(19) **Europäisches Patentamt / European Patent Office / Office européen des brevets**

(11) **EP 4 672 517 A1**

(12) **EUROPEAN PATENT APPLICATION**
published in accordance with Art. 153(4) EPC

(43) Date of publication:
**31.12.2025 Bulletin 2026/01**

(21) Application number: **24760346.7**

(22) Date of filing: **20.02.2024**

(51) International Patent Classification (IPC):
**H01S 5/02253** (2021.01) **H01S 5/40** (2006.01)

(52) Cooperative Patent Classification (CPC):
**H01S 5/02253; H01S 5/40**

(86) International application number:
**PCT/JP2024/005963**

(87) International publication number:
**WO 2024/177048 (29.08.2024 Gazette 2024/35)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **20.02.2023 JP 2023024579**

(71) Applicant: **Nuvoton Technology Corporation Japan**
**Nagaokakyo City, Kyoto 617-8520 (JP)**

(72) Inventors:
• **YAMANAKA, Kazuhiko**
**Nagaokakyo City, Kyoto 6178520 (JP)**
• **ASAKA, Hiroshi**
**Nagaokakyo City, Kyoto 6178520 (JP)**

(74) Representative: **Appelt, Christian W.**
**Boehmert & Boehmert**
**Anwaltspartnerschaft mbB**
**Pettenkoferstrasse 22**
**80336 München (DE)**

(54) **LIGHT SOURCE MODULE**

(57) A light source module (10) includes: a plurality of optical units (1 to 6), wherein each of the plurality of optical units (1 to 6) includes: a semiconductor laser element (200) that emits laser light; a fast axis cylindrical lens (FACL) (110); a first fast axis adjustment lens (first lens) (120); and a slow axis collimator lens (SACL) (170), and α satisfies Formula 1:

$$\alpha = F2/F1 \ (\text{Formula 1}),$$

β satisfies Formula 2: β = d/F2 (Formula 2), and when F2 > 0, α and β satisfy Formula 3, Formula 4, Formula 5, and Formula 6:

$$\alpha > 1 \ (\text{Formula 3}),$$

$\alpha\beta > 1$ (Formula 4),

$$\beta < (1/\alpha) + (1/3) \ (\text{Formula 5}),$$

$$\beta < 1 \ (\text{Formula 6}),$$

where F1 denotes an effective focal length of the FACL (110), F2 denotes an effective focal length of the first lens (120), and d denotes a distance between a principal point of the FACL (110) and a principal point of the first lens (120).

FIG. 2

## Description

[Technical Field]

The present disclosure relates to a light source module.

[Background Art]

Patent Literature (PTL) 1 discloses a semiconductor laser device (light source module) that includes: a semiconductor laser element; a fast axis collimator lens that collimates, in a fast axis direction, laser light emitted from the semiconductor laser element; and a joining material for fixing a position of the fast axis collimator lens.

[Citation List]

[Patent Literature]

[PTL 1] Japanese Unexamined Patent Application Publication No. 2014-170888

[Summary of Invention]

[Technical Problem]

A fast axis collimator lens having a short focal length may be used in the light source module disclosed in PTL 1. In this light source module, the laser light emitted from the semiconductor laser element is spatially combined in the fast axis direction; thus, the fast axis collimator lens is fixed in the vicinity of a light-emitting part of the semiconductor laser element.
However, since, in the fixing of the position of the fast axis collimator lens during manufacturing, the focal length of the fast axis collimator lens is short, the position of the fast axis collimator lens may be displaced, on the order of $\mu$m or the order of sub-$\mu$m, from the optimal position in the optical system of the light source module. The position of the fast axis collimator lens being displaced from the optimal position means that the optical axis in the fast axis direction of the laser light is displaced from the optimal position. When the optical axis is displaced from the optimal position, in the light source module disclosed in PTL 1, problems such as lower coupling efficiency between the target, e.g., an optical fiber, and the laser light occur.
In view of the above, an object of the present disclosure is to provide a light source module that has high coupling efficiency.

[Solution to Problem]

In order to achieve the object, a light source module according to one aspect of the present disclosure includes: a platform including a plurality of stages in a shape of a staircase; and a plurality of optical units each disposed on a different one of the plurality of stages, wherein each of the plurality of optical units includes: a semiconductor laser element that emits laser light; a fast axis cylindrical lens that is a lens on which the laser light emitted from the semiconductor laser element is incident, and that focuses the laser light in a fast axis direction of the laser light; a first fast axis adjustment lens that is a lens on which the laser light that exits from the fast axis cylindrical lens is incident, and that adjusts an optical axis of the laser light in the fast axis direction; and a slow axis collimator lens that is a lens on which the laser light that exits from the first fast axis adjustment lens is incident, and that collimates the laser light in a slow axis direction of the laser light, and $a$ satisfies Formula 1:

$$a = F2/F1 \ \text{(Formula 1)},$$

$\beta$ satisfies Formula 2: $\beta = d/F2$ (Formula 2), when F2 > 0, $a$ and $\beta$ satisfy Formula 3, Formula 4, Formula 5, and Formula 6:

$$a > 1 \ \text{(Formula 3)},$$

$$a\beta > 1 \ \text{(Formula 4)},$$

$\beta < (1/a) + (1/3)$ (Formula 5),

$$\beta < 1 \text{ (Formula 6)},$$

and when F2 < 0, a and β satisfy Formula 7, Formula 8, Formula 9, and Formula 10: a < -1 (Formula 7),

$$\alpha\beta < 1 \text{ (Formula 8)},$$

$$\beta > (1/\alpha) - (1/3) \text{ (Formula 9)},$$

$$\beta > -1 \text{ (Formula 10)},$$

where F1 denotes an effective focal length of the fast axis cylindrical lens, F2 denotes an effective focal length of the first fast axis adjustment lens, and d denotes a distance between a principal point of the fast axis cylindrical lens and a principal point of the first fast axis adjustment lens.

[Advantageous Effects of Invention]

The present disclosure makes it possible to realize a light source module that has high coupling efficiency.

[Brief Description of Drawings]

[FIG. 1]

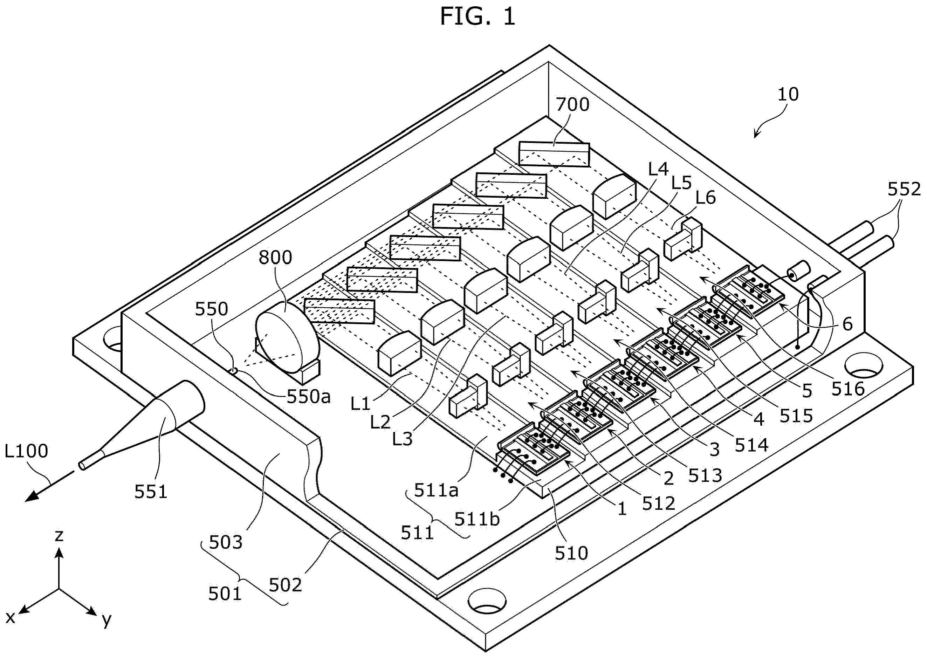

FIG. 1 is a perspective view illustrating the overall configuration of a light source module according to Embodiment 1.
[FIG. 2]

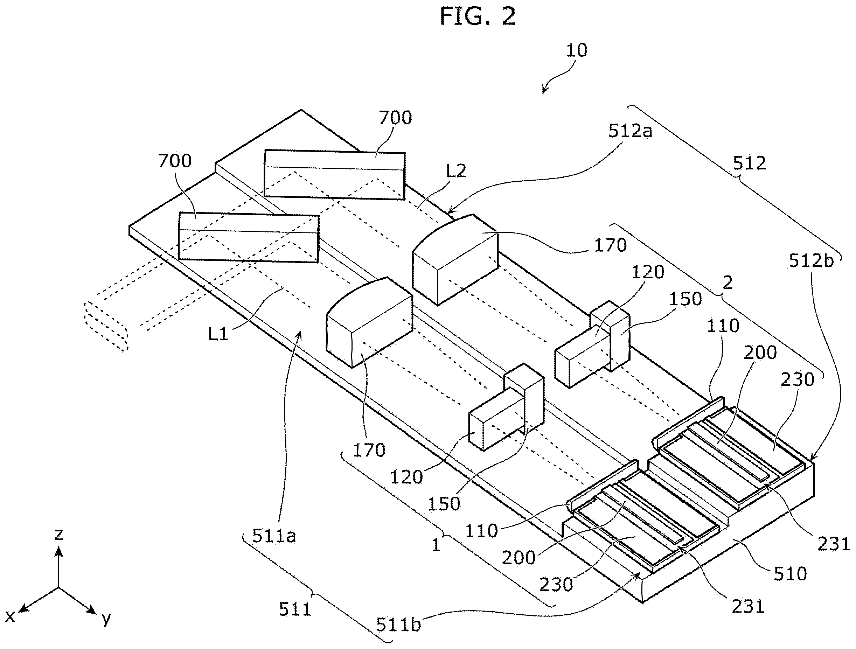

FIG. 2 is a perspective view illustrating the configuration of optical units according to Embodiment 1.
[FIG. 3]

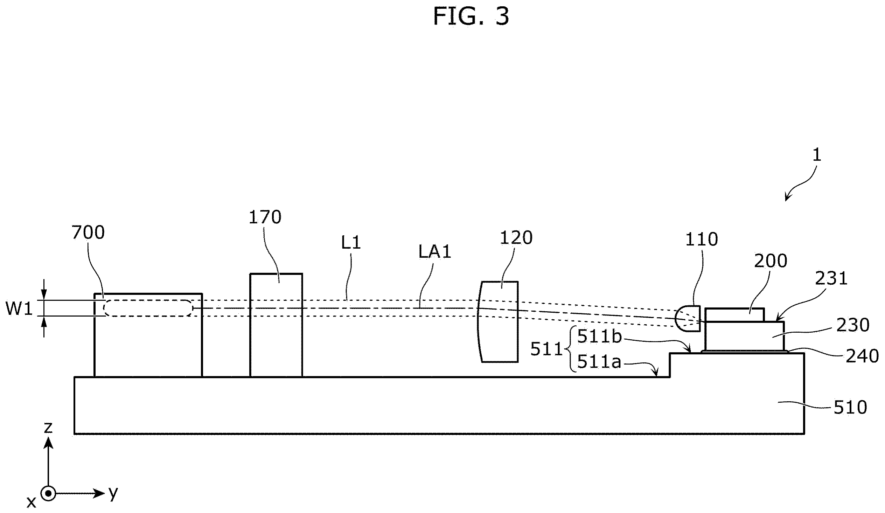

FIG. 3 is a side view illustrating the configuration of an optical unit according to Embodiment 1.
[FIG. 4A]

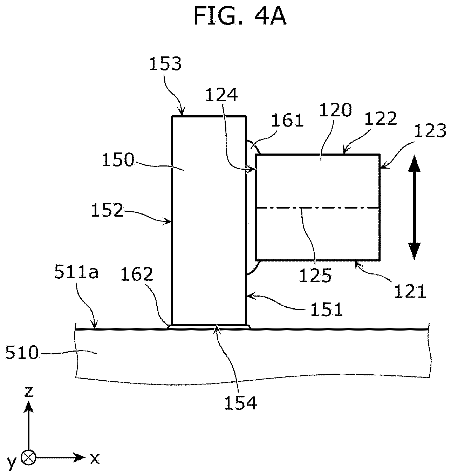

FIG. 4A is a front view illustrating a first lens and a support member according to Embodiment 1.
[FIG. 4B]

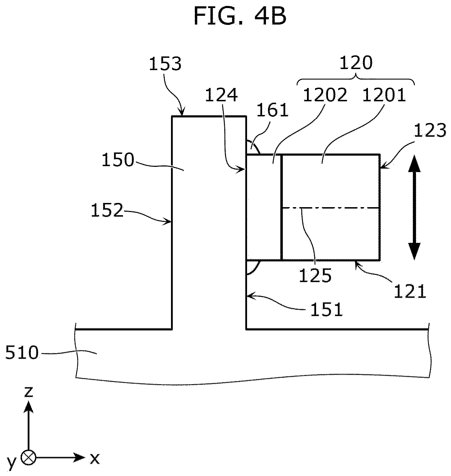

FIG. 4B is a front view illustrating a first lens and a support member according to another example of Embodiment 1.
[FIG. 5]

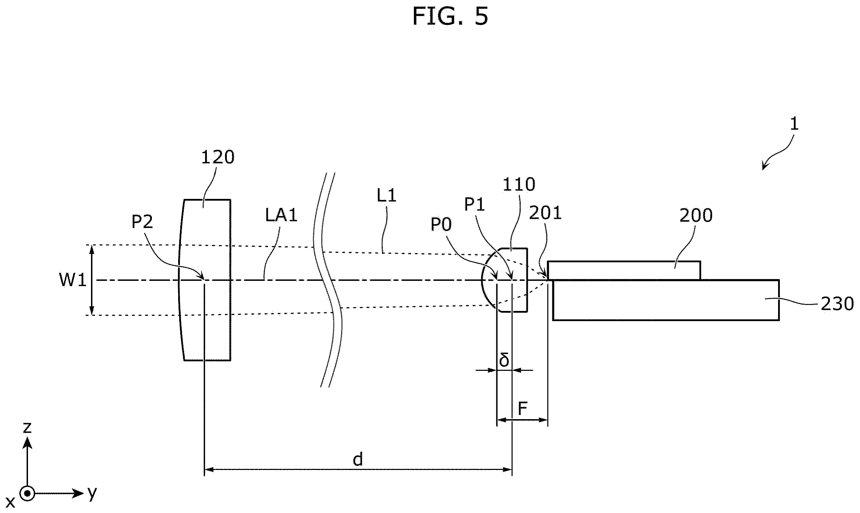

FIG. 5 is a side view of the optical unit according to Embodiment 1.
[FIG. 6A]

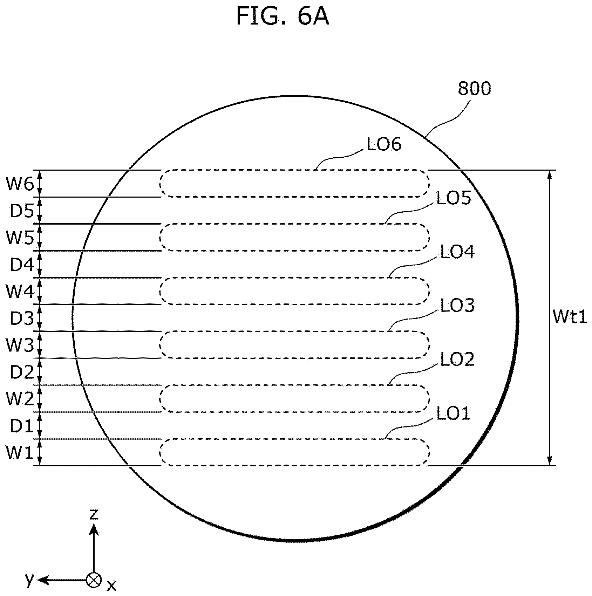

FIG. 6A is a diagram illustrating beam spots of a plurality of laser lights on an incident face of a condenser lens according to Embodiment 1.
[FIG. 6B]

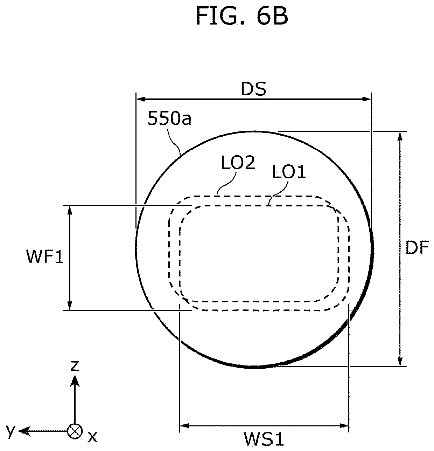

FIG. 6B is a diagram illustrating beam spots of laser lights on the end face of the core of an optical fiber that is a target according to Embodiment 1.
[FIG. 7]

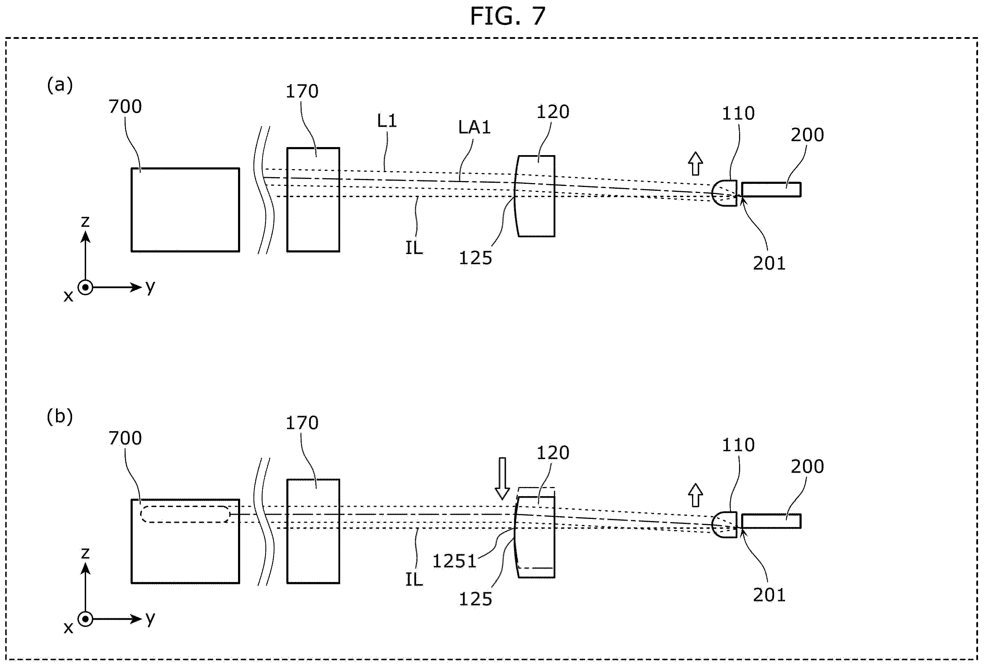

FIG. 7 is a side view of the optical unit that illustrates an example in which the position of the first lens of the optical unit is adjusted in the fast axis direction, in a method for manufacturing the light source module according to Embodiment 1.
[FIG. 8]

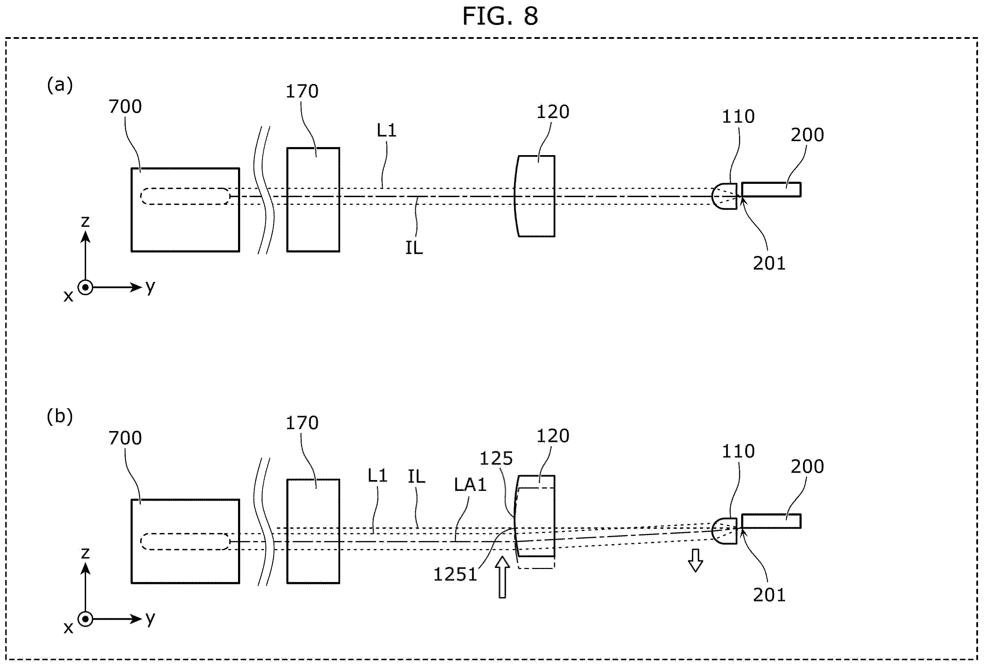

FIG. 8 is a side view of the optical unit that illustrates another example in which the position of the first lens of the optical unit is adjusted in the fast axis direction, in the method for manufacturing the light source module according to Embodiment 1.
[FIG. 9]

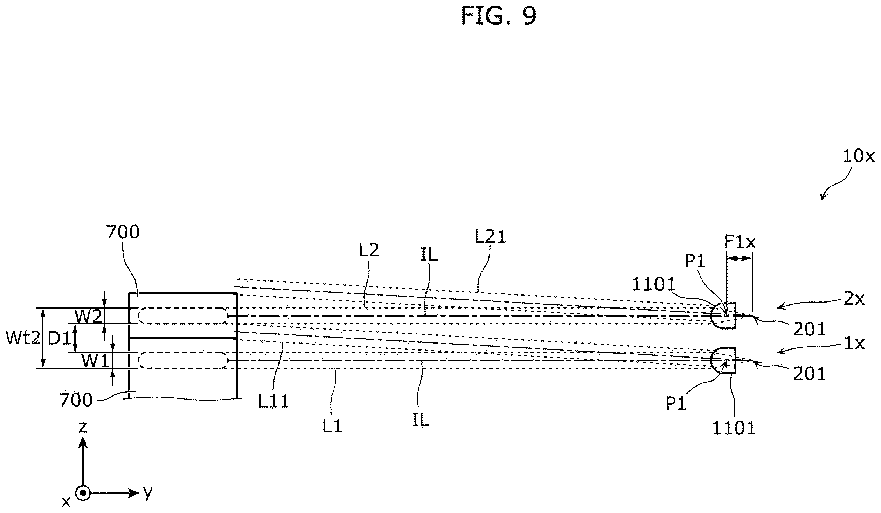

FIG. 9 is a side view illustrating a light source module according to Comparative Example 1.
[FIG. 10]

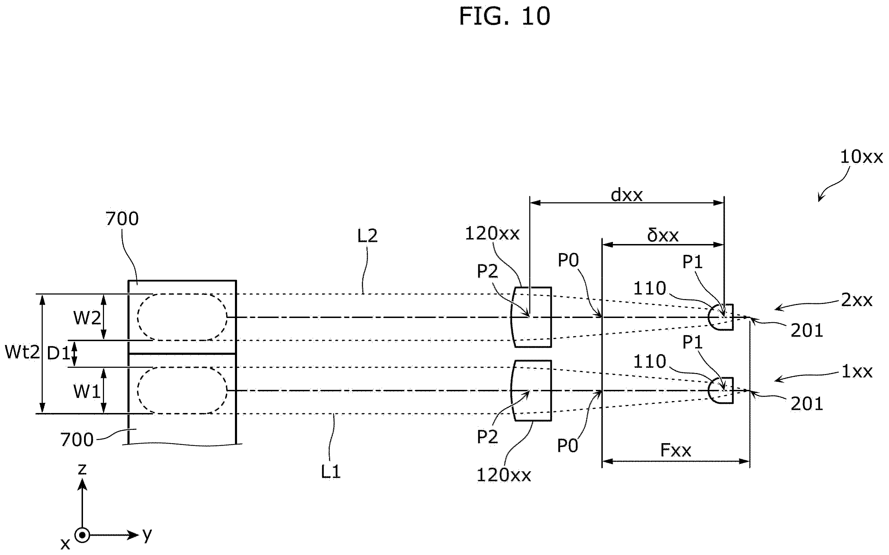

FIG. 10 is a side view illustrating a light source module according to Comparative Example 2.
[FIG. 11]

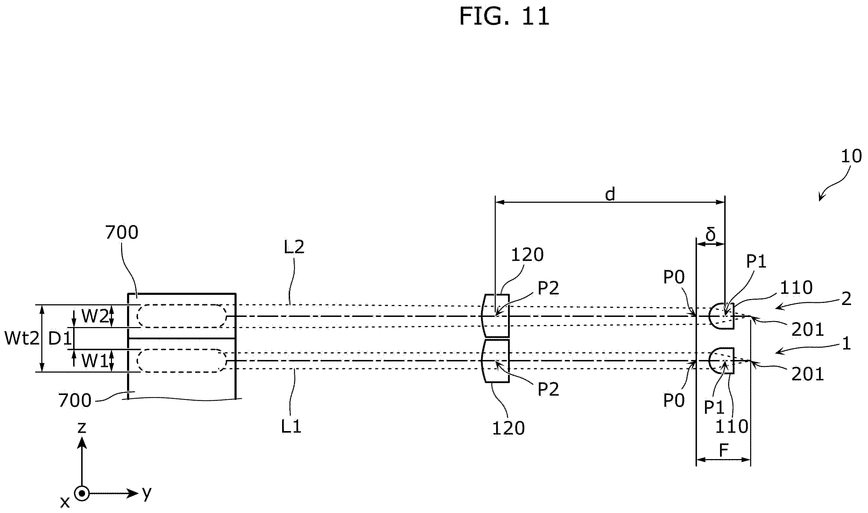

FIG. 11 is a side view illustrating a light source module according to Embodiment 1.
[FIG. 12]

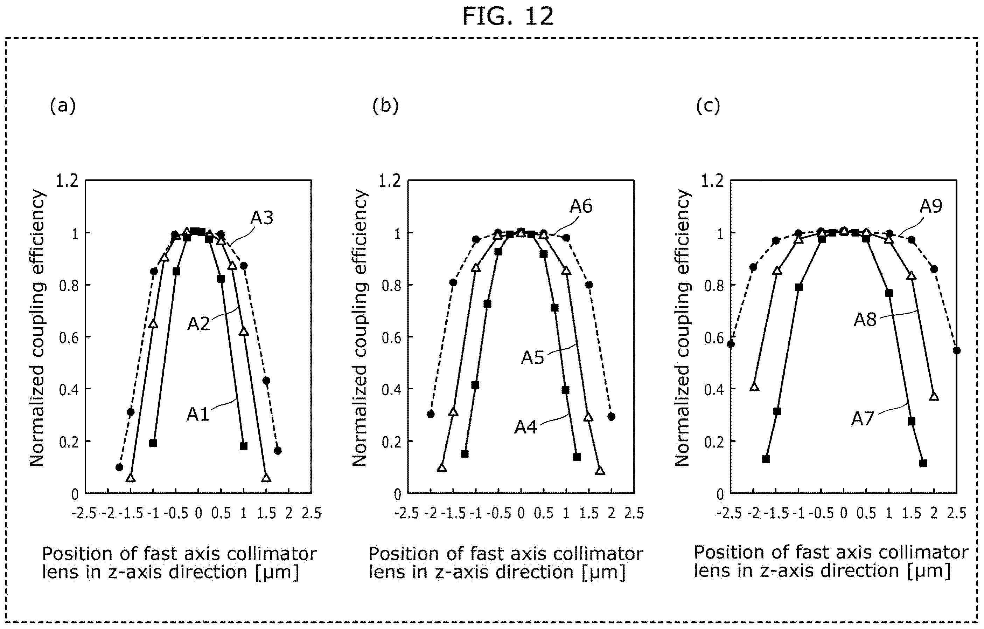

FIG. 12 is a diagram illustrating the result of calculating, for the light source module according to Comparative Example 1, the change in the coupling efficiency under each of a plurality of optical system conditions, by using a simulation.

[FIG. 13]

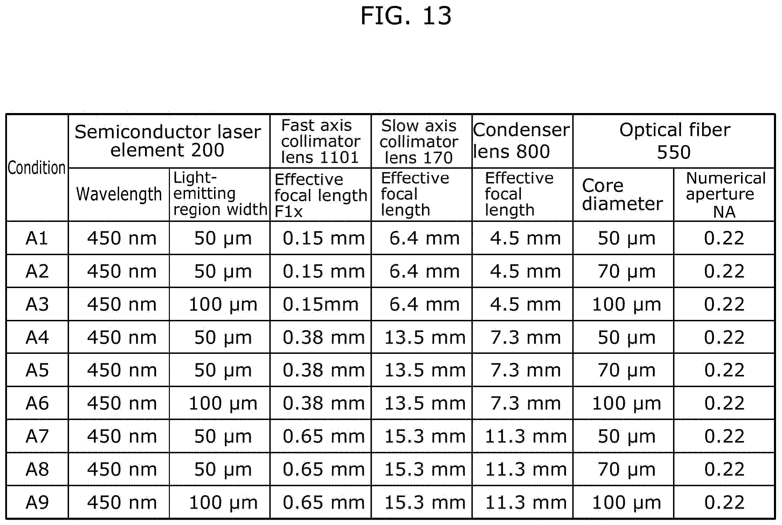

FIG. 13 is a diagram illustrating a table that describes the plurality of optical system conditions illustrated in FIG. 12.

[FIG. 14]

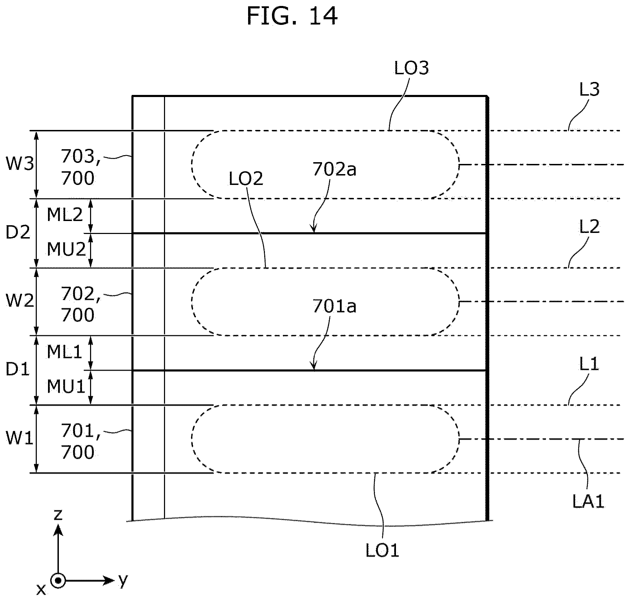

FIG. 14 is a diagram illustrating reflecting mirrors on which the laser lights according to Embodiment 1 are incident.

[FIG. 15]

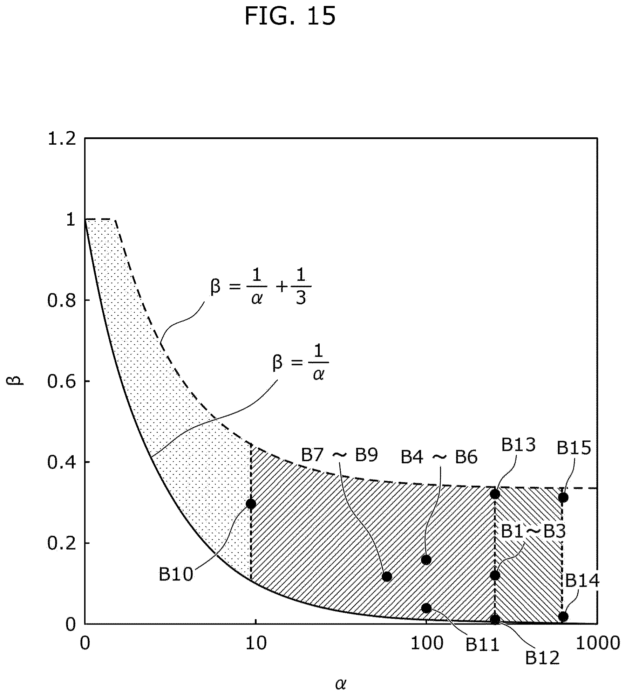

FIG. 15 is a diagram illustrating the ranges of a and β according to Embodiment 1.

[FIG. 16]

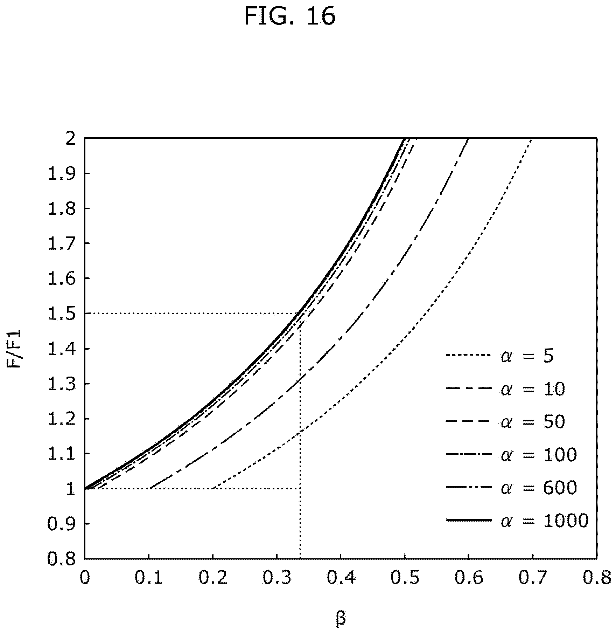

FIG. 16 is a diagram illustrating the relationship between β and F/F1 according to Embodiment 1.

[FIG. 17]

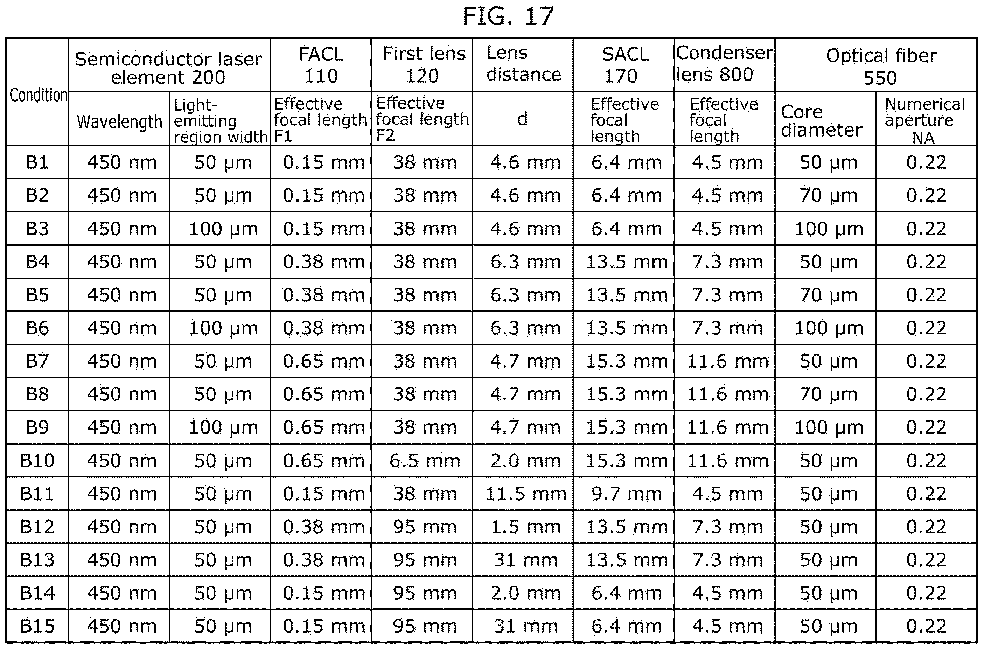

FIG. 17 is a diagram illustrating a table that describes a plurality of optical system conditions for calculating changes in the coupling efficiency in the light source module according to Embodiment 1.

[FIG. 18]

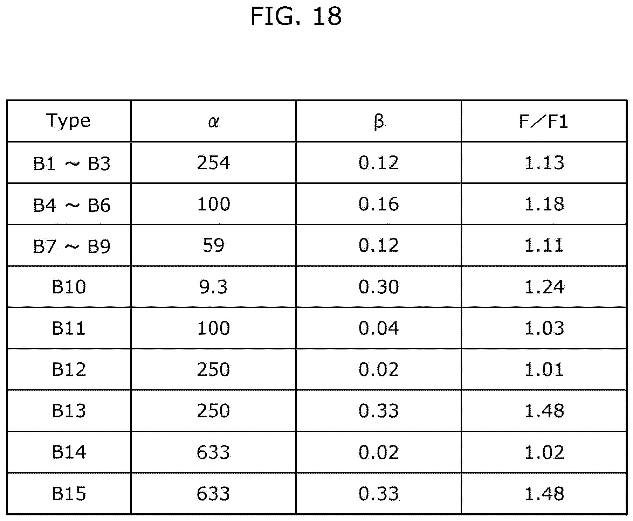

FIG. 18 is a diagram illustrating a table indicating α, β, and F/F1 under the plurality of conditions illustrated in FIG. 17.

[FIG. 19]

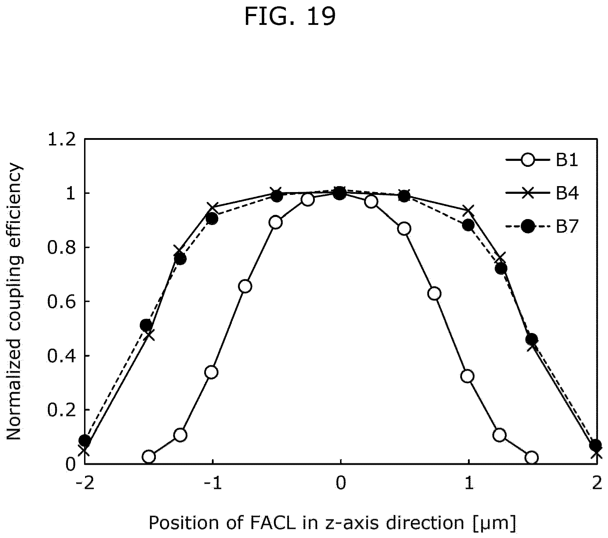

FIG. 19 is a diagram illustrating the results of calculating the coupling efficiency under some of the conditions of the plurality of conditions illustrated in FIG. 17.

[FIG. 20]

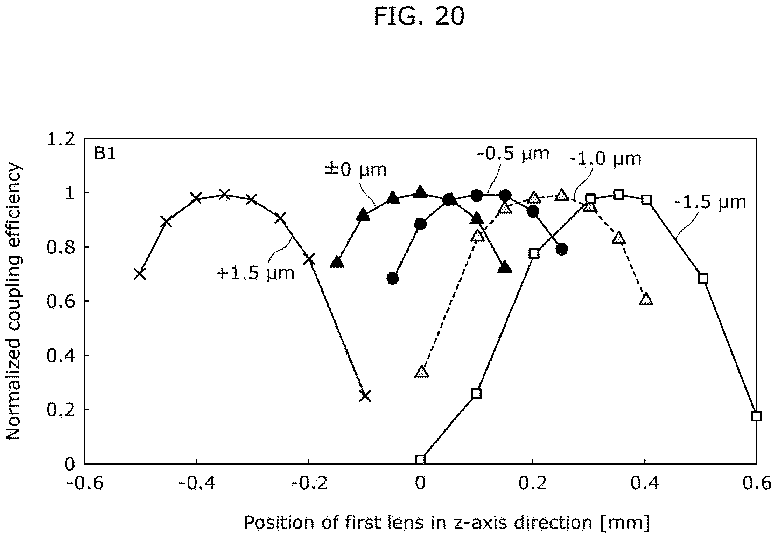

FIG. 20 is a diagram illustrating the results of calculating the coupling efficiency under some of the conditions of the plurality of conditions illustrated in FIG. 17.

[FIG. 21]

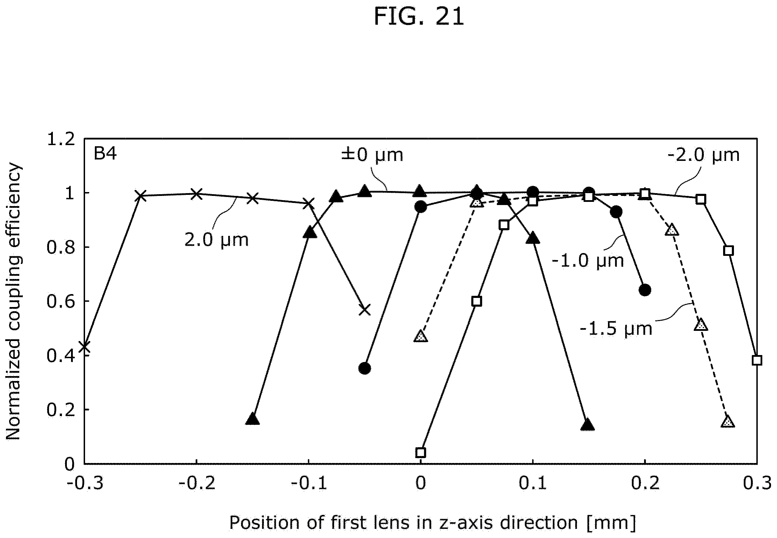

FIG. 21 is a diagram illustrating the results of calculating the coupling efficiency under some of the conditions of the plurality of conditions illustrated in FIG. 17.

[FIG. 22]

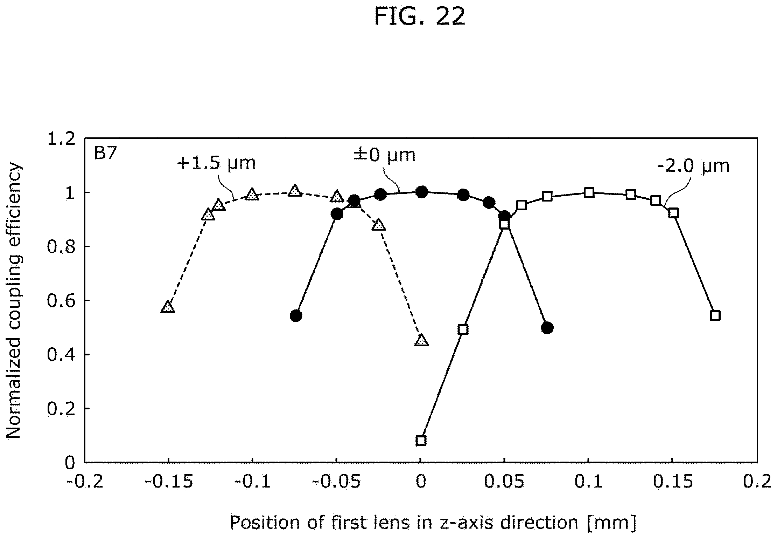

FIG. 22 is a diagram illustrating the results of calculating the coupling efficiency under some of the conditions of the plurality of conditions illustrated in FIG. 17.

[FIG. 23A]

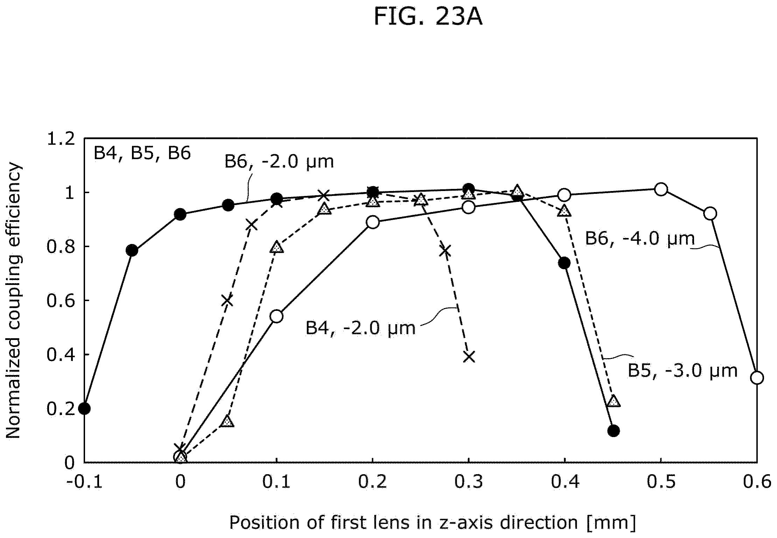

FIG. 23A is a diagram illustrating the results of calculating the coupling efficiency under some of the conditions of the plurality of conditions illustrated in FIG. 17.

[FIG. 23B]

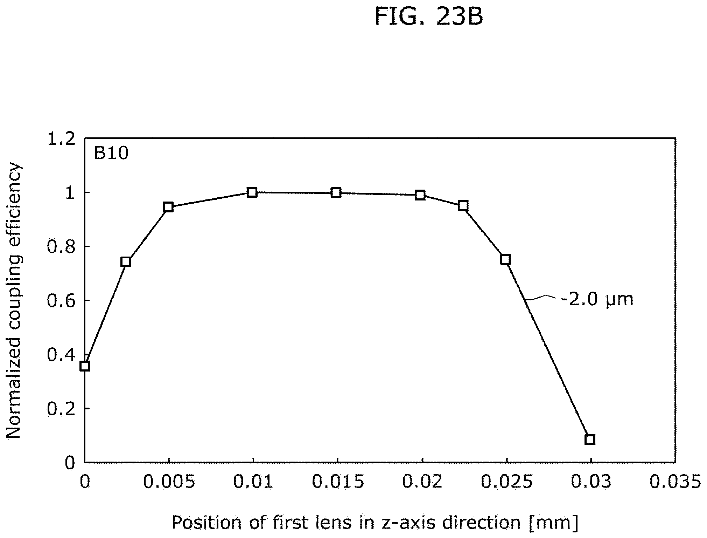

FIG. 23B is a diagram illustrating the results of calculating the coupling efficiency under some of the conditions of the plurality of conditions illustrated in FIG. 17.

[FIG. 23C]

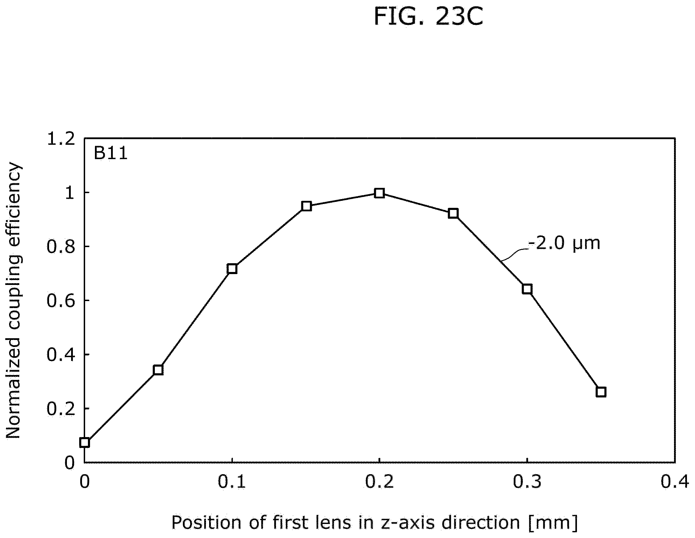

FIG. 23C is a diagram illustrating the results of calculating the coupling efficiency under some of the conditions of the plurality of conditions illustrated in FIG. 17.

[FIG. 23D]

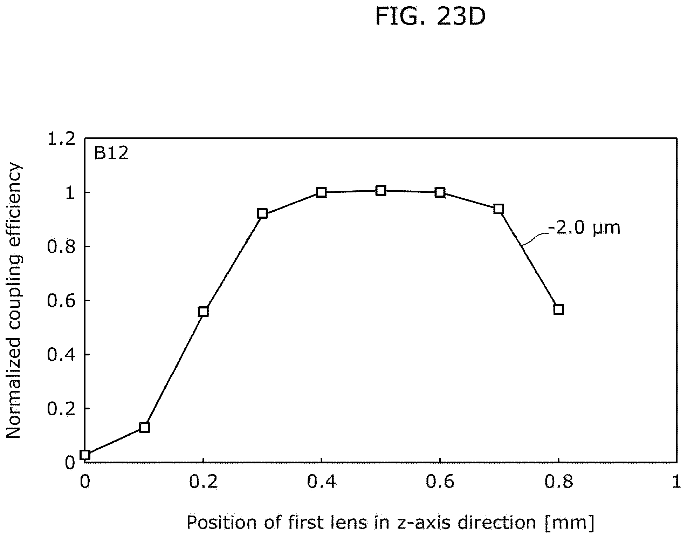

FIG. 23D is a diagram illustrating the results of calculating the coupling efficiency under some of the conditions of the plurality of conditions illustrated in FIG. 17.

[FIG. 23E]

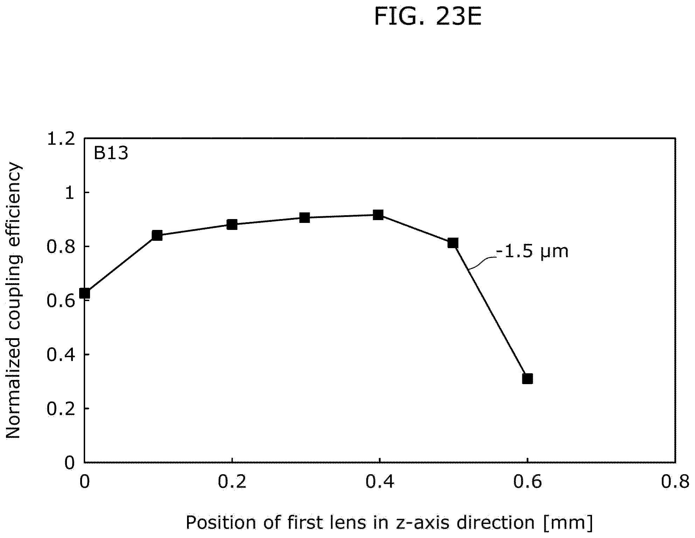

FIG. 23E is a diagram illustrating the results of calculating the coupling efficiency under some of the conditions of the plurality of conditions illustrated in FIG. 17.

[FIG. 23F]

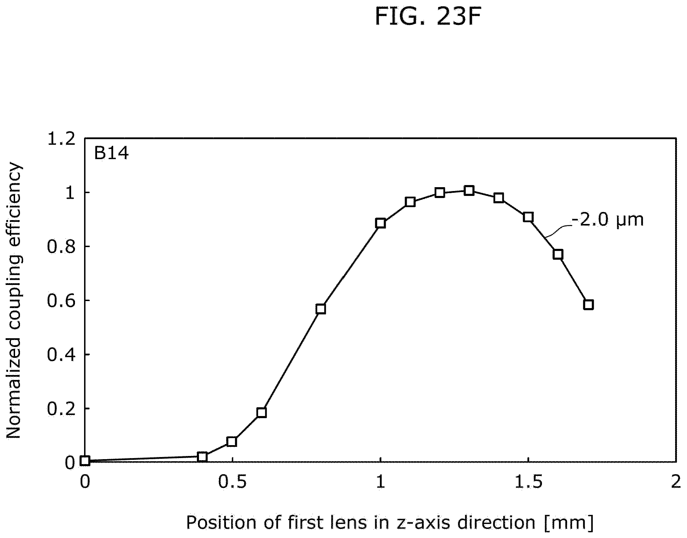

FIG. 23F is a diagram illustrating the results of calculating the coupling efficiency under some of the conditions of the plurality of conditions illustrated in FIG. 17.

[FIG. 23G]

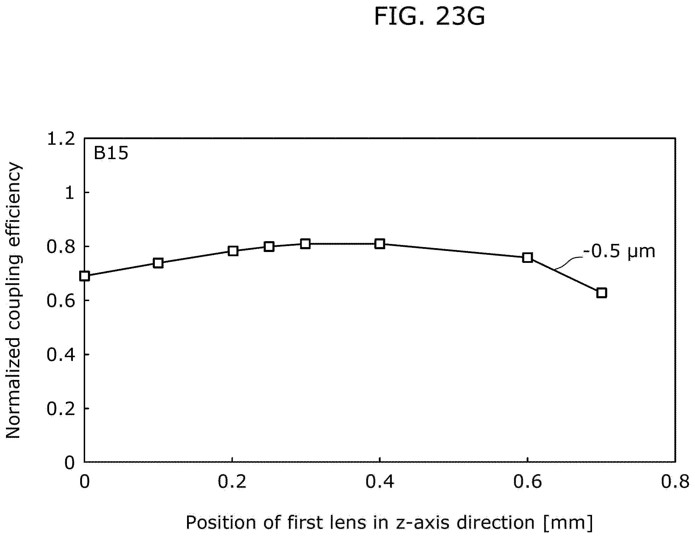

FIG. 23G is a diagram illustrating the results of calculating the coupling efficiency under some of the conditions of the plurality of conditions illustrated in FIG. 17.

[FIG. 24]

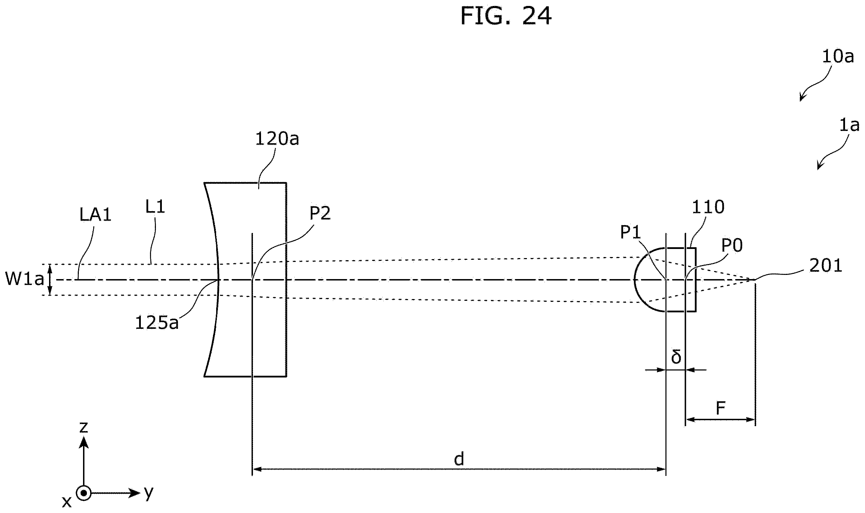

FIG. 24 is a side view illustrating the configuration of an optical unit according to Variation 1 of Embodiment 1.

[FIG. 25]

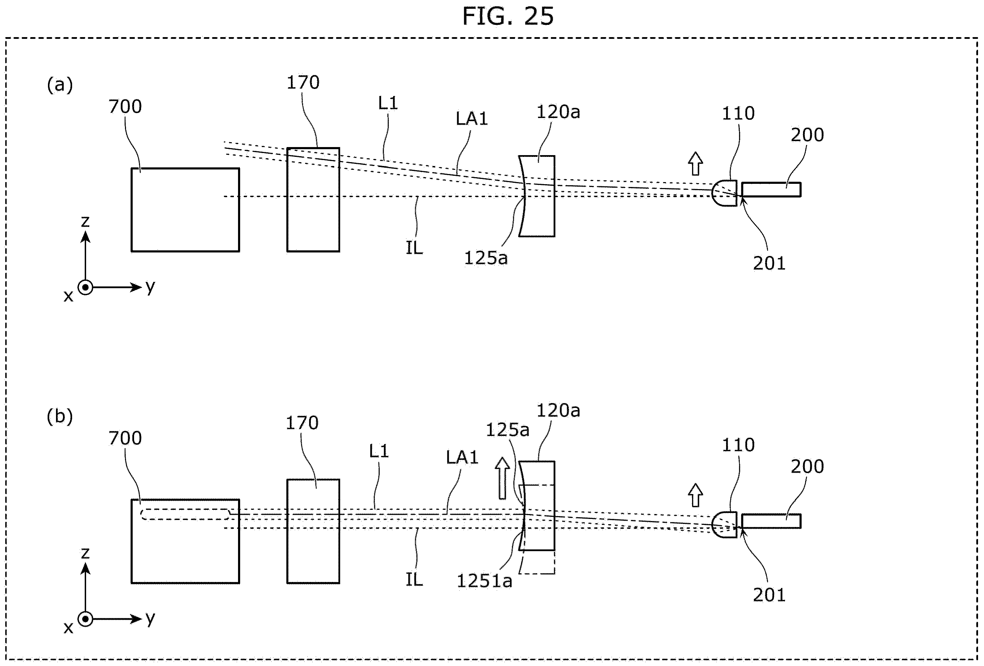

FIG. 25 is a side view illustrating an example in which the position of a first lens according to Variation 1 of Embodiment 1 is adjusted in the fast axis direction.

[FIG. 26]

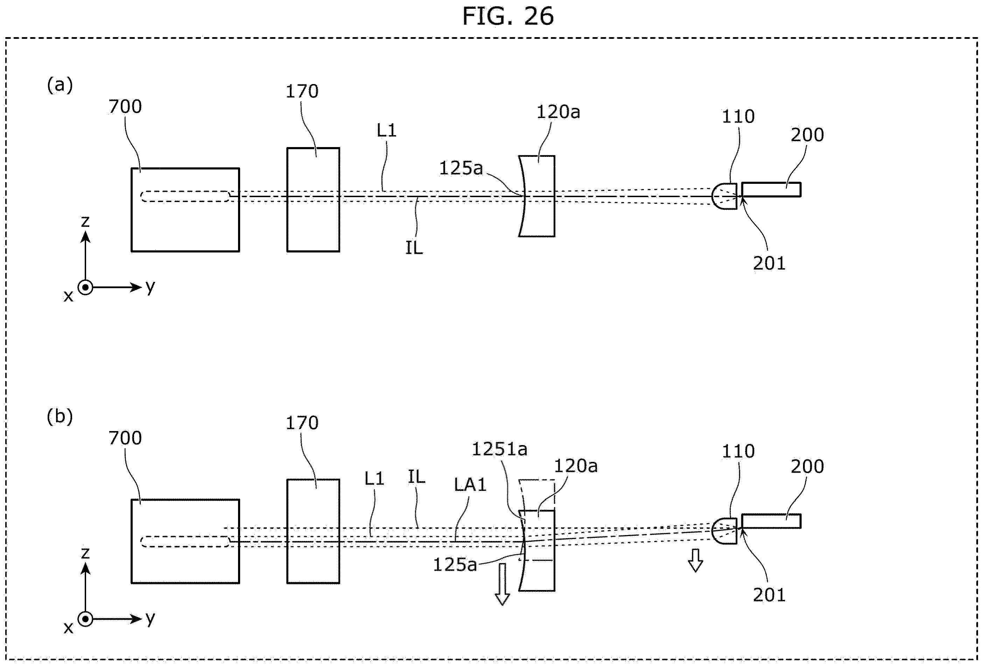

FIG. 26 is a side view illustrating another example in which the position of the first lens according to Variation 1 of Embodiment 1 is adjusted in the fast axis direction.

[FIG. 27]

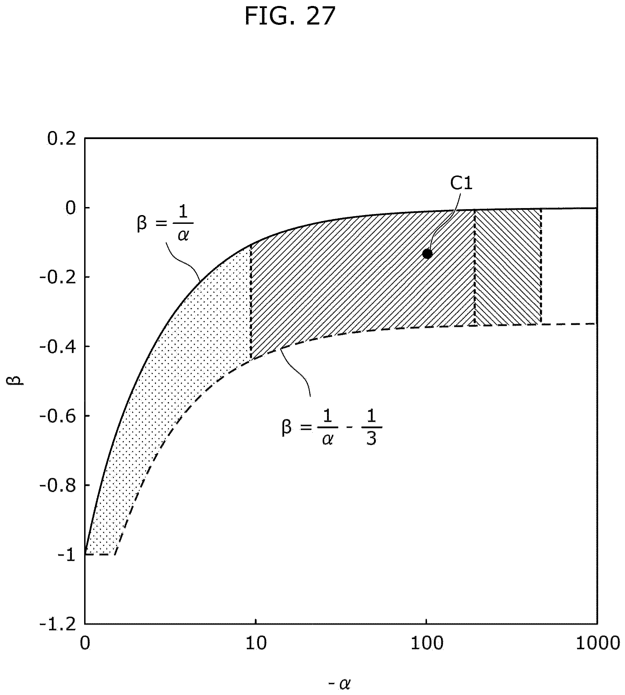

FIG. 27 is a diagram illustrating the ranges of a and β according to Variation 1 of Embodiment 1.

[FIG. 28]

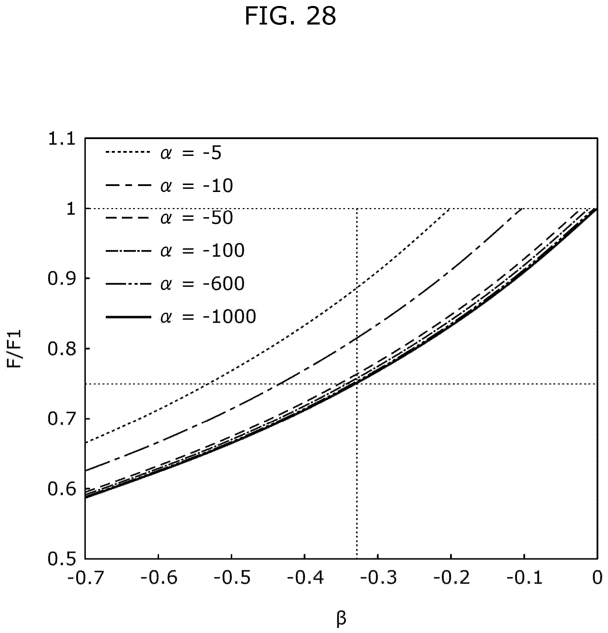

FIG. 28 is a diagram illustrating the relationship between β and F/F1 according to Variation 1 of Embodiment 1.

[FIG. 29]

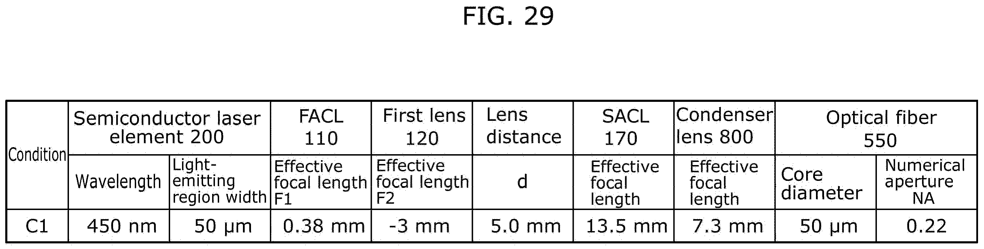

FIG. 29 is a diagram illustrating a table that describes a condition for calculating the coupling efficiency in the light source module according to Variation 1 of Embodiment 1.

[FIG. 30]

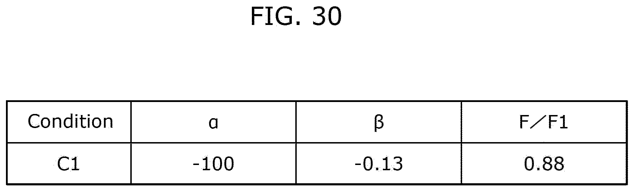

FIG. 30 is a diagram illustrating a table indicating $\alpha$, $\beta$, and F/F1 under the condition indicated in FIG. 29.

[FIG. 31]

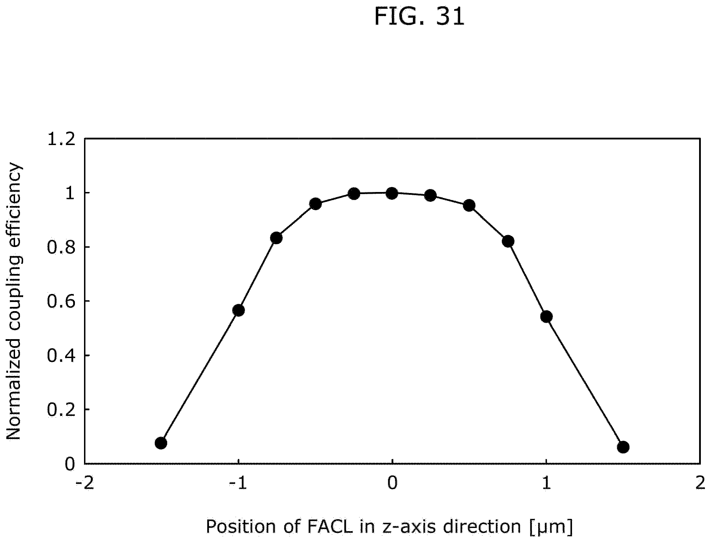

FIG. 31 is a diagram illustrating the results of calculating the change in the coupling efficiency when the positions of the six FACLs have been displaced from the optimal positions under the condition indicated in FIG. 29.

[FIG. 32]

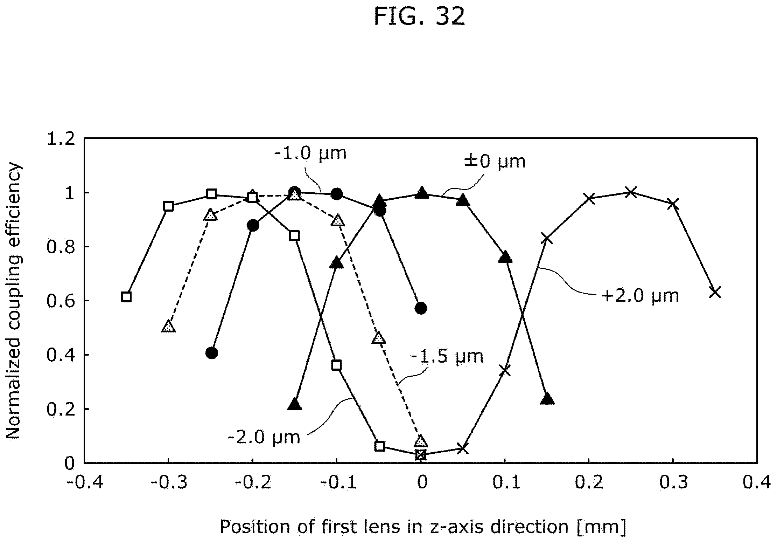

FIG. 32 is a diagram illustrating the results of calculating the change in the coupling efficiency when the positions of the six FACLs have been displaced from the optimal positions under the condition indicated in FIG. 29.

[FIG. 33]

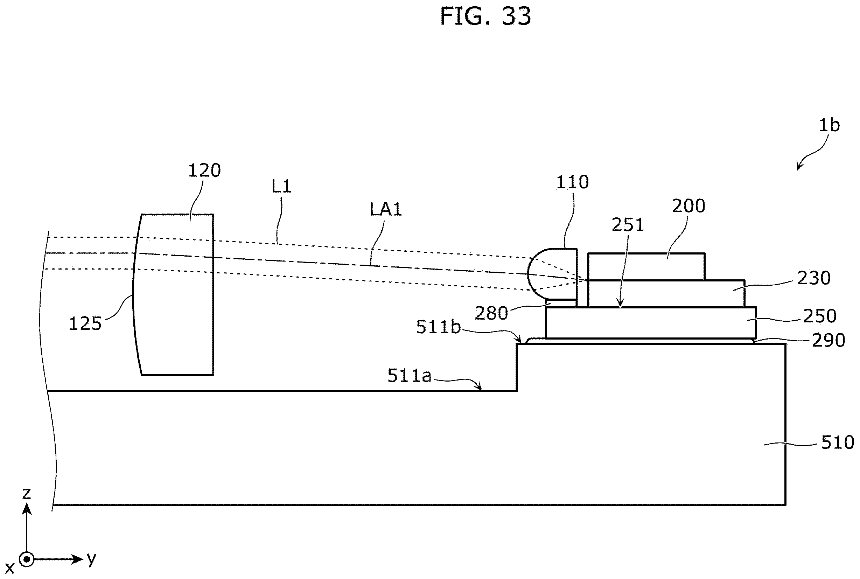

FIG. 33 is a side view illustrating the configuration of an optical unit according to Variation 2 of Embodiment 1.

[FIG. 34]

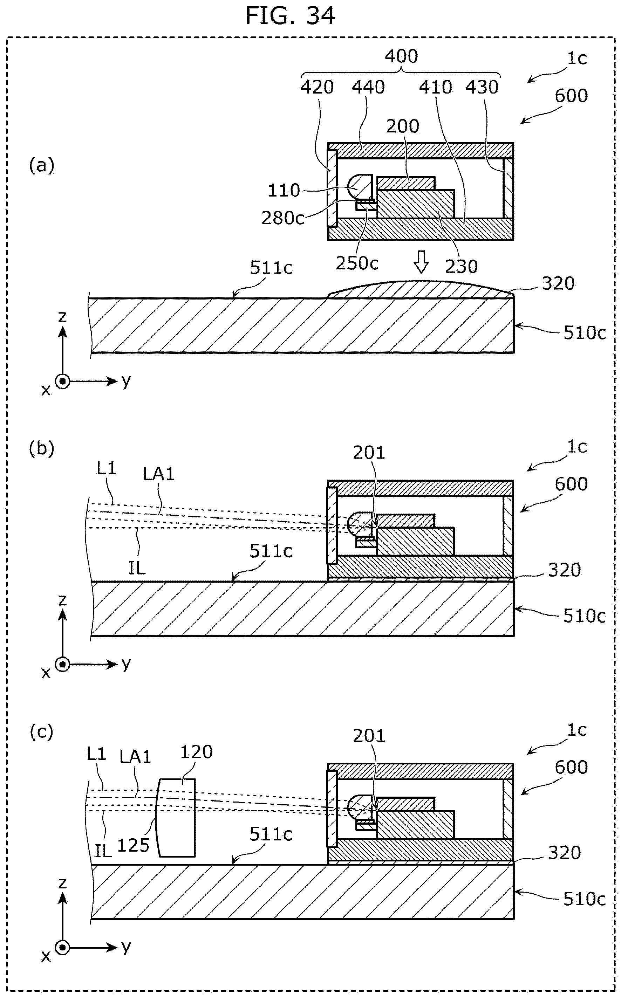

FIG. 34 is a cross-sectional view illustrating a method for manufacturing an optical unit according to Variation 3 of Embodiment 1.

[FIG. 35]

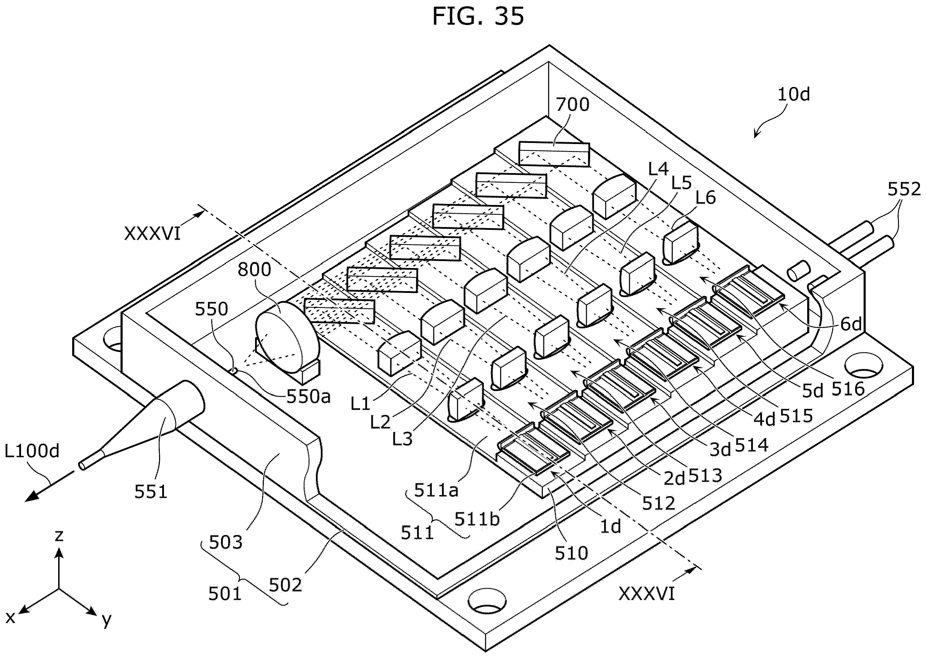

FIG. 35 is a perspective view illustrating the configuration of a light source module according to Embodiment 2.

[FIG. 36]

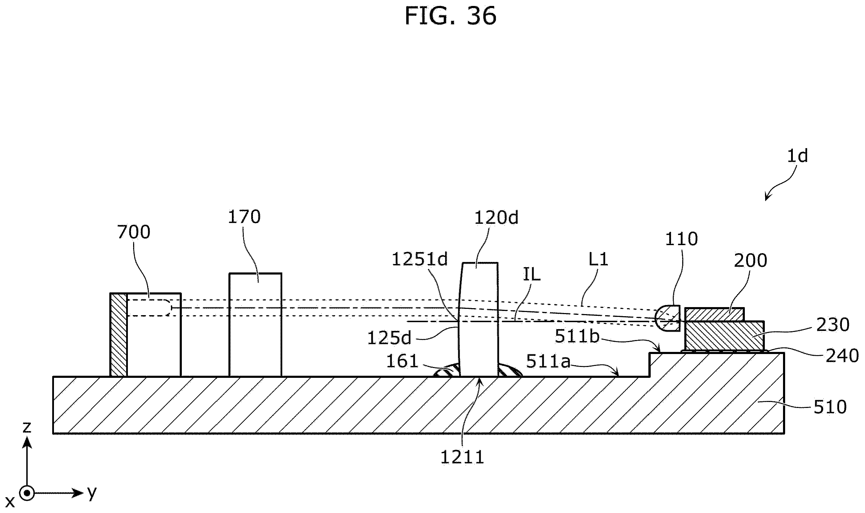

FIG. 36 is a cross-sectional view of an optical unit taken along the XXXVI-XXXVI line in FIG. 35.

[FIG. 37]

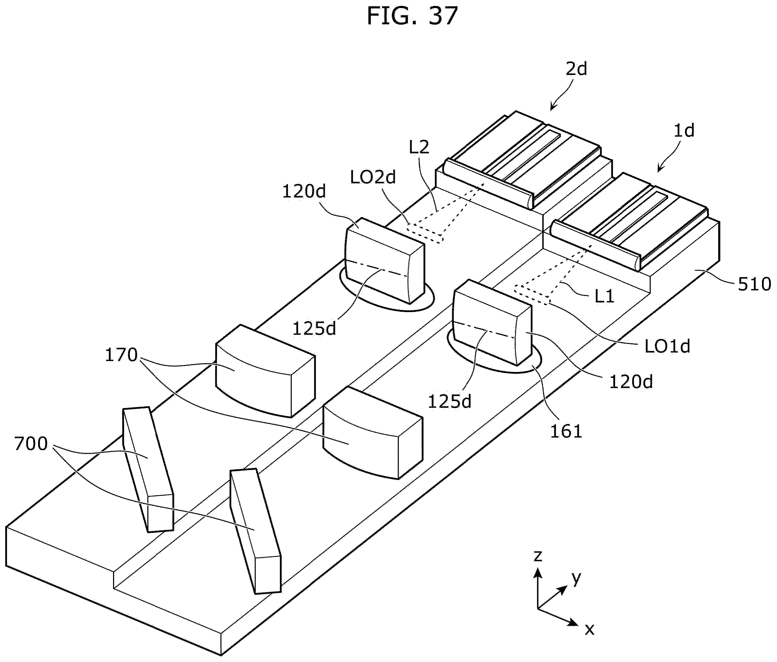

FIG. 37 is a perspective view illustrating the configuration of optical units according to Embodiment 2.

[FIG. 38]

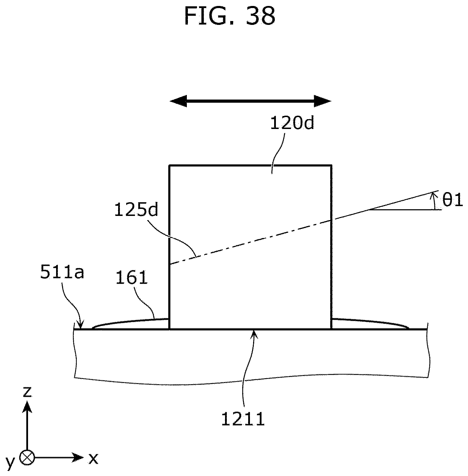

FIG. 38 is a front view for illustrating the tilting of a generatrix according to Embodiment 2.

[FIG. 39A]

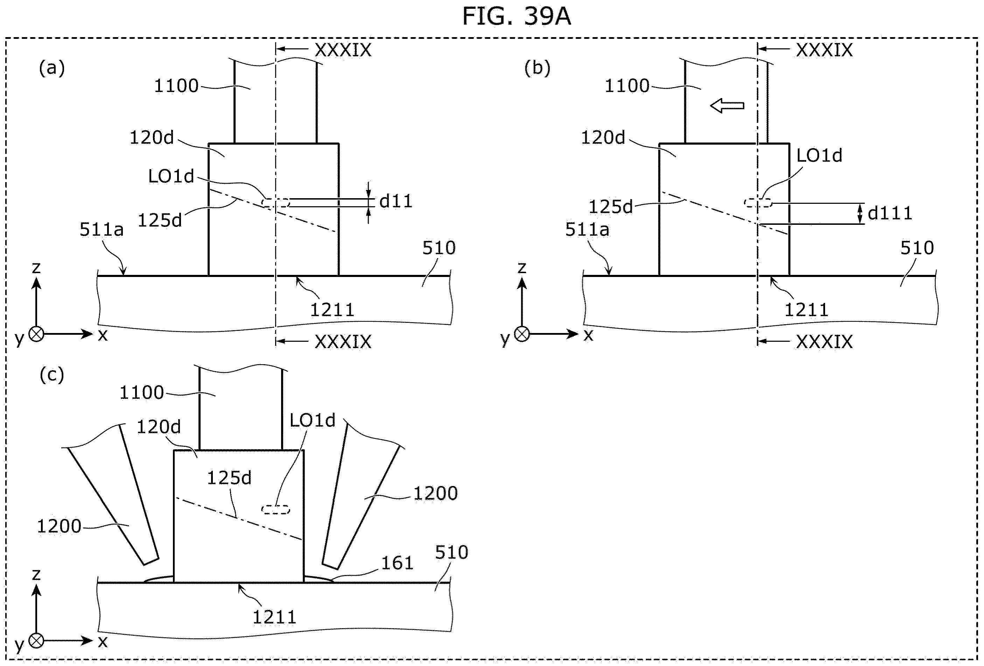

FIG. 39A is a front view illustrating when a first lens according to Embodiment 2 is disposed on a first step.

[FIG. 39B]

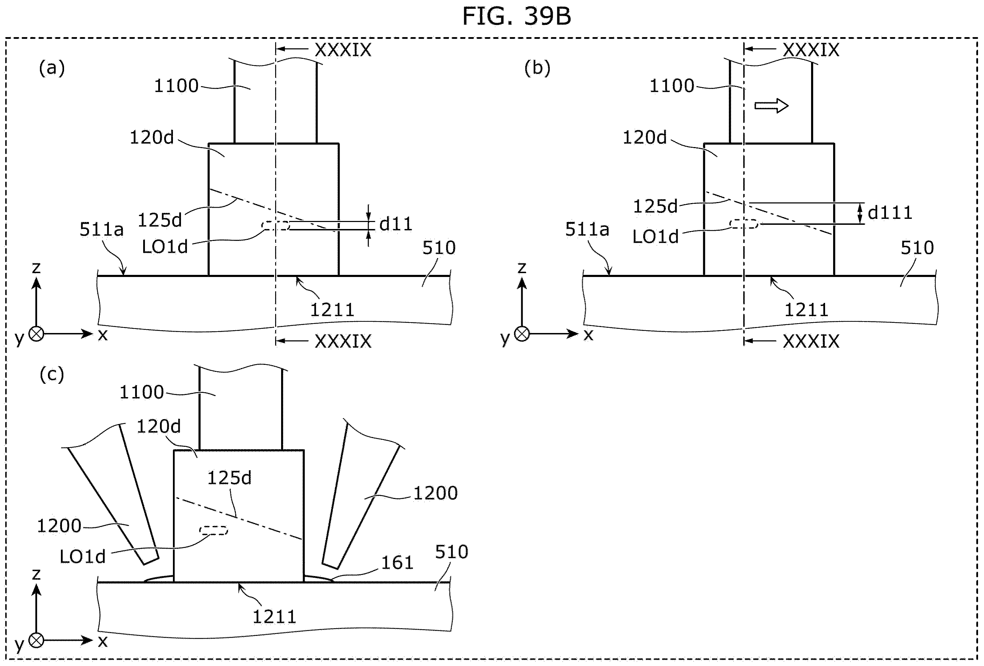

FIG. 39B is another front view illustrating when the first lens according to Embodiment 2 is disposed on the first step.

[FIG. 40]

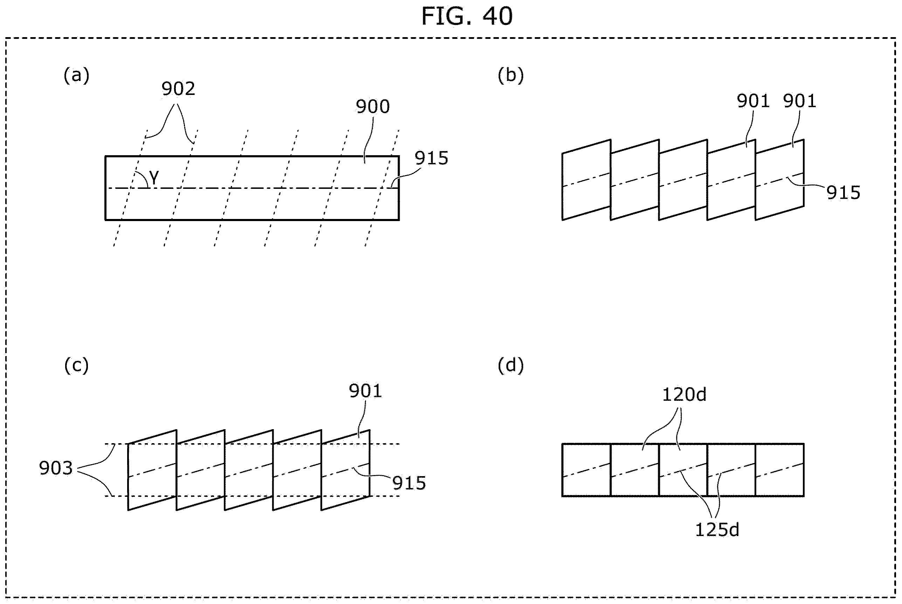

FIG. 40 is a front view illustrating a method for manufacturing the first lens according to Embodiment 2.

[FIG. 41A]

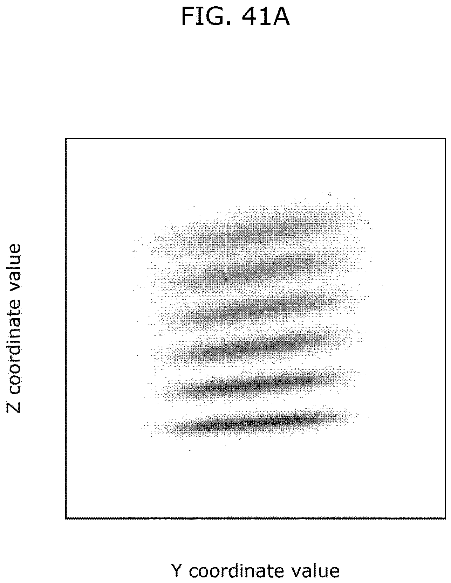

FIG. 41A is a diagram indicating the results of calculating, by simulation, the optical intensity distribution of laser lights at the incident face of a condenser lens when, in addition to a predetermined condition of Embodiment 1, an angle according to Embodiment 2 is -15°.

[FIG. 41B]

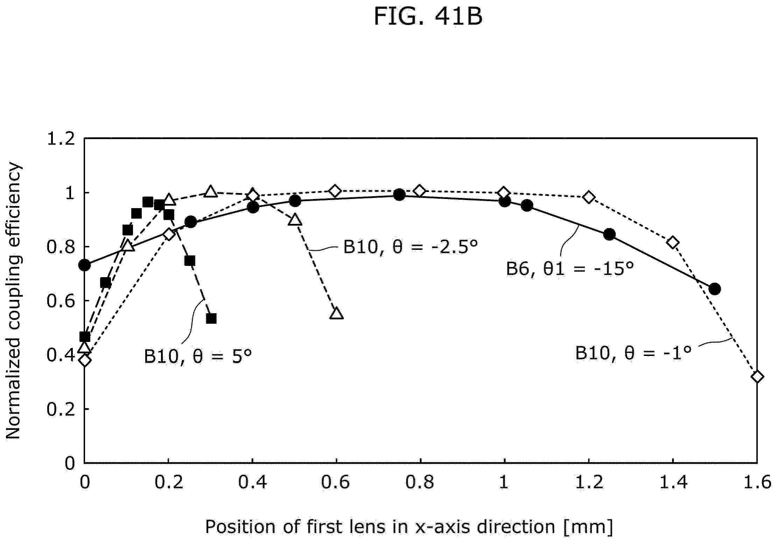

FIG. 41B is a diagram illustrating the results of calculating the coupling efficiency under the predetermined condition of FIG. 41A.

[FIG. 42]

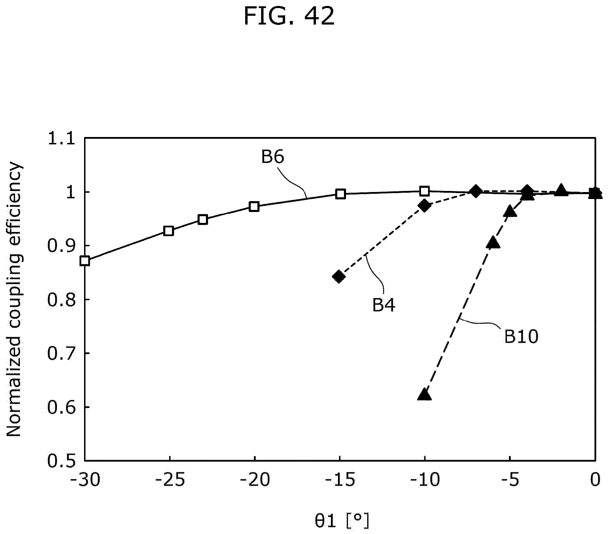

FIG. 42 is a diagram illustrating the results of calculating, by simulation, the maximum value of the coupling efficiency when using the first lens in which the angle according to Embodiment 2 has been changed.

[FIG. 43]

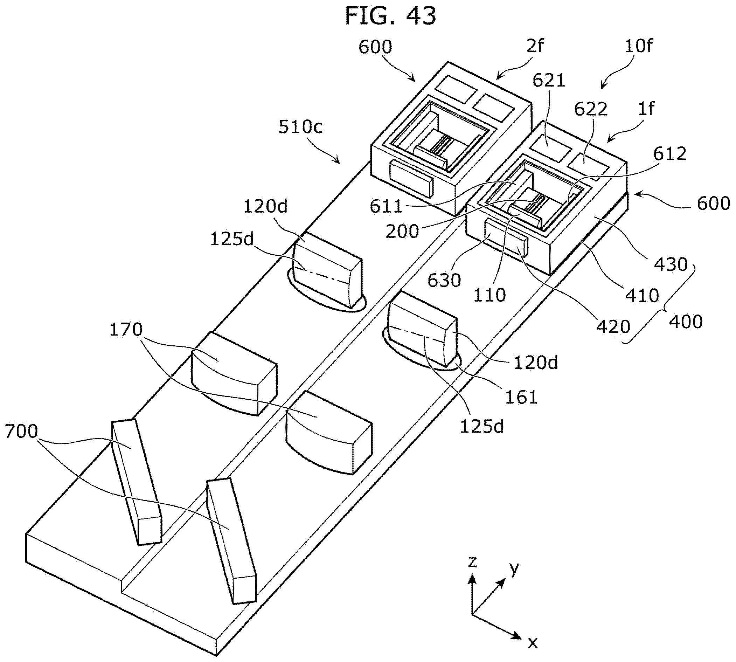

FIG. 43 is a perspective view illustrating a part of a light source module according to Embodiment 3.

[FIG. 44]

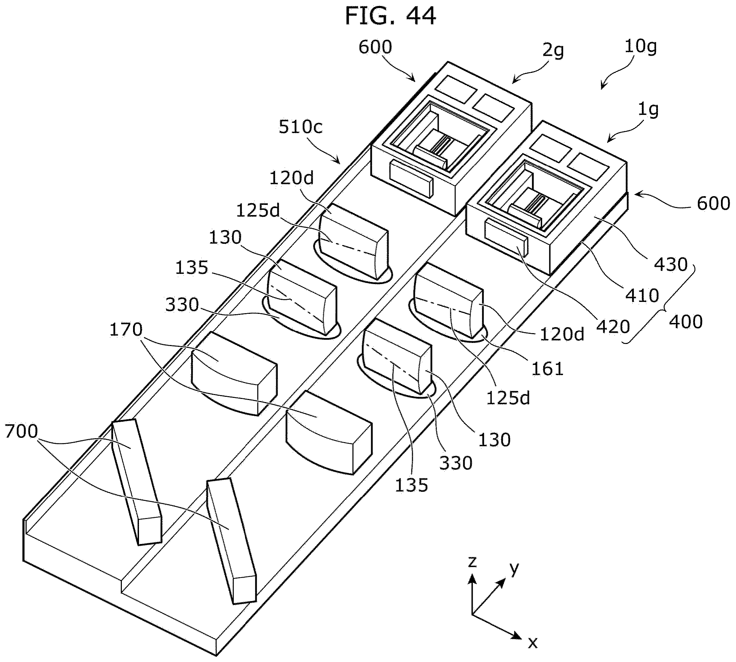

FIG. 44 is a perspective view illustrating a part of a light source module according to Embodiment 4.

[FIG. 45]

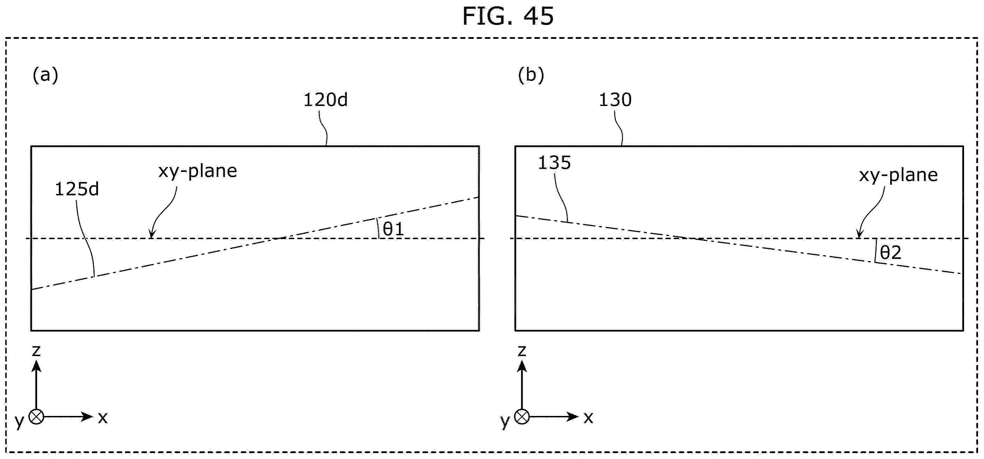

FIG. 45 is a front view for illustrating the tilting of a generatrix according to Embodiment 4.

[FIG. 46]

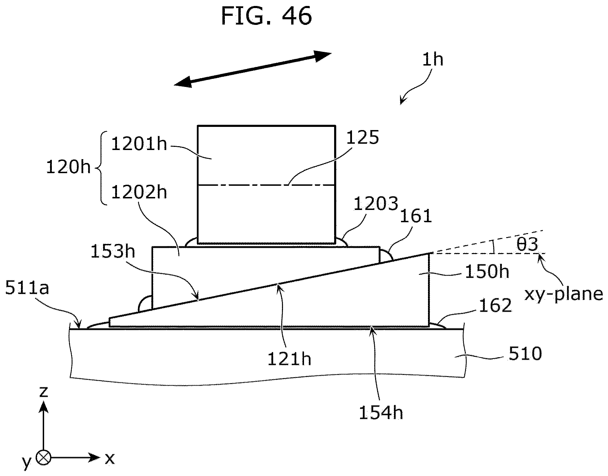

FIG. 46 is a front view illustrating a part of a light source module according to Embodiment 5.

[FIG. 47]

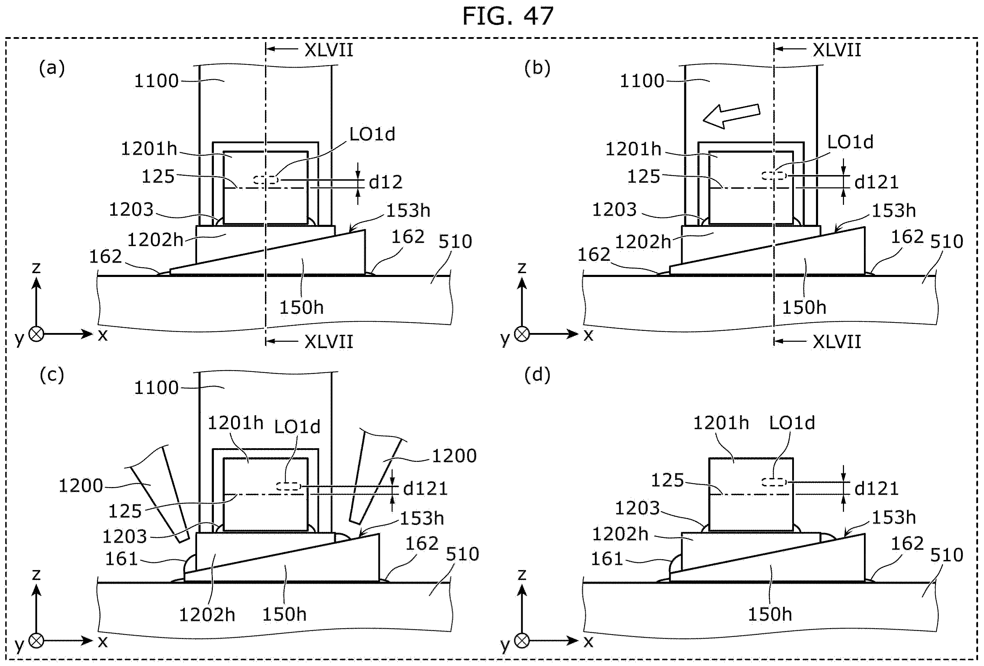

FIG. 47 is a schematic diagram illustrating a step in a method for manufacturing an optical unit.

[FIG. 48]

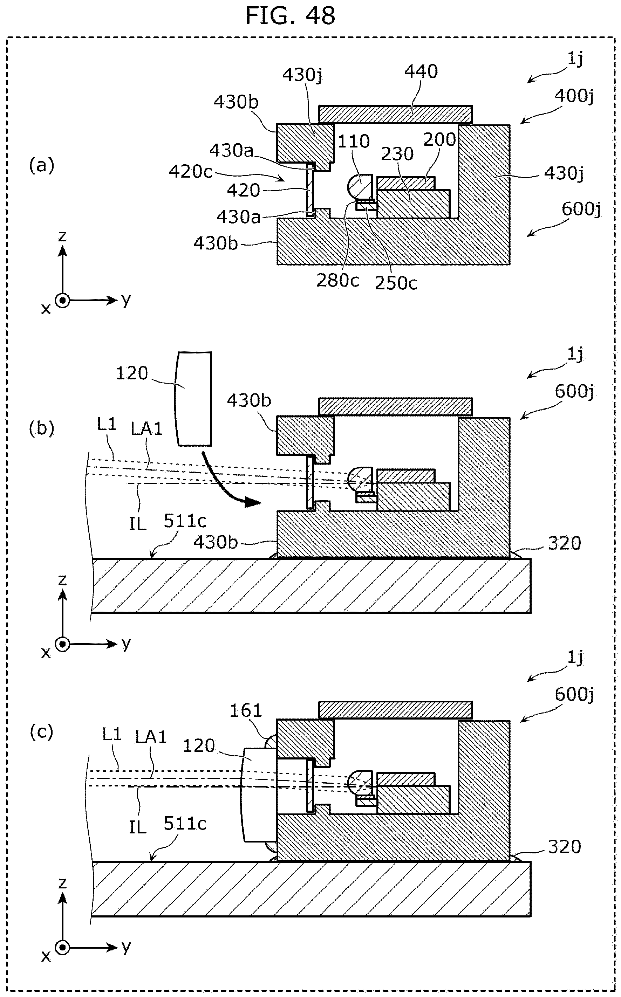

FIG. 48 is a cross-sectional view illustrating a method for manufacturing an optical unit according to Embodiment 6.

[FIG. 49]

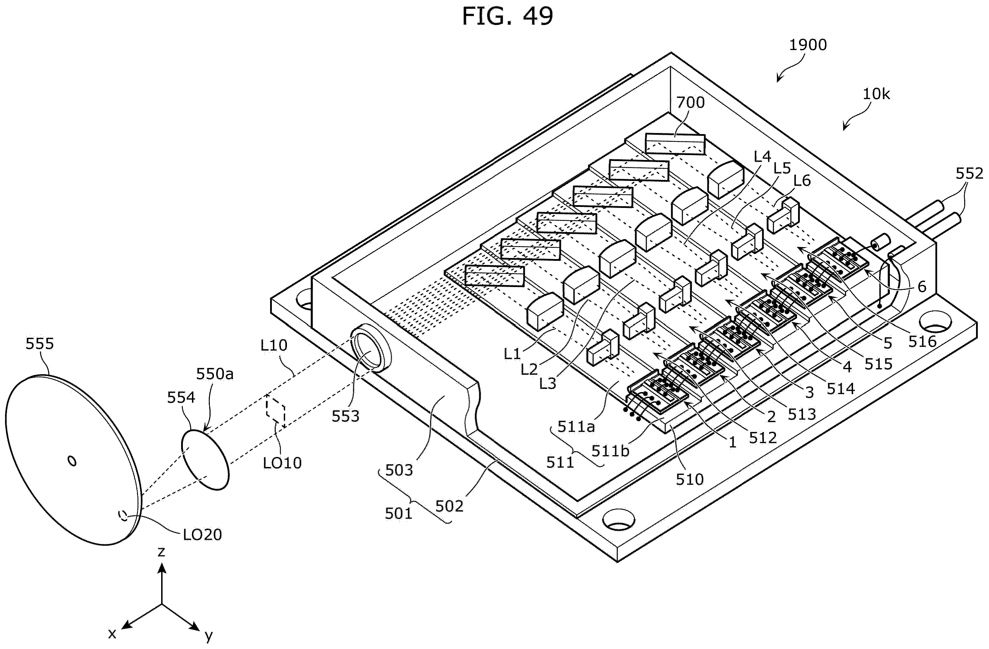

FIG. 49 is a perspective view illustrating the overall configuration of a light source device that includes a light source module, a condenser lens, and a wavelength conversion member according to Embodiment 7.

[FIG. 50]

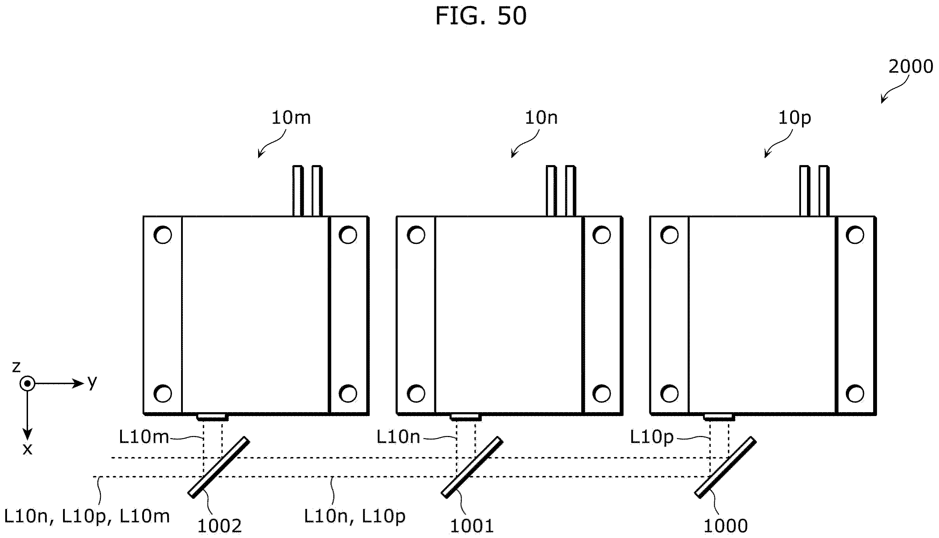

FIG. 50 is a top view illustrating the overall configuration of a light emission device according to Embodiment 8.

[FIG. 51]

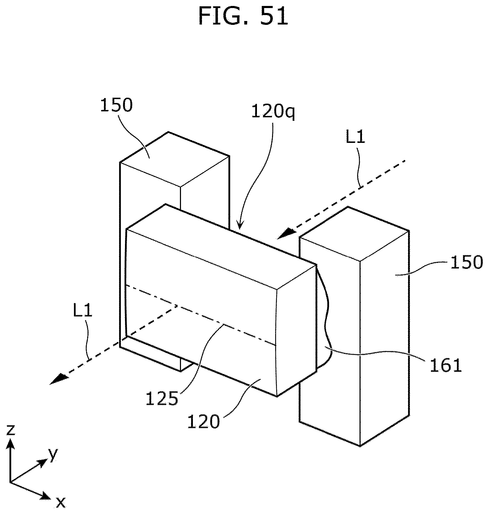

FIG. 51 is a perspective view illustrating another example of bonding the first lens to the support member.

[Description of Embodiments]

Hereinafter, the light source module according to embodiments of the present disclosure is described with reference to the Drawings. Note that each the embodiments described hereinafter illustrates a specific example of the present disclosure. Accordingly, the numerical values, shapes, materials, constituent elements, arrangement and connection of the constituent elements, steps, order of the steps, and other details indicated in the following embodiments are merely examples, and are not intended to limit the present disclosure.

Moreover, the Drawings are schematic illustrations and are not necessarily precise depictions. Thus, for example, the scales and the like in the Drawings do not necessarily match. Furthermore, in the Drawings, elements that are substantially the same are assigned the same reference signs, and overlapping explanations are omitted or simplified.

Furthermore, in the present specification, terms that indicate relationships between elements such as "equal", terms that indicate the shapes of elements such as "flat plate-shaped" or "rectangular", and numerical ranges are not expressions that express only strict meanings, but expressions having meanings that encompass substantially equivalent ranges, e.g., a difference of about several percentage points.

Moreover, in the present specification, the terms "above" (or "upper") and "below" (or "lower") are used not as terms that indicate the upper direction (vertically above) and the lower direction (vertically below) in terms of absolute spatial perception, but as terms defined by relative positional relationships based on the order of stacking in a stacked configuration. Furthermore, the terms "above" and "below" are applied not only in cases in which two constituent elements are disposed having a space therebetween and another constituent element is present between the two constituent elements, but also in cases in which two constituent elements are disposed adhered to each other and the two constituent elements are in contact with each other.

Moreover, the x-axis, the y-axis, and the z-axis indicate three axes in a three-dimensional Cartesian coordinate system regarding a semiconductor laser element. Furthermore, the positive direction of the z-axis may be described as above, and the negative direction of the z-axis may be described as below. In addition, the face on an upper side may be described as the upper face, and the face on the lower side may be described as the lower face.

In the embodiments and the variations, the traveling direction, along the optical axis, of laser light directly after being emitted from a semiconductor laser element is defined as the negative direction of the y-axis, the direction parallel to the fast axis of laser light directly after being emitted from the semiconductor laser element is defined as the z-axis direction, and the direction parallel to the slow axis is defined as the x-axis direction.

In the embodiments described below, "plan view" means viewing the light source module from the positive side of the z-axis. "Front view" means viewing the light source module from the negative side of the y-axis, and the Drawing at this time is referred to as a front view. "Side view" means viewing the light source module from the positive side or the negative side of the x-axis, and the Drawing at this time is referred to as a side view.

[Embodiment 1]

[Configuration]

First, the configuration of light source module 10 according to Embodiment 1 will be described with reference to FIG. 1.

FIG. 1 is a perspective view illustrating the overall configuration of light source module 10 according to the present embodiment.

As illustrated in FIG. 1, light source module 10 includes case 501, platform 510, a plurality of optical units (here, optical units 1, 2, 3, 4, 5, and 6), a plurality of reflecting mirrors 700, condenser lens 800, optical fiber 550, and a pair of terminals 552. Furthermore, light source module 10 includes boot 551.

Light source module 10 is a module that, through the use of an optical system, can be caused to spatially combine and output laser lights emitted from each of a plurality of optical units. Furthermore, light source module 10 may be a module that, through the use of an optical system, can be caused to wavelength-beam combine and output laser lights emitted from each of a plurality of optical units. Note that in FIG. 1 and thereafter, a dashed line is illustrated at a position at which the optical intensity of laser light reaches the value of $1/(e^2)$ of the peak value, representing the divergence of the laser light.

Case 501 has base 502, side wall 503, and a lid (not illustrated).

Side wall 503 is disposed perpendicularly with respect to base 502 of case 501. Furthermore, side wall 503 is disposed so as to surround the plurality of optical units and the like. Moreover, the pair of terminals 552 are inserted into side wall 503, and the exterior and the interior of case 501 are electrically connected to each other by the pair of terminals 552. Side wall 503 is frame-shaped and rectangular in plan view, and, for example, includes Fe, an Fe alloy, an Fe-Ni-Co alloy, Cu, a Cu alloy, or Al. Furthermore, base 502 includes, for example, Cu, a Cu alloy, Al, a ceramic having high thermal conductivity (for example, AIN or BeO), or the like. The lid is a member that covers the top of case 501, and, for example, includes an inorganic material such as a metal or a ceramic material. In plan view, the lid is rectangular in shape and covers the entirety of the upper face of side wall 503.

Case 501 has a space that accommodates each of optical units 1 to 6. The space that accommodates optical units 1 to 6 is sealed in an airtight manner.

Inside case 501, platform 510 is provided. Platform 510 includes a plurality of stages in the shape of a staircase. The plurality of stages consist of first stage 511, second stage 512, third stage 513, fourth stage 514, fifth stage 515, and sixth stage 516. Each of first to sixth stage 511 to 516 has a first step and a second step. For example, first stage 511 has first step 511a and second step 511b. In each of first to sixth stage 511 to 516, the second step is positioned further on the positive side of the z-axis, that is, above, the first step. Furthermore, first stage 511, second stage 512, third stage 513, fourth stage 514, fifth stage 515, and sixth stage 516 are disposed, in this order, such that the z-axis position of each first step is positioned further on the positive side, and such that the z-axis position of each second step is positioned further on the positive side. Each of the plurality of first steps and each of the plurality of second steps is a flat face parallel to the xy-plane, and is the upper face of one stage.

In the present embodiment, each of the plurality of optical units is disposed on a different one of the plurality of stages. Each of the plurality of optical units is a device that is electrically connected to the pair of terminals 552, and converts the power inputted into the pair of terminals 552 to emit laser light. In the present embodiment, six optical units are provided. For distinction, the six optical units may be described as optical unit 1, optical unit 2, optical unit 3, optical unit 4, optical unit 5, and optical unit 6. The plurality of optical units are disposed aligned with each other in the x-axis direction. Each of the plurality of optical units has the same configuration, and here, optical unit 1 will be described.

FIG. 2 is a perspective view illustrating the configuration of optical units 1 and 2 according to the present embodiment. FIG. 3 is a side view illustrating the configuration of optical unit 1 according to the present embodiment. Note that in FIG. 3 and thereafter, optical axis LA1 of laser light L1 may be illustrated with a dash-dotted line. In the present specification, optical axis LA1 means the imaginary beam serving as the center of laser light L1.

Optical unit 1 includes semiconductor laser element 200, first submount 230, fast axis cylindrical lens 110, first fast axis adjustment lens 120, support member 150, and slow axis collimator lens 170. Optical unit 1 is disposed on first stage 511. Hereinafter, the constituent elements included in optical unit 1 will be described.

First submount 230 is a flat plate-shaped placement stand on which semiconductor laser element 200 is disposed. First submount 230 has first upper face 231, which is a flat plate-shaped upper face. First upper face 231 according to the present embodiment is a flat face parallel to the xy-plane. Semiconductor laser element 200 is disposed above first upper face 231.

First submount 230 is disposed above second step 511b. More specifically, first submount 230 is disposed above third bonding material 240 provided above second step 511b. Third bonding material 240 includes, for example, an inorganic material such as a solder material of, e.g., AuSn, SnAgCu, or the like.

First submount 230 includes, for example, a substrate of an insulating material such as a ceramic or a crystal of, e.g., AIN or SiC, and a metal layer that is the surface. First submount 230 may include a first electrode and a second electrode on first upper face 231. The patterned first electrode and second electrode are disposed insulated from each other on first upper face 231, and the first electrode and the second electrode each include a metal film that is, for example, one or a plurality of Ni, Cu, Pt, or Au. The semiconductor laser element is disposed on the first electrode, and is electrically connected to the second electrode by a metal wire. The first electrode and the second electrode are each connected to the second electrode or the first electrode of the submount adjacent thereto, or to terminal 552, and supply power to semiconductor laser element 200.

Semiconductor laser element 200 is a laser element that includes a semiconductor stacked film and an optical waveguide formed on a semiconductor substrate. The semiconductor stacked film includes an active layer, that is, semiconductor laser element 200 includes an active layer.

The optical waveguide of semiconductor laser element 200 is disposed on the first submount 230 side of semiconductor laser element 200. In other words, semiconductor laser element 200 is fixed by a so-called junction-down mounting. Furthermore, the semiconductor laser element is a multiple transverse mode laser that emits a high-output laser light.

Semiconductor laser element 200 emits laser light L1 that has a predetermined divergence angle. More specifically, semiconductor laser element 200 converts, into an induced emission beam such as laser light L1, power inputted into the optical waveguide from an external source, and emits the induced emission beam from one end of the optical waveguide. The fast axis of laser light L1 at this time is an axis in the stacking direction of the semiconductor stacked film of semiconductor laser element 200. Furthermore, the slow axis orthogonal to the fast axis is an axis parallel to the stacked face of the semiconductor stacked film.

In the present embodiment, the active layer of semiconductor laser element 200 is a layer that spreads in a direction parallel to the xy-plane, and immediately after laser light L1 is emitted from semiconductor laser element 200, the fast axis of laser light L1 is an axis parallel to the z-axis direction, and the slow axis of laser light L1 is an axis parallel to the x-axis direction.

Semiconductor laser element 200 enables changing the wavelength of laser light L1 to be emitted, by means of the constituent semiconductor material. For example, when semiconductor laser element 200 is a nitride-based semiconductor laser element having a nitride of Al, Ga, or In as a principal component, semiconductor laser element 200 can emit laser light L1 having a peak wavelength between, for example, a wavelength of 350 nm or greater and 550 nm or less. Furthermore, for example, when semiconductor laser element 200 is a semiconductor laser element that has, as a principal component, a semiconductor that includes Al, Ga, In, As, or P, semiconductor laser element 200 can emit laser light L1 having a peak wavelength between, for example, a wavelength of 600 nm or greater and 1,600 nm or less. Note that semiconductor laser element 200 is not limited to being a semiconductor laser element that includes the above-described semiconductor material, and furthermore, the wavelength of laser light L1 emitted by semiconductor laser element 200 is not limited to having the above-described wavelengths. Furthermore, semiconductor laser element 200 enables selecting the divergence angle of laser light L1 to be emitted, by means of the constituent semiconductor stacked structure and optical waveguide structure. Laser light L1 is emitted from semiconductor laser element 200 while diverging, and for example, the divergence angle has a total width of $1/(e^2)$, and the fast axis direction can be selected from between 20° to 70°, and the slow axis angle can be selected from between 5° and 30°.

Semiconductor laser element 200 is in the shape of a long rectangle in the waveguide direction of the optical waveguide. Furthermore, the optical waveguide has a width of, for example, 5 μm or greater and 300 μm or less, and a length of, for example, 500 μm or greater and 5 mm or less.

Fast axis cylindrical lens 110 (hereinafter, FACL 110) is a cylindrical lens on which laser light L1 emitted from semiconductor laser element 200 is incident, and that focuses laser light L1 in the fast axis direction of laser light L1.

In the present embodiment, laser light L1 emitted from semiconductor laser element 200 is directly incident on FACL 110. FACL 110 narrows the divergence angle of laser light L1 along the fast axis, and converts laser light L1 incident on FACL 110 to laser light L1 having a small divergence angle along the fast axis and being nearly parallel light. In other words, FACL 110 is a lens that pseudo-collimates laser light L1 in the fast axis direction.

FACL 110 is an optical component having power (refractive power) in the fast axis direction that is higher than the power in the slow axis direction. FACL 110 is a cylindrical lens having a power axis and a non-power axis. Furthermore, the power axis and the non-power axis are disposed perpendicular to each other. FACL 110 has a convex columnar face such as a convex curved cylindrical face along the power axis.

Furthermore, FACL 110 is a convex cylindrical lens having an incident face on which laser light L1 is incident, and an exit face through which laser light L1 exits. In other words, FACL 110 is a convex lens. In the present embodiment, FACL 110 is a plano-convex cylindrical lens that is convex in shape and has an incident face that is a flat face parallel to the zx-plane, and an exit face that is a curved face represented by an aspheric function.

In the present embodiment, a plano-convex cylindrical lens was used as FACL 110, but aside from this, a biconvex cylindrical lens or a convex meniscus cylindrical lens in which one face is a convex face and the other face is a concave face may be used.

FACL 110 is a member including an inorganic transparent material such as glass, and an antireflective coating film matched to the wavelength of laser light L1 is formed on the incident face on which laser light L1 is incident and the exit face from which laser light L1 exits.

Furthermore, FACL 110 is fixed to, for example, first submount 230 by means of a joining material (not illustrated). The joining material bonds FACL 110 with first submount 230. The joining material may include, for example, an ultraviolet curable adhesive containing an ultraviolet curable resin. Alternatively, the joining material may include an inorganic-containing adhesive obtained by kneading an inorganic filler made of an inorganic material such as alumina into an ultraviolet curable resin. Alternatively, the joining material may be an inorganic joining material that includes an inorganic material such as a solder material or a metal sintered body.

First fast axis adjustment lens 120 (hereinafter, first lens 120) is a lens on which laser light L1 that has exited from FACL 110 is incident, and that adjusts optical axis LA1 of laser light L1 in the fast axis direction.

First lens 120 is an optical component having power in the fast axis direction that is higher than the power in the slow axis direction. First lens 120 according to the present embodiment is a cylindrical lens having a power axis and a non-power axis. Furthermore, the power axis and the non-power axis are disposed perpendicular to each other. First lens 120 has a convex columnar face such as a convex curved cylindrical face along the power axis. First lens 120 is a convex cylindrical lens. In other words, first lens 120 is a convex lens.

Furthermore, first lens 120 is a convex cylindrical lens having an incident face on which laser light L1 is incident, and an exit face through which laser light L1 exits. Furthermore, the power of first lens 120 is sufficiently low compared to the power of FACL 110. Moreover, the curvature of the surface of first lens 120 is sufficiently larger than the beam spot of laser light L1 that is transmitted therethrough. The refraction amount of laser light L1 that is incident on this first lens 120 changes in accordance with the position of incidence, the optical axis LA1 direction changes in accordance with this, and then laser light L1 is outputted. This first lens 120 collimates incident light that is incident while slightly diverging along the fast axis. In other words, laser light L1, which is pseudo-collimated light that is incident on first lens 120, exits as light collimated in the fast axis direction. Then, laser light L1 is outputted as laser light L1 for which the optical axis LA1 direction has changed in accordance with the position of incidence on first lens 120.

In the present embodiment, first lens 120 is a plano-convex cylindrical lens having an incident face that is planar and an exit face that is convex. Furthermore, the incident face is a face parallel to the zx-plane. The exit face is a curved face represented by a spheric function having a large radius of curvature.

In the present embodiment, a plano-convex cylindrical lens was used as first lens 120, but aside from this, a biconvex cylindrical lens or a convex meniscus cylindrical lens in which one face is a convex face and the other face is a concave face may be used.

First lens 120 is a member that includes an inorganic transparent material such as glass, and an antireflective coating film matched to the wavelength of laser light L1 is formed on the incident face on which laser light L1 is incident and the exit face from which laser light L1 exits.

First lens 120 and support member 150 will be further described with reference to FIG. 4A and FIG. 4B.

FIG. 4A is a front view illustrating first lens 120 and support member 150 according to the present embodiment.

First lens 120 has generatrix 125, first side face 121, second side face 122 and third side face 123, and fourth side face 124.

Generatrix 125 is illustrated by a dash-dotted line. Generatrix 125 is a straight line that follows, of the convex cylindrical surface that is the exit face from which laser light L1 exits, the convex apex portion. First lens 120 according to the present embodiment is a member composed of only of a lens body, and in generatrix 125, the thickness of the lens body that is first lens 120 is the thickest. Note that the straight line in each position when a columnar face is formed by the movement of the straight line is a generatrix, and generatrix 125 is one among countless generatrices. All generatrices including generatrix 125 of first lens 120 according to the present embodiment are parallel to the xy-plane.

Third side face 123 is a side face perpendicular to generatrix 125. Fourth side face 124 is a side face that faces opposite to third side face 123 and is perpendicular to generatrix 125. In the present embodiment, fourth side face 124 of first lens 120 is bonded to support member 150. In other words, first lens 120 is supported by being bonded to support member 150 on the yz-plane. Thus, first lens 120 can be fixed by adjusting the position of generatrix 125 in the z-axis direction (the directions of the arrow in FIG. 4A) and the y-axis direction. In other words, first lens 120 can be fixed by adjusting the position of generatrix 125 in the fast axis direction or the optical axis LA1 direction of laser light L1.

Support member 150 is a member that is fixed to platform 510 and supports first lens 120. Support member 150 may be in any shape as long as it is capable of supporting first lens 120, but here, support member 150 is a member being in a rectangular parallelepiped shape, as an example. Support member 150 has: first supporting side face 151 and second supporting side face 152 that faces opposite to first supporting side face 151, each of which is parallel to the yz-plane; and upper face 153 and lower face 154 that faces opposite to upper face 153, each of which is parallel to the xy-plane.

Support member 150 includes, for example, the same glass material as that of first lens 120. Furthermore, support member 150 may include, e.g., a ceramic such as $Al_2O_3$, $ZrO_2$, or SiN, or may include a metal such as Fe or an Fe alloy.

Support member 150 is bonded to platform 510. Lower face 154 of support member 150 is bonded to first step 511a by using second bonding material 162. Second bonding material 162 is an inorganic material such as a solder material or a metal sintered body. In this case, support member 150 includes glass or $Al_2O_3$ ceramic, and the surface of first supporting side face 151 and the surface of lower face 154 have formed thereon a base film that includes a metal material having favorable wettability with respect to second bonding material 162, such as Au. Second bonding material 162 utilizes an inorganic joining material that includes an inorganic material having a high melting point, such as AuSn solder or an Ag sintered body.

First lens 120 is bonded to support member 150. Fourth side face 124 of first lens 120 is bonded to first supporting side face 151 of support member 150 by using first bonding material 161. First supporting side face 151 is the face to which first lens 120 is attached. First bonding material 161 utilizes an inorganic joining material that includes an inorganic material such as a solder material. In this case, fourth side face 124 of first lens 120 also has formed thereon a base film that includes a metal material having favorable wettability with respect to the solder material. First bonding material 161 utilizes a material having a melting point lower than that of second bonding material 162, such as SnAgCu solder or AuSn solder.

In this way, in the present embodiment, the position of first lens 120 is moved and adjusted in the fast axis direction, and support member 150 and first lens 120 are bonded together face (first supporting side face 151) to face (fourth side face 124). Thus, compared to, for example, a case in which a point is bonded to a point, it is possible to reduce the thickness of first bonding material 161 over a broader range. This makes it possible to reduce the stress inside the bonding material that occurs when first bonding material 161 hardens, thereby inhibiting a reduction of the bond strength. Furthermore, since first bonding material 161 has a lower melting point than second bonding material 162, displacement of the position of support member 150 can be inhibited at the time of fixing first lens 120.

As described above, first lens 120 is a lens on which laser light L1 is incident, and that adjusts the optical axis of laser light L1 in the fast axis direction. More specifically, in the manufacturing of optical unit 1, the position of first lens 120 is moved, that is, adjusted, such that the coupling efficiency between outputted laser light L1 and optical fiber 550 increases.

In the manufacturing of optical unit 1, first, the position of support member 150 is fixed by using second bonding material 162. Subsequently, the position of first lens 120 is moved and then fixed by heating and cooling first bonding material 161, such that the coupling efficiency between outputted laser light L1 and optical fiber 550 increases.

When the position of first lens 120 is fixed, hardening shrinkage of first bonding material 161 may occur. Since first lens 120 is supported on the yz-plane, even when such hardening shrinkage occurs, displacement of generatrix 125 in the z-axis direction, that is, the fast axis direction, is inhibited.

FIG. 4B is a front view illustrating first lens 120 and support member 150 according to another example of the present embodiment.

Support member 150 is formed on platform 510 beforehand. For example, when forming platform 510 that includes copper, support member 150 is fabricated at the same time. Furthermore, when manufacturing case 501 by bonding base 502 and side wall 503 together, similarly, the configuration may be such that support member 150, which includes an Fe alloy, is bonded and fixed to base 502 by using silver solder. First lens 120 according to the other example includes lens body 1201 that includes glass, and lens holder 1202 that includes an Fe alloy. Lens holder 1202 is a flange. Lens body 1201 and lens holder 1202 are bonded to each other beforehand by using a low-melting-point glass or the like. Note that lens body 1201 according to the other example illustrated in FIG. 4B corresponds to first lens 120 according to the present embodiment illustrated in FIG. 4A.

In the other example, support member 150 similarly has first supporting side face 151. Furthermore, first lens 120 has fourth side face 124. In this other example, similarly, first lens 120 is moved while first supporting side face 151 and fourth side face 124 are caused to adhere to each other, and is fixed to support member 150 by using first bonding material 161. In this other example, laser light is outputted onto a part at which lens holder 1202 and support member 150 are in proximity to each other to cause lens holder 1202 and a part of support member 150 to melt and be welded together. In other words, first lens 120 and support member 150 are bonded together by using first bonding material 161, which is a welding part that includes an inorganic material. This makes it possible to firmly fix first lens 120.

Thus, first lens 120 according to the other example can be fixed by adjusting the position of generatrix 125 in the z-axis direction (the direction of the arrow in FIG. 4B) and the y-axis direction. In other words, the position of generatrix 125 can be adjusted and fixed in the fast axis direction or the optical axis LA1 direction of laser light L1.

Laser light L1 that exits from first lens 120 according to the present embodiment and the other example of the present embodiment is laser light that travels while being collimated in the fast axis direction and diverging in the slow axis direction. Laser light L1 that exits from first lens 120 is incident on slow axis collimator lens 170 (hereinafter, SACL 170). Returning to FIG. 2 and FIG. 3, SACL 170 will be described.

SACL 170 is a lens on which laser light L1 that exits from first lens 120 is incident, and that collimates laser light L1 in the slow axis direction of laser light L1. SACL 170 is a lens that has power along the slow axis of the laser light. SACL 170 has a non-power axis in a direction orthogonal to the power axis. SACL 170 is a lens having a convex curved elliptical face, that is, a convex elliptical surface, along the power axis. SACL 170 according to the present embodiment is a plano-convex cylindrical lens having a planar face on which laser light L1 is incident, and a convex face from which laser light L1 exits. SACL 170 includes, as an example, glass having an antireflective coating film formed on the surface.

Alternatively, SACL 170 may be a biconvex cylindrical lens, or may be a meniscus cylindrical lens in which one face is a convex face and the other face is a concave face.

A plurality of SACLs 170 collimate, in the slow axis direction, components of the laser light that are incident on each SACL 170. SACL 170 is disposed on first step 511a.

Due to this configuration, laser light L1 that has passed through SACL 170 travels as output light collimated in both the fast axis and the slow axis, and reaches reflecting mirror 700. Note that the beam width in the fast axis direction of laser light L1 that has reached reflecting mirror 700 is width W1, which is the same as width W1 that is the beam width in the fast axis direction of laser light L1 that has exited from first lens 120.

Reflecting mirror 700 will be described, once again referring to FIG. 1.

As illustrated in FIG. 1, optical unit 1 emits laser light L1. Similarly, optical units 2 to 6 emit laser lights L2, L3, L4, L5, and L6, respectively. The plurality of laser lights (that is, laser lights L1 to L6) emitted from the plurality of optical units are incident on a plurality of reflecting mirrors 700.

Each of the plurality of reflecting mirrors 700 is an optical component having an incident face (reflecting face) on which the laser light that has passed through the respective SACL 170 of the plurality of SACLs 170 is incident. The plurality of reflecting mirrors 700 reflect the respective laser lights that have been collimated by the plurality of first lenses 120 and the plurality of SACLs 170, described above, and perform 90° polarization on the directions of the laser lights. The reflecting faces of the plurality of reflecting mirrors 700 are, in plan view, tilted 45° with respect to the zx-plane. Here, each of the plurality of laser lights L1 to L6 travels in the negative direction of the y-axis parallel to the y-axis, and is incident on a respective one of the plurality of reflecting mirrors 700. Each of the plurality of laser lights L1 to L6 reflected by the respective one of the plurality of reflecting mirrors 700 travels in the positive direction of the x-axis parallel to the x-axis.

Each of the plurality of reflecting mirrors 700 is disposed on the first step of a respective one of the plurality of stages. For example, reflecting mirror 700 on which laser light L1 is incident is disposed on first step 511a.

The plurality of laser lights L1 to L6 reflected by the respective reflecting mirrors 700 are spatially combined such that the fast axes have the same optical axis, and then reach condenser lens 800 fixed on base 502.

Condenser lens 800 is an optical component that has an incident face on which the laser lights that have passed through the respective SACLs 170 of the plurality of SACLs 170 are incident. Further, condenser lens 800 is an optical component on which the plurality of laser lights L1 to L6 that have passed through reflecting mirror 700 are incident. In the present embodiment, condenser lens 800 is a lens that condenses the plurality of laser lights L1 to L6 that have arrived. The plurality of laser lights L1 to L6 whose respective fast axes have the same optical axis due to reflecting mirrors 700 are incident on condenser lens 800. Further, the plurality of laser lights L1 to L6 condensed by condenser lens 800 are incident on an incident face that is an end face of the core of optical fiber 550, which is an example of target 550a. Providing such a condenser lens 800 makes it possible to efficiently condense the plurality of laser lights L1 to L6 onto target 550a.

Optical fiber 550 is provided so as to penetrate side wall 503. The laser lights, being from each of the plurality of optical units and having been condensed by reflecting mirror 700, are coupled in optical fiber 550. Furthermore, boot 551 is a member for covering and protecting the periphery of optical fiber 550. The plurality of laser lights coupled in optical fiber 550 are transmitted along the core of optical fiber 550 and outputted from the end of optical fiber 550, outside of case 501, as emitted laser light L100.

Note that as the plurality of reflecting mirrors 700 that correspond to the plurality of optical units, reflecting mirrors all having the same shape may be used.

Note that as illustrated in FIG. 1, one optical unit and one reflecting mirror 700 are disposed on each of the plurality of stages of platform 510.

Here, the parameters of optical unit 1 will be described in further detail with reference to FIG. 5.

Furthermore, the beam spots of the plurality of laser lights L1 to L6 on the incident face of condenser lens 800 will be described with reference to FIG. 6A. Moreover, the beam spots of laser light L1 and laser light L2 on the end face of the core of optical fiber 550 will be described with reference to FIG. 6B.

FIG. 5 is a side view of optical unit 1 according to the present embodiment. In other words, FIG. 5 illustrates the configuration of the optical system of optical unit 1 in the fast axis direction.

Semiconductor laser element 200 emits, from light emission point 201 that is one end of the optical waveguide, laser light L1 that has a predetermined divergence angle. Note that the width, in the slow axis direction (x-axis direction), of the region that, of the active layer of semiconductor laser element 200 in optical unit 1, emits laser light L1 may be described as the light-emitting region width.

Furthermore, as described above, optical unit 1 has FACL 110 and first lens 120. Thus, the optical system of optical unit 1 in the fast axis direction can be handled by using a composite lens of FACL 110 and first lens 120. Each lens has a principal point and an effective focal length that are determined by surface curvature, thickness, and the like. Principal point P1 denotes the principal point of FACL 110, and effective focal length F1 denotes the effective focal length of FACL 110. Principal point P2 denotes the principal point of first lens 120, and effective focal length F2 denotes the effective focal length of first lens 120. Furthermore, the composite lens has principal point P0, which is its principal point, and effective focal length F, which is its effective focal length. The distance between FACL 110 and first lens 120 is lens distance d, which is the distance between principal point P1 and principal point P2.

First lens 120 is a convex cylindrical lens; thus, $F2 > 0$. Furthermore, principal point P0 is determined by principal point P1 and principal point P2, effective focal length F1, effective focal length F2, and lens distance d. The distance between principal point P0 and principal point P1 is $\delta$. Effective focal length F is determined by effective focal length F1 and effective focal length F2, and lens distance d.

In optical unit 1, light emission point 201 is disposed near the focal point of this composite lens. Thus, the distance between principal point P0 and light emission point 201 of the composite lens corresponds to F, which is the effective focal length of the composite lens.

The beam width, in the fast axis direction, of laser light L1 that has exited from first lens 120 of optical unit 1 is denoted by width W1. In light source module 10 that has the plurality of optical units, when causing the plurality of laser lights to be combined in the fast axis direction, it is better for width W1 to be smaller. Since at this time, width W1 is proportional to effective focal length F of the composite lens, it is better for effective focal length F to be smaller.

FIG. 6A is a diagram illustrating beam spots of the plurality of laser lights L1 to L6 on the incident face of condenser lens 800 according to the present embodiment.

In FIG. 6A, each of the beam spots of the plurality of laser lights L1 to L6 is illustrated by a dashed line. The beam spots represent the ranges at which the beam intensity of laser lights L1 to L6 is high, and the regions at which the beam intensity has a peak value of $1/(e^2)$ are represented by dashed lines. Furthermore, the beam spot of laser light L1 is illustrated by beam spot LO1, the beam spot of laser light L2 is illustrated by beam spot LO2, the beam spot of laser light L3 is illustrated by beam spot LO3, the beam spot of laser light L4 is illustrated by beam spot LO4, the beam spot of laser light L5 is illustrated by beam spot LO5, and the beam spot of laser light L6 is illustrated by beam spot LO6.

Furthermore, the width of beam spot LO1 in the fast axis (z-axis) direction is width W1. Width W1 of beam spot LO1 in the fast axis direction is, as illustrated in FIG. 3, the same as width W1 that is the beam width, in the fast axis direction, of laser light L1 that has reached reflecting mirror 700, and is, as illustrated in FIG. 5, the same as width W1, in the fast axis direction, of laser light L1 that has exited from first lens 120.

In other words, in the present embodiment, from the time laser light L1 exits from first lens 120 to the time laser light L1 is incident on condenser lens 800, width W1, which is the beam width of laser light L1 in the fast axis direction, is constant. The width of beam spot LO2 in the fast axis direction is width W2, the width of beam spot LO3 in the fast axis direction is width W3, the width of beam spot LO4 in the fast axis direction is width W4, the width of beam spot LO5 in the fast axis direction is width W5, and the width of beam spot LO6 in the fast axis direction is width W6.

Note that similarly to laser light L1, from the time laser light L2 exits from first lens 120 to the time laser light L2 is incident on condenser lens 800, width W2, which is the beam width of laser light L2 in the fast axis direction, is constant. The beam width being constant in the fast axis direction is the same with regard to laser lights L3 to L6 as well.

Furthermore, the width between beam spot LO1 and beam spot LO2 in the fast axis direction is width D1, the width between beam spot LO2 and beam spot LO3 in the fast axis direction is width D2, the width between beam spot LO3 and beam spot LO4 in the fast axis direction is width D3, the width between beam spot LO4 and beam spot LO5 in the fast axis direction is width D4, and the width between beam spot LO5 and beam spot LO6 in the fast axis direction is width D5.

Furthermore, the width, in the fast axis direction, of the combined laser light obtained by spatially combining laser lights L1 to L6 is width Wt1. Width Wt1 is the sum of width W1, width D1, width W2, width D2, width W3, width D3, width W4, width D4, width W5, width D5, and width W6. When the outer diameter of condenser lens 800 is fixed, in order for all of laser lights L1 to L6 to be incident on condenser lens 800, it is necessary for width Wt1 to be less than or equal to the outer diameter of condenser lens 800. Width Wt1 may be less than or equal to $1/\sqrt{2}$ of the outer diameter of condenser lens 800. Thus, width W1, width D1, width W2, width D2, width W3, width D3, width W4, width D4, width W5, width D5, and width W6 may be less than or equal to a predetermined value. In the present embodiment, the case in which the six of laser lights L1 to L6 are incident is described, but in a case in which more laser lights are incident, width W1 and width D1 may be made smaller.

FIG. 6B is a diagram illustrating the beam spots of laser light L1 and laser light L2 on the end face of the core of optical fiber 550, which is target 550a according to the present embodiment.

The laser lights that exit from condenser lens 800 are incident on target 550a. FIG. 6B illustrates an example of the beam spots of laser light L1 and laser light L2 on the end face of the core of optical fiber 550, which is target 550a. In FIG. 6B, the core having a size in the y-axis direction of DS and a size in the z-axis direction of DF, and the beam spot of laser light L1 having a size in the y-axis direction of WS1 and a size in the z-axis direction of WF1 are illustrated. At this time, size WF1 of laser light L1 in the z-axis direction is a size obtained by multiplying the size of light emission point 201 of semiconductor laser element 200 in the z-axis direction by the optical magnification of the optical system including FACL 110, first lens 120, and condenser lens 800. Furthermore, the beam spot of laser light L2 is also illustrated. In target 550a, laser light L1 and laser light L2 are disposed within the core in an overlapping manner. Laser lights L3 to L6, not illustrated, are similarly disposed within the core, overlapping L1 and L2. Thus, the plurality of laser lights L1 to L6 can be coupled into the core in an overlapping manner. This makes it possible to realize light source module 10 in which the plurality of laser lights L1 to L6 are combined, the intensity of the laser lights within the core is increased, and the luminance of emitted laser light L100 is high. In the present embodiment, the example in which the six of laser lights L1 to L6 are coupled into the core in an overlapping manner is described, but light source module 10 having emitted laser light L100 with higher luminance can be realized by coupling more laser lights into the core.

As described above, width W1, which is the beam width of laser light L1 in the fast axis direction, is a small value. Similarly, widths W2 to W6, which are the respective beam widths of laser lights L2 to L6 in the fast axis direction, are also small values. Thus, in the present embodiment, width Wt1 of the combined laser light in the fast axis direction, obtained by spatially combining laser lights L1 to L6, is smaller than the width of the incident face of condenser lens 800, which has a predetermined size.

Thus, decreasing the size of width W1 makes it possible to increase the number of laser lights incident on the incident face of condenser lens 800, which has a predetermined size. This makes it possible to increase the radiation luminance of the laser lights that exit from condenser lens 800.

In FIG. 6B, laser light L1 and laser light L2 are illustrated as being slightly displaced from each other, but when laser light L1 and laser light L2 are completely parallel to each other before becoming incident on condenser lens 800, laser light L1 and laser light L2 coincide. Furthermore, when, before becoming incident on condenser lens 800, the traveling direction of laser light L1 is tilted with respect to imaginary line IL, for example, the beam spot of laser light L1 becomes disposed outside of target 550a, whereby the coupling efficiency decreases.

Thus, increasing the number of combined laser lights L1 to L6 on the incident face of condenser lens 800 and making each of laser lights L1 to L6 parallel to imaginary line IL makes it possible to increase the light amount that enters optical fiber 550 from the end face of the core of optical fiber 550. Furthermore, the light amount and the radiation luminance of the laser lights that exit from optical fiber 550 of light source module 10 can be increased.

In optical unit 1, effective focal length F1 of FACL 110 is small, and effective focal length F2 of first lens 120 is sufficiently larger than effective focal length F1 of FACL 110. In this case, effective focal length F of the composite lens approaches effective focal length F1. Thus, in order to, as described above, make width W1, which is the beam width of laser light L1 in the fast axis direction, a sufficiently small value, effective focal length F1 may be decreased and the ratio between effective focal length F2 and effective focal length F1 may be increased. This makes it possible to increase the light amount and the radiation luminance of the laser lights that exit from optical fiber 550 of light source module 10.

Here, width W1, which is the beam width, may be a small value, but when the value is too small, lenses such as FACL 110 become excessively small and handling becomes difficult. In the present embodiment, width W1 is, for example, 0.17 mm or greater and 0.5 mm or less. Furthermore, in the present embodiment, effective focal length F1 of FACL 110 is, for example, 0.15 or greater than 0.65 mm or less.

Further, the effects of first lens 120 being adjusted will be described with reference to FIG. 7 and FIG. 8. Here, the effects of using laser light L1 emitted from optical unit 1 will be described, but similar effects can be expected from optical units 2 to 6 as well.

FIG. 7 is a side view of optical unit 1 that illustrates an example in which the position of first lens 120 of optical unit 1 is adjusted in the fast axis direction, in a method for manufacturing light source module 10 according to the present embodiment. FIG. 8 is a side view of optical unit 1 that illustrates another example in which the position of first lens 120 of optical unit 1 is adjusted in the fast axis direction, in the method for manufacturing light source module 10 according to the present embodiment.

The method for manufacturing light source module 10 will be described with reference to FIG. 1. First, semiconductor laser element 200 is disposed on platform 510 of case 501 via first submount 230. Subsequently, optical fiber 550, reflecting mirror 700, and condenser lens 800 are fixed at predetermined positions of case 501 by using a bonding material, not illustrated. Subsequently, FACL 110, first lens 120, and SACL 170 are disposed at predetermined positions. Here, FACL 110, first lens 120, and SACL 170 are initially disposed at the designed center of the optical system. However, since, in actuality, the positions of, e.g., semiconductor laser element 200 and the downstream optical system are displaced slightly from the designed positions, it is necessary to slightly adjust the positions of FACL 110 and SACL 170 to improve the coupling efficiency between laser lights L1 to L6 and optical fiber 550. As a method of doing this, the amount of light that exits from optical fiber 550 is monitored while causing emission from semiconductor laser element 200, and FACL 110 and SACL 170 are moved to and fixed at the optimal locations; that is, positional adjustment and fixing are performed by means of active alignment.

However, there are cases in which even when the positional adjustment and fixing are performed, the improvement of the coupling efficiency between laser lights L1 to L6 and optical fiber 550 is insufficient. FIG. 7 illustrates an example of improving the coupling efficiency by adjusting the position of first lens 120, after fixing FACL 110. (a) in FIG. 7 is a side view of a state before first lens 120 is adjusted. In FIG. 7, imaginary line IL, which is the optimal optical axis of optical unit 1, is shown for illustrative purposes. That is, FIG. 7 illustrates that the coupling efficiency is highest when laser light L1 is incident on reflecting mirror 700 while coinciding with or being parallel to imaginary line IL. In the present embodiment, imaginary line IL is a line that is parallel to the y-axis, and the position of imaginary line IL in the z-axis direction is the same as the position of light emission point 201 in the z-axis direction. As described above, the position of FACL 110 is adjusted by active alignment and is fixed by using a joining material, not illustrated; however, due to, e.g., hardening shrinkage of the joining material during fixing, the position of FACL 110 may be displaced by several sub-μm to several μm from the predetermined position. When FACL 110 is displaced in the fast axis direction in particular, the decrease in the coupling efficiency is significant due to the focal length being short.

FIG. 7 illustrates a case (displayed by the short arrow) in which FACL 110 has been displaced in the positive direction of the z-axis (upward). In this case, pseudo-collimated laser light L1 tilts upward from the y-axis direction by 0° or greater and propagates toward the negative direction of the y-axis. That is, the angle formed between optical axis LA1 of laser light L1 transmitted through FACL 110, and imaginary line IL becomes greater than 0°.

At this time, when the position of generatrix 125 of first lens 120 in the z-axis direction is in a position overlapping with imaginary line IL as illustrated in (a) in FIG. 7, that is, when first lens 120 is disposed in the designed position in the method for manufacturing the light source module, the angle formed between optical axis LA1 of laser light L1 and imaginary line IL due to refraction changes, but laser light L1 transmitted through first lens 120 tilts upward from the y-axis direction and travels toward the negative direction of the y-axis. In this case, a part of laser light L1 is not incident on reflecting mirror 700, or, even when being on reflecting mirror 700, cannot pass through condenser lens 800 and enter optical fiber 550. In this state, the coupling efficiency in light source module 10 decreases.

However, as illustrated in (b) in FIG. 7, in the present embodiment, the position of first lens 120 is adjusted. Note that in (b) in FIG. 7, the position of first lens 120 before being moved is illustrated by the dash-dot-dot line. Furthermore, generatrix 1251 before adjusting first lens 120 is illustrated. For example, as in FIG. 7, when FACL 110 has been fixed displaced in the positive direction of the z-axis, the position of first lens 120 is adjusted in the negative direction of the z-axis (displayed by the long arrow). In other words, generatrix 125 of first lens 120 is further on the negative side of the z-axis than pre-adjustment generatrix 1251 is, that is, generatrix 125 is disposed at a predetermined position away from imaginary line IL. Accordingly, collimated laser light L1 transmitted through first lens 120 is more refracted compared to before the adjustment and is in a position displaced from imaginary line IL, but can be made to travel parallel to imaginary line IL. At this time, similarly to FACL 110, the position of first lens 120 is adjusted to the optimal position by monitoring the amount of light that exits from optical fiber 550 while causing emission from semiconductor laser element 200.

This makes it possible for laser light L1 to be reflected by reflecting mirror 700 and enter optical fiber 550 by using condenser lens 800. Furthermore, in light source module 10, the coupling efficiency can be improved.

In the above description, the position of FACL 110 being displaced, from the predetermined position, in the z-axis direction by several sub-$\mu$m to several $\mu$m causes the coupling efficiency to rapidly decrease. On the other hand, the coupling efficiency does not greatly change even if first lens 120 is displaced from the predetermined position by several $\mu$m to several tens of $\mu$m. This makes it possible to inhibit the coupling efficiency from decreasing, even if, after all, the position of first lens 120 is displaced by several $\mu$m due to, e.g., shrinking of the bonding material when fixing first lens 120.

(a) in FIG. 8 is an example in which optical axis LA1 of laser light L1 transmitted through FACL 110 is parallel to or coincides with imaginary line IL. Specifically, this is a case in which, when FACL 110 was adjusted and fixed at the optimal position, FACL 110 was not displaced. In this case, it is not necessary to adjust the position of first lens 120.

(b) in FIG. 8 is a diagram of a case in which FACL 110 has been fixed displaced, from the predetermined position, in the negative direction of the z-axis (the short arrow direction). In (b) in FIG. 8, the position of first lens 120 before being moved is illustrated with a dotted line, and generatrix 1251 before adjusting first lens 120 is illustrated. In this case, pseudo-collimated laser light L1 transmitted through FACL 110 tilts upward from the y-axis direction by 0° or greater with respect to imaginary line IL, and travels toward the negative direction of the y-axis.

Furthermore, in (b) in FIG. 8, the position of first lens 120 is adjusted in the positive direction of the z-axis. That is, generatrix 125 of first lens 120 is positioned further in the positive direction of the z-axis than generatrix 1251 is. Accordingly, collimated laser light L1 transmitted through first lens 120 is more greatly refracted than pre-adjustment laser light L1 transmitted therethrough, and travels parallel to imaginary line IL. That is, after passing through FACL 110, optical axis LA1 is tilted downward from the y-axis direction by 0° or greater, but after passing through first lens 120, optical axis LA1 is parallel to imaginary line IL. Thus, laser light L1 can enter optical fiber 550 after being reflected by reflecting mirror 700, and the coupling efficiency in light source module 10 can be improved.

In FIG. 7 and FIG. 8, examples in which first lens 120 is moved in the z-axis direction are illustrated, but this is not intended to be limiting. For example, when first lens 120 is moved in the y-axis direction, the distance between the incident face of first lens 120 and light emission point 201 of semiconductor laser element 200 changes. As a result, the degree of parallel alignment of laser light L1 that exits from first lens 120 can be controlled.

Next, a specific example of light source module 10 according to the present embodiment will be described. Here, this description will be provided with reference to light source module 10x according to Comparative Example 1 and light source module 10xx according to Comparative Example 2.

FIG. 9 is a side view illustrating light source module 10x according to Comparative Example 1. FIG. 10 is a side view illustrating light source module 10xx according to Comparative Example 2. FIG. 11 is a side view illustrating light source module 10 according to the present embodiment. For simplicity, FIG. 9 to FIG. 11 are described using two optical units.

Furthermore, in FIG. 9 to FIG. 11, laser lights L1 and L2 are being emitted from the two optical units. The beam width, in the fast axis direction, of laser light L1 that has reached reflecting mirror 700 in the side views illustrated in FIG. 9 to FIG. 11 is width W1. The beam width, in the fast axis direction, of laser light L2 that has reached reflecting mirror 700 is width W2. Similarly, in the side views, the width, in the fast axis direction, between laser light L1 and laser light L2 that have each reached reflecting mirror 700 is width D1. Furthermore, in the side views, the width, in the fast axis direction, obtained by adding width W1, width D1, and width W2 is width Wt2. Note that width D1, which is the width between laser light L1 and laser light L2 in the fast axis direction in FIG. 11 is the same as the width between beam spot LO1 and beam spot LO2 in the fast axis direction illustrated in FIG. 6A.

Light source module 10x according to Comparative Example 1 (FIG. 9) has the same configuration as that of light source module 10 according to the present embodiment, except that instead of optical units 1 to 6, light source module 10x has optical unit 1x, and optical unit 2x and four optical units that have the same configuration as optical unit 1x.

Optical unit 1x according to Comparative Example 1 has the same configuration as optical unit 1 according to the present embodiment, except that optical unit 1x does not have first lens 120.

In optical unit 1x, in order to decrease width Wt2, it is necessary to decrease effective focal length F1x of fast axis collimator lens 1101, and to decrease widths W1 and W2. Here, problems that may occur when effective focal length F1x is small will be described.

In this optical unit 1x, the position of principal point P1 at which the coupling efficiency is the highest is considered to be the optimal position of principal point P1. When optical unit 1x is manufactured, there may be a case in which the position of principal point P1 is displaced from the optimal position of principal point P1. In a specific example, after fast axis collimator lens 1101 is adjusted by active alignment, a volume change occurs in the bonding material when performing the fixing, and fast axis collimator lens 1101 is displaced. In a case in which F1x, which is the effective focal length, is small, when, for example, the position of principal point P1 is displaced from the optimal position of principal point P1 in the z-axis direction, there is a problem in which the traveling direction of the laser light tilts with respect to imaginary line IL, and consequently, the coupling efficiency with the optical fiber decreases. In FIG. 9, the laser light having such a tilted traveling direction is illustrated as laser light L11 and laser light L21. Note that in FIG. 9, laser lights in a case in which the position of principal point P1 was not displaced from the optimal position of principal point P1 when optical units 1x and 2x were being manufactured are illustrated as laser light L1 and laser light L2.

Furthermore, since optical unit 1x does not include first lens 120, an effect as illustrated in FIG. 11, in which the traveling directions of laser lights L11 and L21 are adjusted by first lens 120, cannot be achieved. Thus, in light source module 10x according to Comparative Example 1, the coupling efficiency is more susceptible to decreasing compared to the present embodiment.

Light source module 10xx according to Comparative Example 2 has the same configuration as that of light source module 10 according to the present embodiment, except that instead of optical units 1 to 6, light source module 10xx has optical unit 1xx, and optical unit 2xx and four optical units that have the same configuration as optical unit 1xx.

Optical unit 1xx according to Comparative Example 2 has the same configuration as optical unit 1 according to the present embodiment, except that optical unit 1xx has first lens 120xx instead of first lens 120.

In Comparative Example 2, Fxx denotes the effective focal length of a composite lens of FACL 110 and first lens 120xx. δxx denotes the distance between principal point P0 and principal point P1. dxx denotes the distance between principal point P1 of FACL 110 and principal point P2 of first lens 120xx. F2xx denotes the effective focal length of first lens 120xx.

In light source module 10xx according to Comparative Example 2, F2xx may not be sufficiently large compared to effective focal length F1 of FACL 110. Furthermore, in light source module 10xx according to Comparative Example 2, the values of F2xx and dxx may be relatively close. In this case, δxx is relatively large with respect to F2xx, that is, the values of F2xx and δxx are close to each other. Note that in light source module 10 according to the present embodiment, δ is relatively small with respect to F2. More specifically, F2, δ, F2xx, and δxx satisfy the relationship of (F2/δ) > (F2xx/bxx).

In light source module 10xx, since δxx is relatively large with respect to F2xx, width W1 and width W2 become large even if FACL 110 having a small effective focal length F1 is used, and consequently, width Wt2 becomes large.

Width Wt2 becoming large leads to the width of the combined laser light that has been spatially combined becoming larger than the condenser lens in the fast axis direction, whereby in light source module 10x according to Comparative Example 2 illustrated in FIG. 10, the coupling efficiency decreases compared to that of the present embodiment illustrated in FIG. 11.

This is further described with reference to Formula 17 and Formula 18.

F, which is the effective focal length of the composite lens, F1, which is the effective focal length of FACL 110, F2, which is the effective focal length of first lens 120, d, which is the lens distance that is the distance between principal point P1 and principal point P2, and δ, which is the distance between principal point P0 and principal point P1, satisfy Formula 17 and Formula 18.

$$1/F = (1/F1) + (1/F2) - (d/(F1 \times F2)) \qquad \text{(Formula 17)}$$

$$\delta = (F \times d)/F2 \qquad \text{(Formula 18)}$$

F, which is the effective focal length of the composite lens, can be represented by Formula 17. Furthermore, δ, which is the distance between principal point P0 and principal point P1, can be represented by Formula 18.

In the present embodiment, F can be made closer to F1 and δ can be decreased by making F2 sufficiently large.

Next, regarding light source module 10x according to Comparative Example 1, the result of calculating the change in the coupling efficiency when the position of the fast axis collimator lens has been displaced from the optimal position will be described.

FIG. 12 is a diagram illustrating the result of calculating, for light source module 10x according to Comparative Example 1, the change in the coupling efficiency under each of a plurality of optical system conditions (conditions A1 to A9), by using a simulation. The configuration of light source module 10x is a configuration in which first lens 120 and support member 150 have been removed from light source module 10 of FIG. 1. That is, six optical units each including semiconductor laser element 200, fast axis collimator lens 1101, and SACL 170 are aligned on a platform, and the emitted lights outputted from the optical units are reflected by six reflecting mirrors and spatially combined in the fast axis direction. Then, the combined output light is condensed and coupled on the end face of an optical fiber, by a condenser lens. FIG. 13 is a diagram illustrating a table that describes the plurality of optical system conditions (conditions A1 to A9) illustrated in FIG. 12. That is, FIG. 13 indicates the optical parameters of semiconductor laser element 200, fast axis collimator lens 1101, SACL 170, condenser lens 800, and optical fiber 550 under conditions A1 to A9. As fast axis collimator lens 1101, a plano-convex lens having an incident face that is planar and an exit face that is a curved face represented by an aspheric function was employed.

In light source module 10x, when the coupling efficiency with optical fiber 550 is determined by the divergence angle of semiconductor laser element 200 and the numerical aperture of the optical fiber, the coupling efficiency is strongly dependent on the light-emitting region width of semiconductor laser element 200 and the core diameter of the optical fiber. Thus, calculations were performed for nine types of conditions obtained by multiplying the three types of optical system conditions, being conditions A1 to A3, conditions A4 to A6, and conditions A7 to A9, by the three types of conditions of the combinations of the light-emitting region width and the core diameter.

As illustrated in FIG. 13, under each of conditions A1 to A9, the peak wavelength of semiconductor laser element 200 was 450 nm. Note that when using a semiconductor laser element having a different peak wavelength, the lens material, lens function, antireflective film on the surface, and reflection design of each lens are optimized, but similar effects can be obtained. The divergence angle of semiconductor laser element 200 is, with a total width of $1/(e^2)$, 48° in the fast axis direction and 12° in the slow axis direction. Note that similar to the peak wavelength, when a semiconductor laser element having a different divergence angle is used, similar effects can be obtained by optimizing the optical system. Furthermore, as condenser lens 800, a plano-convex lens having an incident face that is a curved face represented by an aspheric function and an exit face that is planar was employed. Optical fiber 550 is a step index-type multimode fiber having a core and cladding, and has numerical aperture NA of 0.22.

Under condition A1, the light-emitting region width of semiconductor laser element 200 is 50 μm, F1x, which is the effective focal length of fast axis collimator lens 1101, is 0.15 mm, the effective focal length of SACL 170 is 6.4 mm, the effective focal length of condenser lens 800 is 4.5 mm, and the core diameter of optical fiber 550 is 50 μm.

Condition A2 is the same as condition A1, except that the core diameter of optical fiber 550 is 70 μm. Condition A3 is the same as condition A1, except that the light-emitting region width is 100 μm and the core diameter of optical fiber 550 is 100 μm.

Condition A4 is the same as condition A1, except that F1x, which is the effective focal length of fast axis collimator lens 1101, is 0.38 mm, the effective focal length of SACL 170 is 13.5 mm, and the effective focal length of condenser lens 800 is 7.3 mm.

Condition A5 is the same as condition A4, except that the core diameter of optical fiber 550 is 70 μm. Condition A6 is the same as condition A4, except that the light-emitting region width is 100 μm and the core diameter of optical fiber 550 is 100 μm.

Condition A7 is the same as condition A1, except that F1x, which is the effective focal length of fast axis collimator lens 1101, is 0.65 mm, the effective focal length of SACL 170 is 15.3 mm, and the effective focal length of condenser lens 800 is 11.3 mm.

Condition A8 is the same as condition A7, except that the core diameter of optical fiber 550 is 70 μm. Condition A9 is the same as condition A7, except that the light-emitting region width is 100 μm and the core diameter of optical fiber 550 is 100 μm.

Then, a simulation was performed in line with the plurality of conditions (conditions A1 to A9) illustrated in FIG. 13. In this simulation, the coupling efficiency when the six laser lights emitted from the six optical units (optical unit 1x, and optical unit 2x and the four optical units that have the same configuration as optical unit 1x) in light source module 10x according to Comparative Example 1 were spatially combined and made to enter optical fiber 550 was calculated. Note that the coupling efficiency is calculated by a ratio between the total light amount of the six laser lights emitted from the six semiconductor laser elements 200, and the light amount of the laser light propagated along the core of optical fiber 550. The normalized coupling efficiency is the coupling efficiency obtained by indicating, as 1, the coupling efficiency when each optical element in each optical system is disposed at the optimal position.

The coupling efficiency is calculated using conditions A1 to A3 in (a) in FIG. 12, conditions A4 to A6 in (b) in FIG. 12, and conditions A7 to A9 in (c) in FIG. 12.

The horizontal axis in FIG. 12 illustrates the changes, in the z-axis direction, of the positions of the six fast axis collimator lenses 1101 of the six optical units. Note that here, the same positional changes occurred for all of the six fast axis collimator lenses 1101.

A case in which the position in the z-axis direction, which is the horizontal axis in FIG. 12, is 0 will be described. In FIG. 12, the position, under each of the plurality of conditions, of each of the six fast axis collimator lenses 1101 in the z-axis direction when light source module 10x indicates the highest coupling efficiency is 0, and the coupling efficiency at this time has been normalized as 1. Note that in other words, the time when the position in the z-axis direction is 0 is the time when principal point P1 of each of the six fast axis collimator lenses 1101 is the optimal position for principal point P1. In FIG. 12, the change in the coupling efficiency from the case of the position in the z-axis direction being 0 to the time when all of the six fast axis collimator lenses 1101 of the six optical units have moved in the positive direction of the z-axis or the negative direction of the z-axis is illustrated.

As illustrated in (a) in FIG. 12, under conditions A1 to A3, when the position of each of the six fast axis collimator lenses 1101 moves a mere 0.5 μm in the positive or negative direction of the z-axis, the coupling efficiency begins to decrease to about 0.85 to about 0.99, and even when moving only 1 μm, the coupling efficiency decreases to between about 0.2 and about 0.85.

Furthermore, as illustrated in (b) in FIG. 12, under conditions A4 to A6, even when the position of each of the six fast axis collimator lenses 1101 moves a mere 1.5 μm in the positive or negative direction of the z-axis, the coupling efficiency decreases to between about 0 and about 0.8.

Furthermore, as illustrated in (c) in FIG. 12, under conditions A7 to A9, even when the position of each of the six fast axis collimator lenses 1101 moves a mere 2 μm in the positive or negative direction of the z-axis, the coupling efficiency decreases to between about 0 and about 0.86.

In other words, even in a case in which the position of each of the six fast axis collimator lenses 1101 moves on the order of sub-μm or μm in the positive or negative direction of the z-axis, the coupling efficiency dramatically decreases under all of conditions A1 to A9.

Further, in Comparative Example 1, fast axis collimator lens 1101 is bonded to first submount 230 by using a bonding material, and the thickness of this bonding material is great. Thus, positional displacement of fast axis collimator lens 1101 occurs due to shrinkage when the bonding material hardens. This positional displacement may be on the order of several sub-μm to several μm. Due to this positional displacement of several sub-μm to several μm, as illustrated in FIG. 12, the coupling efficiency of light source module 10x according to Comparative Example 1 decreases.

Further, light source module 10 according to the present embodiment will be described.

FIG. 14 is a diagram illustrating the relationship between reflecting mirrors 701 to 703 on which laser lights L1 to L3 of the present embodiment are incident, and beam spots LO1 to LO3. Here, in order to distinguish between the plurality of reflecting mirrors 700, these may be described as reflecting mirror 701 on which laser light L1 is incident, reflecting mirror 702 on which laser light L2 is incident, and reflecting mirror 703 on which laser light L3 is incident. Furthermore, FIG. 14 is a diagram of reflecting mirrors 701 to 703 as viewed from the positive direction of the x-axis. Beam spots LO1 to LO3 indicate the beam shapes of laser lights L1 to L3 on the reflecting face of reflecting mirrors 701 to 703.

As illustrated in FIG. 14, the width of laser light L1, that is, the width of beam spot LO1, is W1. The width of laser light L2, that is, the width of beam spot LO2, is W2. The width of laser light L3, that is, the width of beam spot LO3, is W3. Furthermore, when viewed from the positive direction of the x-axis, the width between beam spot LO1 and beam spot LO2 in the fast axis direction is width D1, and the width between beam spot LO2 and beam spot LO3 in the fast axis direction is width D2. Note that width D2, which is the width between beam spot LO2 and beam spot LO3 in the fast axis direction, is the same as the width between beam spot LO2 and beam spot LO3 illustrated in FIG. 6A.

Furthermore, reflecting mirror 701 has upper face 701a, and reflecting mirror 702 has upper face 702a. The distance from beam spot LO1 to upper face 701a is distance MU1, and the distance from beam spot LO2 to upper face 701a is distance ML1. The distance from beam spot LO2 to upper face 702a is distance MU2, and the distance from beam spot LO3 to upper face 702a is distance ML2. Width D1 is the sum of distance MU1 and distance ML1, and width D2 is the sum of distance MU2 and distance ML2.

Here, the widths between two beam spots, such as width D1 and width D2, are values that are about the same as the width of one beam spot, such as width W1, width W2, and width W3.

Width W2 according to the present embodiment is proportional to F, which is the effective focal length of optical unit 2. Note that in a case in which optical unit 2 according to the present embodiment does not have first lens 120, width W2 is proportional to F1, which is the effective focal length of FACL 110. Thus, compared to the case in which optical unit 2 according to the present embodiment does not have first lens 120, width W2 according to the present embodiment increases at the proportion of F/F1.

Consequently, when F/F1 becomes too great, the upper end of laser light L2 (the end on the positive side of the z-axis) becomes positioned further on the positive side of the z-axis than upper face 702a of reflecting mirror 702 is, whereby problems such as the upper end of laser light L2 not being reflected by reflecting mirror 702 may occur.

Furthermore, when F/F1 becomes too great, the lower end of laser light L2 (the end on the negative side of the z-axis) becomes positioned further on the negative side of the z-axis than upper end 701a of reflecting mirror 701 is, whereby problems such as the lower end of laser light L2 reflected by reflecting mirror 702 being shielded by reflecting mirror 701 may occur. In this way, when F/F1 becomes too great, the coupling efficiency may decrease in light source module 10.

As described above, when the width between two laser lights (e.g., width D1 and width D2) is about the same as the width of one laser light (e.g., width W1, width W2, and width W3), the coupling efficiency is resistant to decreasing in the ideal optical system, even if F/F1 increases to about 2.

However, in an actual optical system, the positions of the beam spots are displaced in the fast axis direction due to slight displacements of the optical axes of the laser lights, and dimensional displacement of reflecting mirrors 700 occurs. Thus, the distance between the beam spots and the reflecting mirrors may slightly change as well. Therefore, when F/F1 becomes greater than 1, the width of one laser light (e.g., width W1, width W2, and width W3) becomes greater, and problems similar to the above-described problems in the case of F/F1 becoming too great are more likely to occur.

Accordingly, in the present embodiment, F/F1 is less than 1.5. This results in the occurrence of the above-described problems being inhibited. Furthermore, as in the descriptions of FIGs. 9 to 11, in order to make δ smaller, F is brought closer to F1 by making F2 sufficiently greater, and for example, F/F1 may be greater than 1.

Accordingly, in the present embodiment, F and F1 satisfy 1 < F/F1 < 1.5.

Here, a and $\beta$ according to the present embodiment will be described. $\alpha$ satisfies Formula 1, and $\beta$ satisfies Formula 2.

$$\alpha = F2/F1 \qquad \text{(Formula 1)}$$

$$\beta = d/F2 \qquad \text{(Formula 2)}$$

Thus, according to Formula 17, Formula 1, and Formula 2, described above, F, F1, $\alpha$, and $\beta$ satisfy Formula 19.
[Math. 1]

$$\frac{F}{F1} = \frac{1}{\left(1 + \frac{1}{\alpha}\right) - \beta} \qquad \text{(Formula 19)}$$

Here, F2, which is the effective focal distance of first lens 120, is F2 > 0 and greater than F1, which is the effective focal distance of FACL 110, and a satisfies Formula 3.

$$\alpha > 1 \qquad \text{(Formula 3)}$$

Furthermore, since F and F1 satisfy 1 < F/F1 < 1.5, according to Formula 19, $\alpha$ and $\beta$ satisfy Formula 4 and Formula 5.

$$\alpha\beta > 1 \qquad \text{(Formula 4)}$$

$$\beta < (1/\alpha) + (1/3) \qquad \text{(Formula 5)}$$

Since d, which is the distance between principal point P1 of FACL 110 and principal point P2 of first lens 120, is shorter than F2, which is the effective focal length of first lens 120, $\beta$ satisfies Formula 6.

$$\beta < 1 \qquad \text{(Formula 6)}$$

FIG. 15 is a diagram illustrating the ranges of $\alpha$ and $\beta$ according to the present embodiment.

In FIG. 15, hatching has been applied to the ranges of $\alpha$ and $\beta$ that satisfy above-described Formula 3, Formula 4, Formula 5, and Formula 6.

Note that F2 of first lens 120 may be greater than F1 of FACL 110. This is because when the value of F2 is close to the value of F1, the adjustment range of first lens 120 becomes about the same as FACL 110. Thus, Formula 11 may be satisfied.

$$\alpha \geq 9.3 \qquad \text{(Formula 11)}$$

Furthermore, when $\alpha$ is too large, effective focal length F2 of first lens 120 becomes longer, that is, the power becomes too low. Since, as a result, the adjustment function of the tilting of the optical axis becomes too low, $\alpha$ may satisfy Formula 13.

$$\alpha \leq 633 \qquad \text{(Formula 13)}$$

Further, $\alpha$ may satisfy Formula 20.

$$\alpha \leq 250 \qquad \text{(Formula 20)}$$

Furthermore, when a is large and $\beta$ is large, the optical distance from FACL 110 to first lens 120 becomes longer. As a result, the distance from light emission point 201 to reflecting mirror 700 becomes longer, whereby light source module 10 becomes large.

Thus, $\alpha$ may satisfy $9.3 \leq \alpha \leq 633$, and $\beta$ may satisfy Formula 15.

$$0 < \beta \leq 0.33 \qquad \text{(Formula 15)}$$

Furthermore, $\alpha$ may satisfy $9.3 \leq \alpha \leq 250$, and $\beta$ may satisfy Formula 21.

$$0.02 \leq \beta \leq 0.33 \qquad \text{(Formula 21)}$$

FIG. 16 is a diagram illustrating the relationship between $\beta$ and F/F1 according to the present embodiment. In FIG. 16, the relationship between $\beta$ and F/F1 is illustrated when each is under a plurality of conditions of $\alpha$ being 5, 10, 50, 100, 600, and 1,000. As described above, F/F1 may be smaller than 1.5. At this time, when $\alpha$ is small, such as $\alpha = 5$, $\beta$ is selected from the range of, for example, $0.2 \leq \beta \leq 0.33$. When a is, e.g., a = 10, $\beta$ is selected from the range of, for example, $0.1 \leq \beta \leq 0.33$. Furthermore, when a is large, such as $\alpha = 50$ to 1,000, $\beta$ is selected from the range of, for example, $0 < \beta \leq 0.33$.

Next, with regard to light source module 10 according to the present embodiment, the result of calculating, by simulation, the change in the coupling efficiency with respect to changes in the positions of FACL 110 and first lens 120 will be described.

FIG. 17 is a diagram illustrating a table that describes a plurality of optical system conditions (conditions B1 to B15) for calculating changes in the coupling efficiency in light source module 10 according to the present embodiment. Furthermore, FIG. 18 is a diagram illustrating a table indicating $\alpha$, $\beta$, and F/F1 under the plurality of conditions illustrated in FIG. 17.

In the present simulation, the six laser lights L1 to L6 are emitted from the six optical units 1 to 6 of light source module 10, and spatially combined by reflecting mirrors 700. Then, the coupling efficiency when spatially combined laser lights L1 to L6 are coupled with optical fiber 550 by condenser lens 800 is calculated by simulation. At this time, the optical parameters of FACL 110 and first lens 120 were changed and compared. Furthermore, the optical parameters of SACL 170 and condenser lens 800 were changed in line with the values of the optical parameters of FACL 110 and first lens 120. The peak wavelengths of semiconductor laser element 200 were all set to 450 nm. Note that when using a semiconductor laser element having a different peak wavelength, the lens material, lens function, antireflective film on the surface, and reflection design of each lens are optimized, but similar effects can be obtained. The divergence angle of semiconductor laser element 200 is, with a total width of $1/(e^2)$, 48° in the fast axis direction and 12° in the slow axis direction. Note that similar to the peak wavelength, when a semiconductor laser element having a different divergence angle is used, similar effects can be obtained by optimizing the optical system. Moreover, in the present embodiment, FACL 110 is a plano-convex lens having an incident face that is planar and an exit face that is a curved face represented by an aspheric function. First lens 120 is a plano-convex lens having an incident face that is planar and an exit face that is a curved face represented by a spheric function. Condenser lens 800 is a plano-convex lens having an incident face that is a curved face represented by an aspheric function and an exit face that is planar. Optical fiber 550 is a step index-type multimode fiber having a core and cladding, and has numerical aperture NA of 0.22.

In this simulation, combinations of the light-emitting region width of semiconductor laser element 200 and the core diameter of optical fiber 550 were also changed, and the changes in the coupling efficiency were confirmed. These optical parameters are consolidated in FIG. 17.

First, as illustrated in FIG. 17, under condition B1: the light-emitting region width of semiconductor laser element 200 is 50 $\mu$m; F1, which is the effective focal length of FACL 110, is 0.15 mm; F2, which is the effective focal length of first lens 120, is 38 mm; lens distance d is 4.6 mm; the effective focal length of SACL 170 is 6.4 mm; the effective focal length of condenser lens 800 is 4.5 mm; and the core diameter of optical fiber 550 is 50 $\mu$m.

Condition B2 is the same as condition B1, except that the core diameter of optical fiber 550 is 70 $\mu$m. Condition B3 is the same as condition B1, except that the light-emitting region width is 100 $\mu$m and the core diameter of optical fiber 550 is 100 $\mu$m.

Condition B4 is the same as condition B1, except that F1, which is the effective focal length of FACL 110, is 0.38 mm, lens distance d is 6.3 mm, the effective focal length of SACL 170 is 13.5 mm, and the effective focal length of condenser lens 800 is 7.3 mm.

Condition B5 is the same as condition B4, except that the core diameter of optical fiber 550 is 70 $\mu$m. Condition B6 is the same as condition B4, except that the light-emitting region width is 100 $\mu$m and the core diameter of optical fiber 550 is 100 $\mu$m.

Condition B7 is the same as condition B1, except that F1, which is the effective focal length of FACL 110, is 0.65 mm, lens distance d is 4.7 mm, the effective focal length of SACL 170 is 15.3 mm, and the effective focal length of condenser lens 800 is 11.6 mm.

Condition B8 is the same as condition B7, except that the core diameter of optical fiber 550 is 70 $\mu$m. Condition B9

is the same as condition B7, except that the light-emitting region width is 100 $\mu$m and the core diameter of optical fiber 550 is 100 $\mu$m.

Condition B10 is the same as condition B7, except that F2, which is the effective focal length of first lens 120, is 6.5 mm, and lens distance d is 2.0 mm.

Condition B11 is the same as condition B1, except lens distance d is 11.5 mm, the effective focal length of SACL 170 is 9.7 mm, and the effective focal length of condenser lens 800 is 4.5 mm.

Condition B12 is the same as condition B4, except that F2, which is the effective focal length of first lens 120, is 95 mm, and lens distance d is 1.5 mm.

Condition B13 is the same as condition B12, except that lens distance d is 31 mm.

Condition B14 is the same as condition B1, except that F2, which is the effective focal length of first lens 120, is 95 mm, and lens distance d is 2.0 mm.

Condition B15 is the same as condition B14, except that lens distance d is 31 mm.

Furthermore, as illustrated in FIG. 18, a, $\beta$, and F/F1 satisfy Formula 3, Formula 4, Formula 5, and Formula 6 under all of the plurality of conditions (conditions B1 to B15). Furthermore, the values of a and $\beta$ corresponding to the plurality of conditions (conditions B1 to B15) are illustrated in FIG. 15.

FIG. 19 to FIG. 23G are diagrams illustrating the results of calculating the coupling efficiency under some of the conditions of the plurality of conditions illustrated in FIG. 17.

Note that FIG. 19 illustrates the result of calculating the coupling efficiency under conditions B1, B4, and B7, FIG. 20 illustrates the result of calculating the coupling efficiency under condition B1, FIG. 21 illustrates the result of calculating the coupling efficiency under condition B4, FIG. 22 illustrates the result of calculating the coupling efficiency under condition B7, FIG. 23A illustrates the result of calculating the coupling efficiency under conditions B4, B5, and B6, FIG. 23B illustrates the result of calculating the coupling efficiency under condition B10, FIG. 23C illustrates the result of calculating the coupling efficiency under condition B11, FIG. 23D illustrates the result of calculating the coupling efficiency under condition B12, FIG. 23E illustrates the result of calculating the coupling efficiency under condition B13, FIG. 23F illustrates the result of calculating the coupling efficiency under condition B14, and FIG. 23G illustrates the result of calculating the coupling efficiency under condition B15.

The horizontal axis in FIG. 19 illustrates the changes in the z-axis direction of the positions of the six FACLs 110 of the six optical units 1 to 6. Note that here, the same positional changes occurred in all of the six FACLs 110.

A case in which the position in the z-axis direction, which is the horizontal axis in FIG. 19, is 0 will be described. In FIG. 19, the position, under each of B1, B4, and B7, of each of the six FACLs 110 in the z-axis direction when light source module 10 indicates the highest coupling efficiency is 0, and the coupling efficiency at this time has been normalized as 1. Note that in other words, the time when the position in the z-axis direction is 0 is the time when principal point P1 of each of the six FACLs 110 is the optimal position for principal point P1.

In FIG. 19, the change in the coupling efficiency from the case in which the position in the z-axis direction is 0 to the time when all of the six FACLs 110 have moved in the positive direction of the z-axis or the negative direction of the z-axis is illustrated. Note that in FIG. 19, for each of the six first lenses 120 of the six optical units 1 to 6, the position illustrated in (a) in FIG. 7, that is, the position of generatrix 125 of each of the six first lenses 120 in the z-axis direction, is the same as the position of imaginary line IL in the z-axis direction.

As illustrated in FIG. 19, under condition B1, even when the position of each of the six FACLs 110 moves a mere 1 $\mu$m in the positive or negative direction of the z-axis, the coupling efficiency decreases to about 0.4. Furthermore, under conditions B4 and B7, even when the position of each of the six FACLs 110 moves a mere 1.5 $\mu$m in the positive or negative direction of the z-axis, the coupling efficiency decreases to about 0.5. In other words, even when the position of each of the six FACLs 110 is displaced on the order of $\mu$m in the z-axis direction, the coupling efficiency decreases.

Further, conditions B1, B4, B5, B6, B7, and B10 to B15 indicated in FIG. 17 will be described.

The coupling efficiency in light source module 10 when, under condition B1, principal point P1 of each of the six FACLs 110 has been positionally displaced from the above-described optimal position in the z-axis direction is shown in FIG. 20. Similarly, FIG. 21, FIG. 22, FIG. 23A, FIG. 23B, FIG. 23C, FIG. 23D, FIG. 23E, FIG. 23F, and FIG. 23G show the coupling efficiency in light source module 10 when principal point P1 of each of the six FACLs 110 has been positionally displaced from the above-described optimal position in the z-axis direction, under: condition B4; condition B7; conditions B4, B5, and B6; condition B10; condition B11; condition B12; condition B13; condition B14; and condition B15, respectively.

Note that in FIG. 20, the coupling efficiency when the positional displacement in the z-axis direction is each of +1.5 $\mu$m, $\pm$0 $\mu$m, -0.5 $\mu$m, -1.0 $\mu$m, and -1.5 $\mu$m is illustrated.

Furthermore, in FIG. 21, the coupling efficiency when the positional displacement in the z-axis direction is each of +2.0 $\mu$m, $\pm$0 $\mu$m, -1.0 $\mu$m, -1.5 $\mu$m, and -2.0 $\mu$m is illustrated.

Furthermore, in FIG. 22, the coupling efficiency when the positional displacement in the z-axis direction is each of +1.5 $\mu$m, $\pm$0 $\mu$m, and -2.0 $\mu$m is illustrated.

Moreover, in FIG. 23A, the coupling efficiency when the positional displacement in the z-axis direction under condition B4 is -2.0 $\mu$m, the coupling efficiency when the positional displacement in the z-axis direction under condition B5 is -3.0 $\mu$m, and the coupling efficiency when the positional displacement in the z-axis direction under condition B6 is each of -4.0 $\mu$m and -2.0 $\mu$m are illustrated.

Furthermore, in FIG. 23B, the coupling efficiency when the positional displacement in the z-axis direction is -2.0 $\mu$m is illustrated.

Furthermore, in FIG. 23C, the coupling efficiency when the positional displacement in the z-axis direction is -2.0 $\mu$m is illustrated.

Furthermore, in FIG. 23D, the coupling efficiency when the positional displacement in the z-axis direction is -2.0 $\mu$m is illustrated.

Furthermore, in FIG. 23E, the coupling efficiency when the positional displacement in the z-axis direction is -1.5 $\mu$m is illustrated.

Furthermore, in FIG. 23F, the coupling efficiency when the positional displacement in the z-axis direction is -2.0 $\mu$m is illustrated.

Furthermore, in FIG. 23G, the coupling efficiency when the positional displacement in the z-axis direction is -0.5 $\mu$m is illustrated.

Furthermore, the horizontal axis in FIG. 20 illustrates the adjustment amount of each of the six first lenses 120 in the z-axis direction. The case in which the horizontal axis in FIG. 20 is 0 means a case in which the position of generatrix 125 of each of the six first lenses 120 in the z-axis direction is the same as the position of imaginary line IL in the z-axis direction.

In other words, the horizontal axis in FIG. 20 illustrates the position of generatrix 125 of each of the six first lenses 120 in the z-axis direction, with respect to imaginary line IL. Note that in FIG. 20, the coupling efficiency under a condition of the six FACLs 110 and first lenses 120 being in the optimal positions is normalized as 1. The same applies to FIG. 21 to FIG. 23G.

In each of the plurality of positional displacement conditions illustrated in FIG. 20 as well, it is clear that the coupling efficiency is increased by the position of each of the six first lenses 120 being adjusted in the z-axis direction. Thus, as illustrated in FIG. 19, even if the coupling efficiency decreases due to the position of each of the six FACLs 110 being displaced in the z-axis direction, the coupling efficiency in light source module 10 can be increased by adjusting the positions of the six first lenses 120. Even in a case in which the position of each of the six FACLs 110 is displaced in either the positive direction or the negative direction of the z-axis at this time, the coupling efficiency in light source module 10 can be increased by adjusting the positions of the six first lenses 120. Furthermore, in a case in which the position of each of the six FACLs 110 was not displaced in the z-axis direction, when the positions of the generatrices of the six first lenses 120 are disposed near a position that overlaps imaginary line IL, high optical efficiency can be maintained even without adjusting the positions of the six FACLs 110. In other words, when fixing the six FACLs 110 after performing active alignment, the optical efficiency can be increased by using first lenses 120, even if the optical efficiency had decreased due to the respective positions of the six FACLs 110 changing on the order of sub-$\mu$m or $\mu$m.

Further, as illustrated in FIG. 20, the adjustment amount of the position of each of the six first lenses 120 in the z-axis direction is on the order of several hundreds of $\mu$m, and for example, using optical unit 1 facilitates the adjustment of optical axis LA1. Furthermore, the position of first lens 120 adjusted in accordance with the position of FACL 110 such that the optical efficiency is maximal has a coupling efficiency with a decrease amount within 5%, even when being displaced by about $\pm 50$ $\mu$m from the optimal position. In other words, when fixing position-adjusted first lens 120 by using first bonding material 161 that includes an inorganic material such as SnAgCu solder, similarly to FACL 110, a decrease in the optical efficiency can be inhibited even if displacement occurs on the order of several $\mu$m. That is, the permissible range of the displacement amount when the position of first lens 120 is displaced is sufficiently large with respect to Comparative Examples 1 and 2. More specifically, the permissible range of the displacement amount when the position of first lens 120 is displaced is sufficiently large with respect to the permissible range of the displacement amount when the position of fast axis collimator lens 1101 is displaced in Comparative Example 1 and the permissible range of the displacement amount when the position of first lens 120xx is displaced in Comparative Example 2. In this way, in the present embodiment, increasing the coupling efficiency does not necessitate adjustment and fixing of a precise position on the order of, for example, sub-$\mu$m. As described above, light source module 10 having high coupling efficiency can be easily realized.

A similar effect can also be obtained in FIG. 21 to FIG. 23G. For example, under condition B4 in FIG. 21, the position of first lens 120 adjusted in accordance with the position of FACL 110 such that the optical efficiency is maximal has a coupling efficiency with a decrease amount within 5%, even when being displaced by about $\pm 75$ $\mu$m from the optimal position. For example, under condition B7 in FIG. 22, the position of first lens 120 adjusted in accordance with the position of FACL 110 such that the optical efficiency is maximal has a coupling efficiency with a decrease amount within 5%, even when being displaced by about $\pm 75$ $\mu$m from the optimal position.

Furthermore, conditions B4, B5, and B6 in FIG. 23A are examples in which the combination of the light-emitting region width of semiconductor laser element 200 and the core diameter of optical fiber 550 has been changed, but a similar effect is obtained.

Furthermore, in FIG. 23B to FIG. 23G, a similar effect is obtained under conditions B10 to B15 as well. Thus, under the conditions within the ranges of Formula 4, Formula 5, and Formula 6 illustrated in FIG. 15, light source module 10 having high coupling efficiency can be easily realized.

Note that under conditions B11 to B15 in FIG. 23C to FIG. 23G, the position of first lens 120 adjusted in accordance with the position of FACL 110 such that the optical efficiency is maximal has a coupling efficiency with a decrease amount within 5%, even when being displaced by about $\pm$ tens of $\mu$m to $\pm$ hundreds of $\mu$m from the optimal position.

In contrast, under condition B10 in FIG. 23B, the range of the positions of first lens 120 in which the amount of decrease in the coupling efficiency from the maximal value is within 5% is about $\pm 10\ \mu$m. In other words, the permissible range for the position of first lens 120 to be displaced is tens of $\mu$m. These values are sufficient for adjusting the position of first lens 120, but are relatively small compared to the other conditions. This is because a becomes smaller and the adjustment range of first lens 120 becomes closer to FACL 110. Thus, $\alpha$ may satisfy Formula 11.

$$\alpha \geq 9.3 \qquad \text{(Formula 11)}$$

Furthermore, under condition B13 and condition B15, $\beta$ is 0.33, which is relatively large, and first lens 120 is disposed at a position separated from FACL 110. Under these conditions, SACL 170 is disposed between FACL 110 and first lens 120. Under these conditions as well, as illustrated in FIG. 23E and FIG. 23G, the coupling efficiency can be improved by adjusting the position of first lens 120 with respect to the positional displacement of FACL 110. That is, a decrease in the coupling efficiency can be inhibited. However, since first lens 120 is disposed at a position separated from FACL 110, laser lights L1 to L6 partially fail to be incident on the reflecting mirrors, whereby the effect of inhibiting the decrease in the coupling efficiency is lower compared to the other conditions. Thus, $\beta$ may be smaller than this, and specifically may be 0.33 or lower.

Furthermore, under condition B14 and condition B15, $\alpha$ is 633, which is relatively large. Under these conditions as well, as illustrated in FIG. 23F and FIG. 23G, the coupling efficiency can be improved by adjusting the position of first lens 120 with respect to the positional displacement of FACL 110. That is, a decrease in the coupling efficiency can be inhibited. However, effective focal length F2 of first lens 120 becomes longer, that is, the power becomes lower, and the adjustment range is on the order of millimeters. Since this adjustment range is about the same as the size of the optical elements such as, for example, first lens 120, $\alpha$ may be smaller than this.

In other words, according to condition B14 and condition B15, $\alpha$ may satisfy Formula 13.

$$\alpha \leq 633 \qquad \text{(Formula 13)}$$

Furthermore, according to condition B15, $\alpha$ may satisfy Formula 15.

$$0 < \beta \leq 0.33 \qquad \text{(Formula 15)}$$

Furthermore, under condition B12 and condition B14, $\beta$ is 0.02, which is relatively large, and first lens 120 is disposed at a position near FACL 110. Under these conditions as well, as illustrated in FIG. 23D and FIG. 23F, the coupling efficiency can be improved by adjusting the position of first lens 120 with respect to the positional displacement of FACL 110. That is, a decrease in the coupling efficiency can be inhibited. Thus, $\beta$ may be larger than this, and specifically may be 0.02 or greater.

In other words, according to condition B14, $\beta$ may satisfy Formula 21.

$$0.02 \leq \beta \leq 0.33 \qquad \text{(Formula 21)}$$

Furthermore, under condition B12 and condition B13, a is 250. Under these conditions as well, as illustrated in FIG. 23D and FIG. 23E, the coupling efficiency can be improved by adjusting the position of first lens 120 with respect to the positional displacement of FACL 110. Moreover, comparing condition B13 ($\alpha$ = 250) and condition B15 (a = 633), the maximal value of the coupling efficiency is larger under condition B13.

In other words, according to condition B12 and condition B13, a may satisfy Formula 20.

$$\alpha \leq 250 \qquad \text{(Formula 20)}$$

Thus, a may satisfy $9.3 \leq a \leq 633$, and $\beta$ may satisfy Formula 15.

Furthermore, a may satisfy $9.3 \leq a \leq 250$, and $\beta$ may satisfy Formula 21.

Further, condition B11 is indicated as an example in which a satisfies $9.3 \leq \alpha \leq 250$, and $\beta$ satisfies Formula 21. Under condition B11, a is 100, and $\beta$ is 0.04. Under these conditions as well, as illustrated in FIG. 23C, the coupling efficiency can be improved to almost 1 by adjusting the position of first lens 120 with respect to the positional displacement of FACL 110. Moreover, the position of first lens 120 adjusted in accordance with the position of FACL 110 such that the optical efficiency is maximal has a coupling efficiency with a decrease amount within 5%, even when deviating by about $\pm$ tens of $\mu$m from the optimal position. This permissible range for the displacement is sufficiently large compared to the permissible range of the displacement amount when the position of fast axis collimator lens 1101 in the comparative example illustrated in FIG. 12 has been displaced.

In the above description, F1, which is the effective focal length of FACL 110 under condition B1 to condition B15, is 0.15 mm or greater and 0.65 mm or less, and is more effective for F1 in this range.

Further, in the above-described embodiment, an inorganic joining material may be used as the joining material that fixes FACL 110. The laser light emitted from light emission point 201 is partially emitted onto the joining material disposed near light emission point 201. Thus, using an inorganic joining material as the joining material makes it possible to inhibit the laser light deteriorating the joining material. Similarly, using an inorganic joining material as first bonding material 161 and second bonding material 162 makes it possible to inhibit the laser light deteriorating the joining material.

Note that in the above-described embodiment, each of first bonding material 161 and second bonding material 162 was an inorganic joining material, but this is not intended to be limiting. Each of first bonding material 161 and second bonding material 162 may include, for example, a joining material such as an ultraviolet curable adhesive containing an ultraviolet curable resin. Alternatively, each of first bonding material 161 and second bonding material 162 may include an inorganic-containing joining material such as an adhesive obtained by kneading an inorganic filler made of an inorganic material such as alumina into an ultraviolet curable resin.

Note that in the above embodiment, a concave-reflective cylindrical lens may be used as FACL 110. Furthermore, a concave-reflective cylindrical lens may be used as first lens 120. Moreover, SACL 170 may be a concave-reflective cylindrical lens. Furthermore, SACL 170 and reflecting mirror 700 may be an integral optical component that is a concave-reflective cylindrical lens.

Hereinafter, Variations 1 to 3 of Embodiment 1 will be described. Below, description will center on the points of difference from Embodiment 1, and the description of common points will be omitted or simplified.

[Variation 1 of Embodiment 1]

FIG. 24 is a side view illustrating the configuration of optical unit 1a according to Variation 1 of Embodiment 1.

Light source module 10a according to the present variation has the same configuration as light source module 10 according to Embodiment 1, except that instead of optical units 1 to 6, light source module 10a according to the present variation includes optical unit 1a and five optical units each having the same configuration as optical unit 1a. In other words, light source module 10a according to the present variation includes six optical units.

Optical unit 1a according to the present variation has the same configuration as optical unit 1 according to Embodiment 1, except that instead of first lens 120, first fast axis adjustment lens 120a (hereinafter, first lens 120a) is included.

First lens 120a is a lens on which laser light L1 that has exited from FACL 110 is incident, and that adjusts optical axis LA1 of laser light L1 in the fast axis direction.

First lens 120a is an optical component having power in the fast axis direction that is higher than the power in the slow axis direction. First lens 120a according to the present variation is a cylindrical lens having a power axis and a non-power axis. Furthermore, the power axis and the non-power axis are disposed perpendicular to each other. First lens 120a has a concave columnar face such as a concave curved cylindrical face along the power axis. First lens 120a is a concave cylindrical lens. In other words, first lens 120a is a concave lens.

Furthermore, first lens 120a is a concave cylindrical lens having an incident face on which laser light L1 is incident and an exit face through which laser light L1 exits. Furthermore, the absolute value of the power of first lens 120a is sufficiently low compared to the absolute value of the power of FACL 110. In the present variation, first lens 120a is a plano-concave lens having an incident face that is planar and an exit face that is a concave face. Furthermore, the incident face is a face parallel to the zx-plane. The exit face is a curved face represented by a spheric function having a large radius of curvature. This first lens 120a collimates incident light that is incident while slightly converging along the fast axis.

First lens 120a is a member that includes an inorganic transparent material such as glass, and an antireflective coating film matched to the wavelength of laser light L1 is formed on the incident face on which laser light L1 is incident and the exit face from which laser light L1 exits.

First lens 120a has generatrix 125a.

Generatrix 125a is a straight line that follows, of the concave cylindrical surface that is the exit face from which laser light L1 exits, the valley floor portion. The thickness of first lens 120a is low in generatrix 125a. All generatrices including generatrix 125a of first lens 120a according to the present variation are parallel to the xy-plane.

As described above, optical unit 1a has FACL 110 and first lens 120a.

Furthermore, as in Embodiment 1, the principal point of FACL 110 is principal point P1, and the principal point of first lens 120a is principal point P2. Furthermore, in optical unit 1a, principal point P0, which is the principal point of the composite lens of FACL 110 and first lens 120a, is present.

In the present variation, principal point P0 is further on the light emission point 201 side than principal point P1 is. The effective focal length of the composite lens is F and the distance between principal point P0 and principal point P1 is $\delta$. Light emission point 201 is disposed at a position that is effective focal length F away from principal point P0.

F1 denotes the effective focal length of FACL 110, and F2 denotes the effective focal length of first lens 120a. Note that since first lens 120a is a plano-concave cylindrical lens, F2 < 0. Furthermore, the distance between principal point P1 of FACL 110 and principal point P2 of first lens 120a is lens distance d.

In the present variation as well, effective focal length F of the composite lens, effective focal length F1 of FACL 110, effective focal length F2 of first lens 120a, lens distance d, and $\delta$, which is the distance between principal point P0 and principal point P1, satisfy Formula 17 and Formula 18.

$$1/F = (1/F1) + (1/F2) - (d/(F1 \times F2)) \qquad \text{(Formula 17)}$$

$$\delta = (F \times d)/F2 \qquad \text{(Formula 18)}$$

However, since in the present variation, F2 < 0, $\delta$ is a negative value, and principal point P0 is located further on the positive side of the y-axis than principal point P1 is.

Laser light L1 emitted from light emission point 201 is incident on FACL 110 and exits as pseudo-collimated light. In the present variation, FACL 110 outputs laser light L1 that is incident on FACL 110 after converting it into laser light L1 that is nearly collimated light and converges slightly along the fast axis. Laser light L1 that exits from FACL 110 is collimated in the fast axis direction at first lens 120a and exits from first lens 120a. At this time, the beam width, in the fast axis direction, of laser light L1 that exits from first lens 120a is defined as width W1a. Since, in the present variation, $\delta$ is a negative value, effective focal length F is smaller than effective focal length F1, and width W1a can be easily reduced. On the other hand, when width W1a is too low, the optical density may increase and alter the surface of reflecting mirror 700 on which laser light L1 is incident. Accordingly, in the present variation, F/F1 is greater than 0.75. This makes it possible to inhibit width W1a from becoming too low and the above-described problem occurring.

As described above, first lens 120a is a lens on which laser light L1 is incident, and that adjusts optical axis LA1 of laser light L1 in the fast axis direction. Although not illustrated in FIG. 24, first lens 120a is fixed while supported by support member 150. In the manufacturing of optical unit 1a, the position of first lens 120a is moved, that is, adjusted, such that the coupling efficiency between outputted laser light L1 and optical fiber 550 increases. In the manufacturing of optical unit 1a, first, support member 150 is fixed to a predetermined position on platform 510, by second bonding material 162. Subsequently, the position of first lens 120a is moved and fixed by first bonding material 161, such that the coupling efficiency between outputted laser light L1 and optical fiber 550 increases.

Further, the effects of first lens 120a being adjusted are described with reference to FIG. 25 and FIG. 26. Here, the effects of using laser light L1 emitted from optical unit 1a are described, but the same effects are also expected for the other five optical units included in light source module 10a according to the present variation.

FIG. 25 is a side view illustrating an example in which the position of first lens 120a according to the present variation is adjusted in the fast axis direction. FIG. 26 is a side view illustrating another example of the position of first lens 120a according to the present variation being adjusted in the fast axis direction.

FIG. 25 illustrates an example in which the position of first lens 120a is adjusted after FACL 110 is fixed. More specifically, (a) in FIG. 25 is a side view of a state before first lens 120a is adjusted, and (b) in FIG. 25 is a side view of a state after first lens 120a is adjusted. In FIG. 25, imaginary line IL is shown for illustrative purposes. Imaginary line IL is a line parallel to the y-axis, and the position of imaginary line IL in the z-axis direction is the same as the position of light emission point 201 in the z-axis direction.

In FIG. 25, first, first lens 120a is disposed near a position where the position of generatrix 125a in the z-axis direction overlaps imaginary line IL. Furthermore, FACL 110 is also disposed near a position where the position of the generatrix of FACL 110 in the z-axis direction overlaps imaginary line IL. Subsequently, the position of FACL 110 is adjusted by active alignment in order to perform precise positional adjustment. FACL 110 is then fixed to light emission point 201 using a bonding material, but it is assumed that due to the volume change of the bonding material, the position of the generatrix of FACL 110 has been displaced slightly further upward, that is, further in the positive direction of the z-axis, than imaginary line IL. In this case, laser light L1 that has been emitted from light emission point 201 and transmitted through and outputted from FACL 110 propagates tilted above imaginary line IL. In other words, laser light L1 is slightly tilted in the positive direction of the z-axis and travels toward the negative direction of the y-axis. In other words, laser light L1 transmitted through FACL 110 has an angle between its optical axis LA1 and imaginary line IL that is greater than 0°.

Furthermore, if the position of generatrix 125a of first lens 120a in the z-axis direction is the same as the position of the imaginary line IL in the z-axis direction, as illustrated by (a) in FIG. 25, laser light L1 transmitted through first lens 120a is further tilted in the positive direction of the z-axis and travels toward the negative direction of the y-axis. Thus, laser light L1 cannot be incident on reflecting mirror 700 or does not enter optical fiber 550 further downstream. In this state, the coupling efficiency in light source module 10a decreases.

However, as illustrated in (b) in FIG. 25, in the present variation, the position of first lens 120a is adjusted. In (b) in FIG. 25, the position of first lens 120a before being moved is illustrated by a dotted line. In (b) in FIG. 25, the position of the generatrix of first lens 120a before being moved is indicated by 1251a. When, as illustrated in FIG. 25, laser light L1 transmitted through FACL 110 is tilted in the positive direction of the z-axis and travels in the negative direction of the y-axis, the position of first lens 120a is adjusted in the positive direction of the z-axis (this adjusted first lens 120a is illustrated as a solid line in (b) in FIG. 25). In other words, generatrix 125a of first lens 120a is positioned at a predetermined position further on the positive side of the z-axis than imaginary line IL and generatrix 1251a are. As a result, collimated laser light L1 transmitted through first lens 120a travels parallel to imaginary line IL. Thus, laser light L1 can be incident on reflecting mirror 700, and the coupling efficiency in light source module 10a can be increased.

(a) in FIG. 26 is a diagram illustrating a case in which the generatrix of first lens 120a is disposed at imaginary line IL and fixed. In this case, laser light L1 that has been emitted from light emission point 201 and transmitted through FACL 110 has optical axis LA1 that is parallel to imaginary line IL. In this case, it is not necessary to adjust the position of generatrix 125a regarding the position of first lens 120a.

(b) in FIG. 26 is a diagram illustrating a case in which FACL 110 is fixed in a position displaced below imaginary line IL. In this case, pseudo-collimated laser light L1 that has been emitted from light emission point 201 and transmitted through FACL 110 propagates below imaginary line IL, that is, tilted in the negative direction of the z-axis toward the negative direction of the y-axis. In other words, laser light L1 transmitted through FACL 110 has an angle between its optical axis LA1 and imaginary line IL that is greater than 0° in the negative direction of the z-axis.

Furthermore, in (b) in FIG. 26, the position of first lens 120a has been adjusted. In (b) in FIG. 26, the position of first lens 120a before being moved is illustrated by a dotted line. When, as illustrated in (b) in FIG. 26, laser light L1 transmitted through FACL 110 is tilted in the negative direction of the z-axis and travels in the negative direction of the y-axis, the position of first lens 120a is adjusted downward, that is, in the negative direction of the z-axis. In other words, generatrix 125a of first lens 120a is positioned further on the negative side of the z-axis than imaginary line IL and preadjustment generatrix 1251a are. As a result, collimated laser light L1 transmitted through first lens 120a travels parallel to the y-axis direction. Thus, laser light L1 can be incident on reflecting mirror 700, and the coupling efficiency in light source module 10a can be increased.

Here, $\alpha$ and $\beta$ according to the present variation are described. In the present variation as well, similarly to Embodiment 1, $\alpha$ satisfies Formula 1, and $\beta$ satisfies Formula 2.

$$\alpha = F2/F1 \qquad \text{(Formula 1)}$$

$$\beta = d/F2 \qquad \text{(Formula 2)}$$

Thus, according to Formula 17, Formula 1, and Formula 2 described above, F, F1, $\alpha$, and $\beta$ satisfy Formula 19.
[Math. 2]

$$\frac{F}{F1} = \frac{1}{\left(1 + \frac{1}{\alpha}\right) - \beta} \qquad \text{(Formula 19)}$$

Here, the absolute value of F2, which is the effective focal length of first lens 120a, is greater than F1, which is the effective focal length of FACL 110, whereby $\alpha$ satisfies Formula 7.

$$\alpha < -1 \qquad \text{(Formula 7)}$$

Furthermore, in the present variation, F and F1 satisfy $0.75 < F/F1 < 1$. Thus, according to Formula 19, $\alpha$ and $\beta$ satisfy Formula 8 and Formula 9.

$$\alpha\beta < 1 \qquad \text{(Formula 8)}$$

$$\beta > (1/a) - (1/3) \qquad \text{(Formula 9)}$$

Since d, which is the distance between principal point P1 of FACL 110 and principal point P2 of first lens 120a, is shorter than F2, which is the effective focal length of first lens 120a, β satisfies Formula 10.

$$\beta > -1 \qquad \text{(Formula 10)}$$

FIG. 27 is a diagram illustrating the ranges of a and β according to the present variation.

In FIG. 27, the ranges of a and β that satisfy Formula 7, Formula 8, Formula 9, and Formula 10 described above are marked with dots.

The absolute value of effective focal length F2 of first lens 120a may be greater than effective focal length F1 of FACL 110; thus, Formula 12 may be satisfied.

$$a \leq -9.3 \qquad \text{(Formula 12)}$$

Furthermore, when a is too small, that is, when the absolute value of a is too large, effective focal length F2 of first lens 120a becomes longer and the power becomes lower. As a result, the adjustment function of the tilting of optical axis LA1 becomes too low. Thus, a may satisfy Formula 14.

$$a \geq 633 \qquad \text{(Formula 14)}$$

Further, $\alpha$ may satisfy Formula 22.

$$a \geq 250 \qquad \text{(Formula 22)}$$

Furthermore, when the absolute value of $\alpha$ is large and β is large, the optical distance from FACL 110 to first lens 120a becomes longer. As a result, the distance from light emission point 201 to reflecting mirror 700 becomes longer and light source module 10a becomes larger.

Thus, a may satisfy -9.3 $\geq$ a $\geq$ -633, and β may satisfy Formula 16.

$$-0.33 \leq \beta < 0 \qquad \text{(Formula 16)}$$

Furthermore, $\alpha$ may satisfy -9.3 $\geq \alpha \geq$ -250, and β may satisfy Formula 23.

$$-0.3 \leq \beta \leq -0.02 \qquad \text{(Formula 23)}$$

FIG. 28 is a diagram illustrating the relationship between β and F/F1 according to the present variation.

In FIG. 28, the relationship between β and F/F1 under a plurality of conditions where a is -5, -10, -50, -100, -600, and -1000, respectively, is shown. As described above, F/F1 may be greater than 0.75 and less than 1. At this time, when a is large, for example, a = -5, β is selected from the range of, for example, -0.33 $\leq \beta \leq$ -0.2. When a is, for example, a = 10, β is selected from the range of, for example, -0.33 $\leq \beta \leq$ -0.1. Furthermore, when $\alpha$ is small, for example, a = -50 to -1,000, β is selected from the range of, for example, -0.33 $\leq \beta <$ -0.

Next, the result of calculating the change in the coupling efficiency for light source module 10a according to the present variation will be described.

FIG. 29 is a diagram illustrating a table that describes condition C1 for calculating the coupling efficiency in light source module 10a according to the present variation. Furthermore, FIG. 30 is a diagram illustrating a table representing a, β and F/F1 under condition C1, indicated in FIG. 29.

As illustrated in FIG. 29, under condition C1, the peak wavelength of semiconductor laser element 200 was 450 nm, similarly to Embodiment 1. Note that when using a semiconductor laser element having a different peak wavelength, the lens material, lens function, antireflective film on the surface, or reflection design of each lens is optimized, but similar effects can be obtained. Furthermore, the light-emitting region width of semiconductor laser element 200 is 50 μm, F1, which is the effective focal length of FACL 110, is 0.38 mm, F2, which is the effective focal length of first lens 120a, is -38 mm, lens distance d is 5.0 mm, the effective focal length of SACL 170 is 13.5 mm, the effective focal length of condenser lens 800 is 7.3 mm, and the core diameter and numerical aperture NA of optical fiber 550 are 50 μm and 0.22, respectively.

Furthermore, as illustrated in FIG. 30, $\alpha$, β, and F/F1 satisfy Formula 7, Formula 8, Formula 9, and Formula 10 under condition C1. Moreover, the values of $\alpha$ and $\beta$ corresponding to condition C1 are also illustrated in FIG. 27.

FIG. 31 and FIG. 32 are diagrams illustrating the results of calculating the change in the coupling efficiency when the positions of the six FACLs 110 have been displaced from the optimal positions under condition C1. More specifically, FIG. 31 and FIG. 32 illustrate the results of calculating, by simulation, the coupling efficiency when six laser lights emitted from the six optical units included in light source module 10a are spatially combined under condition C1. Note that the coupling efficiency means the coupling efficiency between the six laser lights and optical fiber 550.

The horizontal axis in FIG. 31 illustrates the change in position, in the z-axis direction, of the six FACLs 110 of the six optical units according to the present variation. Note that here, the same positional changes occurred in all of the six FACLs 110.

A case in which the position in the z-axis direction, which is the horizontal axis in FIG. 31, is 0 is described. In FIG. 31, under condition C1, the position of each of the six FACLs 110 in the z-axis direction when light source module 10a exhibits the highest coupling efficiency is set to 0, and the coupling efficiency at this time is normalized to 1. Note that in other words, the time when the position in the z-axis direction is 0 is the time when principal point P1 of each of the six FACLs 110 is the optimal position for principal point P1.

In FIG. 31, the change in the coupling efficiency from the case of the position in the z-axis direction being 0 to the time when all of the six FACLs 110 have moved in the positive direction of the z-axis or the negative direction of the z-axis is illustrated. Note that in FIG. 31, all of the six first lenses 120a of the six optical units according to the present variation are in the position indicated in (a) in FIG. 25, that is, the position of generatrix 125a of each of the six first lenses 120a in the z-axis direction is the same as the position of imaginary line IL in the z-axis direction.

Furthermore, as illustrated in FIG. 31, under condition C1, even when the position of each of the six FACLs 110 moves a mere 1 $\mu$m in the positive or negative direction of the z-axis, the coupling efficiency decreases to about 0.5. In other words, even when the position of each of the six FACLs 110 is displaced on the order of $\mu$m in the z-axis direction, the coupling efficiency decreases.

Further, condition C1 indicated in FIG. 29 will be described.

The coupling efficiency of light source module 10a when principal point P1 of each of the six FACLs 110 has been displaced from the above-described optimal position in the z-axis direction, under condition C1, is shown in FIG. 32.

Note that in FIG. 32, the coupling efficiency when the positional displacement in the z-axis direction is +2.0 $\mu$m, $\pm$0 $\mu$m, -1.0 $\mu$m, -1.5 $\mu$m, and -2.0 $\mu$m is illustrated.

The horizontal axis in FIG. 32 illustrates the adjustment amount of the position of each of the six first lenses 120a in the z-axis direction. The case of the horizontal axis in FIG. 32 being 0 means a case in which the position of generatrix 125a of each of the six first lenses 120a in the z-axis direction is the same as the position of imaginary line IL in the z-axis direction. In other words, the horizontal axis in FIG. 32 illustrates the position of generatrix 125a of each of the six first lenses 120a in the z-axis direction, with respect to imaginary line IL. Note that in FIG. 32, the coupling efficiency when FACL 110 and first lens 120a are at the optimal positions, that is, disposed on imaginary line IL, has been normalized as 1.

In each of the plurality of positional displacement conditions illustrated in FIG. 32 as well, it is clear that the coupling efficiency is increased to almost 1 by the position of each of the six first lenses 120a being adjusted in the z-axis direction. Thus, as illustrated in FIG. 30, even if the positions of the six FACLs 110 are displaced in the positive direction or the negative direction of the z-axis and thus disposed such that the coupling efficiency decreases, the coupling efficiency in light source module 10a can be increased by adjusting the positions of the six first lenses 120a. Furthermore, even if the positions of the six FACLs 110 are displaced in the z-axis direction, the coupling efficiency in light source module 10a can be kept high by fixing first lens 120a at a predetermined position.

Further, as illustrated in FIG. 32, the adjustment amount of the position of each of the six first lenses 120a in the z-axis direction is on the order of several hundreds of $\mu$m, whereby for example, adjustment of optical axis LA1 with optical unit 1a is easy. Furthermore, the position of first lens 120a adjusted in accordance with the position of FACL 110 such that the optical efficiency is maximal has a coupling efficiency with a decrease amount within 5%, even when being displaced by about $\pm$50 $\mu$m from the optimal position. In other words, when fixing position-adjusted first lens 120a using an ultraviolet curable adhesive or the like, similarly to when fixing FACL 110, a decrease in the optical efficiency can be inhibited even if displacement occurs on the order of several $\mu$m. In this way, in the present variation, increasing the coupling efficiency does not necessitate adjustment and fixing of a precise position on the order of, for example, sub-$\mu$m. As described above, light source module 10a having high coupling efficiency can be easily realized.

[Variation 2 of Embodiment 1]

FIG. 33 is a side view illustrating the configuration of optical unit 1b according to Variation 2 of Embodiment 1.

The light source module according to the present variation has the same configuration as light source module 10 according to Embodiment 1, except that instead of optical units 1 to 6, the light source module according to the present variation includes optical unit 1b and five optical units each having the same configuration as optical unit 1b. In other words, the light source module according to the present variation includes six optical units.

Optical unit 1b according to the present variation has the same configuration as optical unit 1 according to Embodiment 1, except that optical unit 1b further includes second submount 250 and joining material 280.

Second submount 250 according to the present variation is a flat plate-shaped placement stand on which first submount 230 having semiconductor laser element 200 disposed thereon and fast axis cylindrical lens 110 (FACL 110) are disposed. Second submount 250 includes a material having high thermal conductivity and a low coefficient of thermal expansion. Second submount 250 includes an insulating material such as a ceramic or a crystal of, e.g., AIN or SiC.

Second submount 250 has second upper face 251, which is a flat plate-shaped upper face. Second upper face 251 according to the present variation is a flat face parallel to the xy-plane. Second submount 250 protrudes from first submount 230 in the direction in which laser light L1 travels. Furthermore, first submount 230 and FACL 110 are disposed above second upper face 251 of the protruding portion of second submount 250.

Joining material 280 is a member that fixes FACL 110. In other words, FACL 110 and second submount 250 are bonded by joining material 280. Joining material 280 may be, for example, an inorganic joining material such as a solder material or a metal sintered body.

In the manufacturing of the light source module according to the present variation, when FACL 110 is disposed above second upper face 251, FACL 110 is fixed while being supported by second upper face 251 parallel to the xy-plane. Thus, adjustment of the position of FACL 110 in the y-axis direction, that is, the focal direction, is easy. Furthermore, joining material 280 is disposed between second upper face 251 and the lower face of FACL 110, and joins these together. In other words, FACL 110 is fixed by joining material 280 disposed on second upper face 251. Therefore, since FACL 110 and second submount 250 are joined face to face, FACL 110 can be firmly fixed to semiconductor laser element 200.

On the other hand, with regard to adjusting and fixing FACL 110 in the z-axis direction, joining material 280 has thickness. Thus, when the position of FACL 110 is adjusted in the z-axis direction and then fixed, the position of FACL 110 may be displaced from the optimal position due to changes in the volume of joining material 280. However, in the present variation, optical unit 1b includes first lens 120 for adjusting optical axis LA1 of laser light L1 in the z-axis direction. In other words, firmly fixing FACL 110 and adjusting optical axis LA1 of laser light L1 is facilitated.

Furthermore, as illustrated in FIG. 33, second submount 250 is disposed above second step 511b of first stage 511 of platform 510. Second submount 250 and second step 511b are bonded by fourth bonding material 290. Fourth bonding material 290 may include, for example, an inorganic joining material such as a solder material or a metal sintered body.

[Variation 3 of Embodiment 1]

FIG. 34 is a cross-sectional view illustrating a method for manufacturing optical unit 1c according to Variation 3 of Embodiment 1. Note that the placement direction and the like are indicated by dashed arrows in FIG. 34.

The light source module according to the present variation has the same configuration as light source module 10 according to Embodiment 1, except that instead of optical units 1 to 6, the light source module according to the present variation includes optical unit 1c and five optical units each having the same configuration as optical unit 1c. In other words, the light source module according to the present variation includes six optical units. Each of the six optical units has the same configuration, and here, optical unit 1c will be described.

Optical unit 1c according to the present variation has the same configuration as optical unit 1 according to Embodiment 1, except that mainly, package 400 is included.

Optical unit 1c includes package 400 that houses and hermetically seals semiconductor laser element 200 and FACL 110. More specifically, package 400 further houses and hermetically seals first submount 230.

Package 400 is a component having translucent window 420, bottom plate 410, side plate 430, and top plate 440.

Translucent window 420 is an optical component through which laser light L1 that exits from FACL 110 is transmitted. Translucent window 420 is, for example, a rectangular inorganic glass plate, and is an optical component that has an antireflective coating formed on, of translucent window 420, an incident face on which laser light L1 is incident and an exit face from which laser light L1 exits.

Bottom plate 410 is a plate-shaped member that includes an inorganic material that has high thermal conductivity. Bottom plate 410 may include a metal such as Cu or a Cu alloy, for example, or a ceramic or polycrystalline body such as AIN, SiC or diamond.

Side plate 430 is a plate member positioned on the positive side of the y-axis, the positive side of the x-axis, and the negative side of the x-axis with respect to semiconductor laser element 200, and translucent window 420 and bottom plate 410 constitute a rectangular frame shape in plan view. In other words, semiconductor laser element 200, FACL 110, and first submount 230 are disposed in an opening of this rectangular frame shape. Side plate 430 includes an inorganic material such as a metal, a ceramic, or a glass material, and a terminal, not illustrated, is formed thereon. Side plate 430 is a member that includes an inorganic insulating material such as an alumina ceramic or AIN ceramic as the main material, and a terminal.

Top plate 440 is a plate-shaped member that includes an inorganic material such as a metal or a ceramic material.

Top plate 440 is a member that covers the above-described opening of the rectangular frame shape, which is composed of translucent window 420 and bottom plate 410.

Translucent window 420 and side plate 430 are bonded together. Furthermore, bottom plate 410 is bonded to translucent window 420 and side plate 430, and top plate 440 is bonded to translucent window 420 and side plate 430.

Package 400 that is composed of translucent window 420, bottom plate 410, side plate 430, and top plate 440 has a sealed space inside, and semiconductor laser element 200, FACL 110, and first submount 230 are disposed in the sealed space. Furthermore, semiconductor laser element 200 disposed inside package 400 is electrically connected to the outside of package 400 by a terminal.

In other words, semiconductor laser element 200 and FACL 110 are hermetically sealed by package 400.

This protects semiconductor laser element 200 from impurities such as organic matter from outside package 400. Therefore, it is possible to inhibit the deterioration of semiconductor laser element 200 that occurs due to impurities such as organic matter adhering to semiconductor laser element 200 during operation of semiconductor laser element 200.

Furthermore, optical unit 1c includes second submount 250c.

Second submount 250c is a member that is bonded to first submount 230 and supports FACL 110. Second submount 250c may be in any shape as long as it is capable of supporting FACL 110, but here, second submount 250c is a member that is in a flat plate shape, as an example. Second submount 250c has an upper face parallel to the xy-plane and is fixed to protrude with respect to first submount 230 in the direction in which laser light L1 travels. Further, joining material 280c is disposed on the upper face of second submount 250c to fix FACL 110. In other words, joining material 280c is disposed between the lower face of FACL 110 and the upper face of second submount 250c to join FACL 110. Furthermore, second submount 250c and first submount 230 are bonded by a bonding material, not illustrated. In the present variation, a side face of second submount 250c that is parallel to the xz-plane is bonded to a side face of first submount 230 that is parallel to the xz-plane. Joining material 280c is, for example, an inorganic joining material such as a solder material or a metal sintered body. As illustrated in FIG. 34, second submount 250c is also hermetically sealed by package 400.

Furthermore, platform 510c according to the present variation will be described. Platform 510c includes a plurality of stages in the shape of a staircase. The plurality of stages consist of first stage 511c, a second stage, a third stage, a fourth stage, a fifth stage, and a sixth stage. Optical unit 1c is disposed on first stage 511c.

Note that first stage 511c differs from first stage 511 according to Embodiment 1 in that first stage 511c is a stage consisting of one stage, that is, first stage 511c does not have a plurality of steps such as first step 511a and second step 511b. Similarly, each of the second through sixth stages according to the present variation consists of one stage. Each of first stage 511c and the second through sixth stages is a flat face parallel to the xy-plane.

Furthermore, in the present variation, sixth bonding material 320 bonds bottom plate 410 of package 400 to first stage 511c. Sixth bonding material 320 includes, for example, an inorganic joining material such as a solder material or a metal sintered body.

Note that as illustrated in FIG. 34, among the plurality of constituent elements included in optical unit 1c, semiconductor laser element 200, FACL 110, first submount 230, joining material 280c, second submount 250c, and package 400 may be collectively described as package unit 600.

Here, a method for manufacturing the light source module according to the present variation will be described. More specifically, a method for manufacturing optical unit 1c will be described.

(a) in FIG. 34 is a cross-sectional view for illustrating the placement of package 400 on first stage 511c. First, package unit 600, in which semiconductor laser element 200, first submount 230, second submount 250c, and FACL 110 have been fixed at predetermined positions, is manufactured inside package 400. At this time, the position of FACL 110 is adjusted to the upper face of second submount 250c and fixed by joining material 280c. Subsequently, sixth bonding material 320 is applied on first stage 511c and package unit 600 is disposed on sixth bonding material 320.

(b) in FIG. 34 is a cross-sectional view illustrating a state before first lens 120 according to the present variation is disposed. First, package unit 600 disposed on sixth bonding material 320 of first stage 511c is heated and cooled while package unit 600 is pressed toward first stage 511c. At this time, package unit 600 is bonded to first stage 511c by using sixth bonding material 320. Next, predetermined power is applied to package unit 600, and laser light L1 is emitted from light emission point 201 of semiconductor laser element 200. (c) in FIG. 34 is a cross-sectional view illustrating a state after the position of first lens 120 according to the present variation has been adjusted and first lens 120 has been disposed.

In (b) and (c) in FIG. 34, imaginary line IL is shown for illustrative purposes. Imaginary line IL is a line parallel to the y-axis, and the position of imaginary line IL in the z-axis direction is the same as the position of light emission point 201 in the z-axis direction.

When package unit 600 illustrated in (b) in FIG. 34 is fixed to first stage 511c, package unit 600 may be fixed to first stage 511c at a tilt, or the film thickness of joining material 280c in package unit 600 may change. At this time, optical axis LA1 of laser light L1 may be tilted with respect to imaginary line IL due to the displacement of FACL 110 from the optimal position in the fast axis direction, that is, in the z-axis direction. (b) in FIG. 34 illustrates an example in which laser light L1 travels diagonally upward with respect to imaginary line IL. That is, the angle formed between imaginary line IL and optical axis LA1 of laser light L1 transmitted through translucent window 420 becomes greater than 0°. Laser light L1 transmitted through translucent window 420 is positioned further in the positive direction of the z-axis than imaginary line IL is, and travels not parallel to the y-axis direction, but toward the negative direction of the y-axis and the positive direction of the z-axis.

Then, as illustrated in (c) in FIG. 34, in the present variation, first lens 120 is disposed and the position of first lens 120 is adjusted. When, as in FIG. 34, laser light L1 transmitted through translucent window 420 travels in the negative direction of the y-axis and the positive direction of the z-axis, generatrix 125 of first lens 120 becomes positioned further on the positive side of the z-axis than imaginary line IL is. As a result, laser light L1 transmitted through first lens 120 is refracted and travels parallel to the y-axis direction. Thus, laser light L1 can be incident on reflecting mirror 700, and the coupling efficiency in the light source module according to the present variation can be increased.

[Advantageous Effects, etc.]

Light source module 10 according to Embodiment 1 includes: platform 510 that includes a plurality of stages (first to sixth stages 511 to 516) in the shape of a staircase; and the plurality of optical units (optical units 1 to 6) disposed on each of the plurality of stages. Each of optical units 1 to 6 has: semiconductor laser element 200 that emits laser light; a fast axis cylindrical lens (FACL 110) that is a lens on which the laser light emitted from semiconductor laser element 200 is incident and that focuses the laser light in the fast axis direction of the laser light; a first fast axis adjustment lens (first lens 120) that is a lens on which the laser light that exits from FACL110 is incident and that adjusts optical axis LA1 of the laser light in the fast axis direction; and slow axis collimator lens 170 (SACL 170) that is a lens on which the laser light that exits from first lens 120 is incident and that collimates the laser light in the slow axis direction of the laser light.

F1 denotes the effective focal length of FACL 110, F2 denotes the effective focal length of first lens 120, and d denotes the lens distance, which is the distance between principal point P1 of FACL 110 and principal point P2 of first lens 120. In this case, $\alpha$ satisfies Formula 1.

$$\alpha = F2/F1 \qquad \text{(Formula 1)}$$

$\beta$ satisfies Formula 2.

$$\beta = d/F2 \qquad \text{(Formula 2)}$$

When F2 > 0, $\alpha$ and $\beta$ satisfy Formula 3, Formula 4, Formula 5, and Formula 6.

$$\alpha > 1 \qquad \text{(Formula 3)}$$

$$\alpha\beta > 1 \qquad \text{(Formula 4)}$$

$$\beta < (1/\alpha) + (1/3) \qquad \text{(Formula 5)}$$

$$\beta < 1 \qquad \text{(Formula 6)}$$

When F2 < 0, $\alpha$ and $\beta$ satisfy Formula 7, Formula 8, Formula 9, and Formula 10.

$$\alpha < -1 \qquad \text{(Formula 7)}$$

$$\alpha\beta < 1 \qquad \text{(Formula 8)}$$

$$\beta > (1/\alpha) - (1/3) \qquad \text{(Formula 9)}$$

$$\beta > -1 \qquad \text{(Formula 10)}$$

For example, in Embodiment 1, F2 > 0. In this case, the effects illustrated in FIG. 19 to FIG. 23G are obtained. In other words, even if the position of principal point P1 of each of the plurality of FACLs 110 (here, six FACLs 110) is displaced from the optimal position in the z-axis direction, the positions of the plurality of first lenses 120 (here, six first lenses 120) are adjusted, thereby increasing the coupling efficiency in light source module 10.

Furthermore, for example, in Variation 1 of Embodiment 1, F2 < 0. In this case, the effects illustrated in FIG. 31 and FIG. 32 are obtained. In other words, even if the position of principal point P1 of each of the plurality of FACLs 110 (here, six FACLs 110) is displaced from the optimal position in the z-axis direction, the positions of the plurality of first lenses 120a (here, six first lenses 120a) are adjusted, thereby increasing the coupling efficiency in light source module 10a.

Thus, in both the case of F2 > 0 and the case of F2 < 0, the positions of the six first lenses 120 and 120a are adjusted, thereby realizing light source modules 10 and 10a having high coupling efficiency.

For example, when F2 > 0 (Embodiment 1, for example), α satisfies Formula 11.

$$9.3 \leq \alpha \qquad \text{(Formula 11)}$$

Furthermore, for example, when F2 < 0 (Variation 1 of Embodiment 1, for example), α satisfies Formula 12.

$$-9.3 \geq \alpha \qquad \text{(Formula 12)}$$

This makes it possible, under condition B10 in FIG. 23B described above, for the range for the position of first lens 120 in which the decrease in coupling efficiency is within 5% to be set to about ±10 μm; in other words, the range for this position can be sufficiently larger than in Comparative Examples 1 and 2. Furthermore, under condition C1 in FIG. 32, the range for the position of first lens 120a in which the decrease in the coupling efficiency is within 5% can be set to about ±50 μm.

For example, when F2 > 0 (Embodiment 1, for example), α satisfies Formula 13.

$$\alpha \leq 633 \qquad \text{(Formula 13)}$$

Furthermore, for example, when F2 < 0 (Variation 1 of Embodiment 1, for example), α satisfies Formula 14.

$$\alpha \geq 633 \qquad \text{(Formula 14)}$$

This makes it possible to inhibit the decrease in the coupling efficiency by adjusting the position of first lens 120 with respect to the positional displacement of FACL 110, as indicated in condition B14 in FIG. 23F and condition B15 in FIG. 23G described above. Furthermore, as indicated in condition C1 in FIG. 32, the decrease in the coupling efficiency can be inhibited by adjusting the position of first lens 120a with respect to the positional displacement of FACL 110.

Furthermore, for example, the fast axis cylindrical lens (FACL 110) has an incident face on which the laser light is incident and an exit face from which the laser light exits, and the incident face is positioned to face light emission point 201 of semiconductor laser element 200.

This makes it possible to position the fast axis cylindrical lens (FACL 110) near light emission point 201 of semiconductor laser element 200, thereby making it possible to reduce the fast axis direction beam width of the laser light condensed in the fast axis direction.

In Embodiment 1, each of the plurality of first lenses 120 is a cylindrical lens and is a convex lens.

As indicated in Embodiment 1, when each of the plurality of first lenses 120 is a convex lens, F2 > 0 is satisfied, thus making it possible to increase the coupling efficiency in light source module 10 even when the position of the fast axis cylindrical lens (FACL 110) is displaced from the optimal position, as described above. Furthermore, each of the plurality of first lenses 120 being a cylindrical lens makes it possible to easily configure light source module 10.

In Embodiment 1, β satisfies Formula 15.

$$0 < \beta \leq 0.33 \qquad \text{(Formula 15)}$$

When, as described above, β is set to the range of Formula 15, along with the condition of F2 > 0, F/F1 can be made smaller than 1.5, thus making it possible to inhibit a decrease in the coupling efficiency of light source module 10.

In Variation 1 of Embodiment 1, each of the plurality of first lenses 120a is a cylindrical lens and is a concave lens.

As indicated in Variation 1 of Embodiment 1, when each of the plurality of first lenses 120a is a concave lens, F2 < 0 is satisfied, thus making it possible to increase the coupling efficiency in light source module 10a even when the position of the fast axis cylindrical lens (FACL 110) is displaced from the optimal position, as described above. Furthermore, each of the plurality of first lenses 120a being a cylindrical lens makes it possible to easily configure light source module 10a.

In Variation 1 of Embodiment 1, β satisfies Formula 16.

$$-0.33 \leq \beta < 0 \qquad (\text{Formula } 16)$$

When, as described above, β is set to the range of Formula 16, along with the condition of F2 < 0, F/F1 can be made larger than 0.75, thus making it possible to inhibit alteration of the surface of reflecting mirror 700 in light source module 10a.

In Embodiment 1, F1 is 0.15 mm or greater and 0.65 mm or less.

Optical units 1 to 6 according to Embodiment 1 have FACL 110 in which F1, which is the effective focal length, satisfies the above. In light source module 10 that has such optical units 1 to 6, the coupling efficiency can be increased.

In Embodiment 1, each of optical units 1 to 6 has support member 150 provided to platform 510. In each of optical units 1 to 6, support member 150 has an attachment face (first supporting side face 151) to which first lens 120 is attached. First lens 120 has a side face (fourth side face 124) orthogonal to generatrix 125. Semiconductor laser element 200 has an active layer. The side face (fourth side face 124) is fixed to the attachment face (first supporting side face 151), which is orthogonal to the active layer.

This makes it possible, as illustrated in FIG. 4A, for example, to adjust and fix the position of generatrix 125 in the fast axis direction or the optical axis LA1 direction of laser light L1.

In Embodiment 1, each of the plurality of optical units has a joining material that fixes FACL 110.

This makes it possible, in Embodiment 1, for the coupling efficiency to be increased by adjusting the position of first lens 120, even when the position of FACL 110 has been displaced in the fast axis direction due to the volume change of the joining material.

Furthermore, the joining material may be an inorganic-containing joining material.

Thus, in Embodiment 1, there is a smaller amount of shrinkage when the joining material hardens compared to, for example, a case of using a resin material to fix FACL 110. This reduces the displacement of the position of FACL 110 in the z-axis direction and facilitates adjustment of the position of first lens 120 to achieve higher coupling efficiency.

Furthermore, in Variation 2 of Embodiment 1, joining material 280 corresponds to the joining material.

In Embodiment 1, the joining material includes an inorganic joining material.

This makes it possible to inhibit the joining material that fixes FACL 110 from deteriorating due to the laser light and consequently reducing the joining strength.

In Variation 2 of Embodiment 1, each of the plurality of optical units has first submount 230 on which semiconductor laser element 200 is disposed and second submount 250 that is joined to first submount 230 and FACL 110.

Thus, in Variation 2 of Embodiment 1, when FACL 110 is disposed above second submount 250 (more specifically, above second upper face 251), FACL 110 is fixed while being supported by second upper face 251 that is parallel to the xy-plane. Therefore, it is easier to adjust the distance between light emission point 201 and FACL 110, that is, the position of FACL 110 in the focal direction.

Note that first submount 230 and second submount 250 may be constituted integrally using the same material.

In Variation 2 of Embodiment 1, joining material 280 is disposed between the lower face of FACL 110 and the upper face (second upper face 251) of second submount 250.

Thus, in Variation 2 of Embodiment 1, the lower face of FACL 110 and second upper face 251 are joined face to face, making it possible to firmly fix FACL 110.

In Variation 3 of Embodiment 1, each of the plurality of optical units has package 400 that houses and hermetically seals semiconductor laser element 200 and FACL 110.

Thus, in Variation 3 of Embodiment 1, semiconductor laser element 200, FACL 110, package 400, and the like constitute package unit 600, and semiconductor laser element 200 is protected from impurities such as organic matter from outside package 400. Therefore, it is possible to inhibit the deterioration of semiconductor laser element 200 that occurs due to impurities such as organic matter adhering to light emission point 201 of semiconductor laser element 200 during operation of semiconductor laser element 200.

Furthermore, in package unit 600, joining material 280c that fixes FACL 110 may be an inorganic joining material. This makes it possible to inhibit the deterioration of semiconductor laser element 200 that occurs due to the floating foreign matter such as siloxane from joining material 280c occurring in package 400 and adhering to light emission point 201 of semiconductor laser element 200.

[Embodiment 2]

Hereinafter, Embodiment 2 will be described. Below, description will center on the points of difference from Embodiment 1, and the description of common points will be omitted or simplified.

[Configuration]

First, the configuration of light source module 10d according to Embodiment 2 will be described with reference to FIG. 35.

FIG. 35 is a perspective view illustrating the configuration of light source module 10d according to Embodiment 2.

Light source module 10d according to the present embodiment has the same configuration as light source module 10 according to Embodiment 1, except that light source module 10d has optical units 1d to 6d instead of optical units 1 to 6.

FIG. 36 is a cross-sectional view of optical unit 1d taken along the XXXVI-XXXVI line in FIG. 35. FIG. 37 is a perspective view illustrating the configuration of optical units 1d and 2d according to the present embodiment. Each of optical units 1d to 6d has the same configuration, and here, mainly optical unit 1d will be described.

Optical unit 1d according to the present embodiment has the same configuration as optical unit 1 according to Embodiment 1, except that instead of first lens 120, first fast axis adjustment lens 120d (hereinafter, first lens 120d) is included, and support member 150 is not included.

Optical unit 1d according to the present embodiment moves the position of generatrix 125d in the z-axis direction by moving first lens 120d in the x-axis direction. First lens 120d has the same configuration as first lens 120 according to Embodiment 1, except that first lens 120d has generatrix 125d instead of generatrix 125.

Generatrix 125 according to Embodiment 1 was parallel to the xy-plane. Furthermore, in Embodiment 1, the active layer of semiconductor laser element 200 was parallel to the xy-plane, whereby generatrix 125 was parallel to the active layer. Moreover, generatrix 125 was parallel to the generatrix of FACL 110. Furthermore, generatrix 125 was parallel to the upper faces of first stage 511 to sixth stage 516.

Generatrix 125d according to the present embodiment is tilted with respect to the active layer of semiconductor laser element 200. In other words, generatrix 125d is tilted with respect to the upper face of first stage 511 to sixth stage 516. In other words, generatrix 125d is tilted with respect to the generatrix of FACL 110. This tilting of generatrix 125d will be described with reference to FIG. 38.

FIG. 38 is a front view for illustrating the tilting of generatrix 125d according to the present embodiment. Note that for simplicity, FIG. 38 shows mainly first lens 120d.

Generatrix 125d is tilted with respect to the active layer, first stage 511 (more specifically, first step 511a), and the xy-plane. Here, angle $\theta1$ is the angle between generatrix 125d and the active layer. Furthermore, in the case of tilting from the positive direction of the x-axis to the positive direction of the z-axis, $\theta1$ is assumed to take a positive value, and in the case of tilting from the positive direction of the x-axis to the negative direction of the z-axis, $\theta1$ is assumed to take a negative value. Since generatrix 125d is tilted with respect to the active layer, $0° < |\theta1|$ is satisfied. Note that the tilt is sufficient as long as it is $0° < |\theta1| < 45°$, and the tilt may be $0.5° < |\theta1| < 23°$, or may be $1° < |\theta1| < 5°$. Furthermore, the position of generatrix 125d is adjusted by moving first lens 120d in the x-axis direction indicated by the arrow in FIG. 38.

This will be described with reference to FIG. 36 and FIG. 37, in addition to FIG. 38. First lens 120d has bottom face 1211. Furthermore, generatrix 125d is tilted with respect to bottom face 1211. First lens 120d is not supported by support member 150, unlike first lens 120 according to Embodiment 1. First lens 120d is fixed to platform 510 by bonding bottom face 1211 of first lens 120d and first step 511a together, by using first bonding material 161. First step 511a is the attachment face of first lens 120d. In other words, in Embodiment 1, first bonding material 161 was disposed on the side face (fourth side face 124) of first lens 120, but in the present embodiment, first bonding material 161 is disposed on bottom face 1211 of first lens 120d. Furthermore, bottom face 1211 and first step 511a are partially or wholly in direct contact with each other, or a thin layer of first bonding material 161, e.g., 5 μm or less, is formed at a part or an entirety between bottom face 1211 and first step 511a.

In the present embodiment, first lens 120d is disposed above first step 511a of first stage 511. Note that first step 511a on which this first lens 120d is disposed corresponds to a flat placement face. Furthermore, bottom face 1211 described above is a face that is parallel to the flat placement face (first step 511a). Since first step 511a is a flat face parallel to the xy-plane, it can be stated that generatrix 125d is tilted with respect to the flat placement face (first step 511a), the active layer, and the xy-plane.

In FIG. 36, the angle between imaginary line IL and optical axis LA1 of laser light L1 after exiting from FACL 110 is greater than 0° and tilted upward. Furthermore, generatrix 125d of first lens 120d is positioned below imaginary line IL, in the z-axis direction of optical axis LA1. Thus, similarly to Embodiment 1, optical axis LA1 of laser light L1 that exits from first lens 120d is refracted so as to become parallel to imaginary line IL, and adjusted.

In FIG. 37, beam spot LO1d of laser light L1 incident on first lens 120d of optical unit 1d is illustrated by a dashed line. Similarly, beam spot LO2d of laser light L2 incident on first lens 120d of optical unit 2d is illustrated by a dashed line. Beam spots LO1d and LO2d are long in the x-axis direction from a front view, and rectangular with rounded corners.

Furthermore, the effect imparted by angle $\theta1$ will be examined. Here, this will be described with reference to a front view when first lens 120d of optical unit 1d is disposed on first step 511a in the manufacturing of light source module 10d.

FIG. 39A is a front view illustrating when the position of first lens 120d according to the present embodiment is positionally adjusted and fixed on first step 511a, in a method for manufacturing optical unit 1d.

In FIG. 39A, collet 1100 that moves first lens 120d and syringe 1200 that ejects first bonding material 161 are illustrated. In FIG. 39A, an example of a case in which first bonding material 161 is an ultraviolet curable adhesive containing an ultraviolet curable resin is illustrated. In FIG. 39A, an example that is a case in which angle θ1 of first lens 120d is negative is illustrated.

FIG. 39A illustrates a case in which, in optical unit 1d, when the position of FACL 110 is adjusted and fixed, FACL 110 has been displaced slightly above a predetermined position, i.e., in the positive direction of the z-axis. First lens 120d is then moved to adjust the direction of optical axis LA1 of laser light L1. At this time, semiconductor laser element 200 is being caused to emit light, whereby laser light L1 is being emitted. (a) in FIG. 39A is a front view illustrating a state before first lens 120d is moved. (b) in FIG. 39A is a front view illustrating a state after first lens 120d is moved. Here, first lens 120d illustrated in (b) in FIG. 39A has been moved further on the negative side of the x-axis, with respect to first lens 120d illustrated in (a) in FIG. 39A. Furthermore, here, first lens 120d has been moved such that bottom face 1211 is in line with the flat placement face (first step 511a).

In (a) in FIG. 39A, in the front view, beam spot LO1d of laser light L1 is positioned above generatrix 125d, that is, in the positive direction of the z-axis. At this time, the distance between the center of beam spot LO1d and generatrix 125d in the z-axis direction is distance d11, and the center of beam spot LO1d and generatrix 125d do not overlap each other. In other words, at reference line XXXIX-XXXIX, the center of beam spot LO1d is distance d11 away from generatrix 125d. In other words, in the front view, the position of the center of beam spot LO1d in the z-axis direction and the position of generatrix 125d in the z-axis direction are different from each other.

In (b) in FIG. 39A, in the front view, generatrix 125d moves in the negative direction of the x-axis, whereby at reference line XXXIX-XXXIX, generatrix 125d moves in the negative direction of the z-axis. The center of beam spot LO1d then moves distance d111 away from generatrix 125d.

At this time, the cross-sectional view of optical unit 1d at reference line XXXIX-XXXIX corresponds to the view in FIG. 36, without the bonding material. Optical axis LA1 of laser light L1 exits diagonally upward from FACL 110 with respect to imaginary line IL, and the amount of refraction is adjusted such that optical axis LA1 is parallel to imaginary line IL, by adjusting the position of generatrix 125d of first lens 120d. Laser light L1 is then coupled to optical fiber 550 with high efficiency.

In (c) in FIG. 39A, first bonding material 161 is applied from syringe 1200 to a part where first lens 120d, disposed at a predetermined position, connects to first step 511a. Ultraviolet light is then radiated to cure first bonding material 161 and fix first lens 120d to platform 510.

FIG. 39B is another front view illustrating when first lens 120d according to the present embodiment is disposed on first step 511a. FIG. 39B is similar to FIG. 39A, but illustrates a case in which, in optical unit 1d, when the position of FACL 110 is adjusted and fixed, FACL 110 has been displaced slightly below the predetermined position, i.e., in the negative direction of the z-axis.

In (a) in FIG. 39B, in the front view, beam spot LO1d of laser light L1 is positioned below generatrix 125d, that is, in the negative direction of the z-axis. At this time, the distance between the center of beam spot LO1d and generatrix 125d in the z-axis direction is distance d11.

In (b) in FIG. 39B, in the front view, generatrix 125d moves in the positive direction of the x-axis, whereby at reference line XXXIX-XXXIX, generatrix 125d moves in the positive direction of the z-axis. The center of beam spot LO1d then moves distance d111 away from generatrix 125d.

Optical axis LA1 of laser light L1 exits diagonally downward from FACL 110 with respect to imaginary line IL, and the amount of refraction is adjusted such that optical axis LA1 is parallel to imaginary line IL, by adjusting the position of generatrix 125d of first lens 120d. Laser light L1 is then coupled to optical fiber 550 with high efficiency.

In (c) in FIG. 39B, first lens 120d is fixed to platform 510 by using first bonding material 161, as in (c) in FIG. 39A.

Thus, in the present embodiment, even if FACL 110 is displaced from the predetermined position in the positive direction of the z-axis or the negative direction of the z-axis when being fixed, the tilt of optical axis LA1 of laser light L1 relative to imaginary line IL can be adjusted by adjusting the position of first lens 120d in the x-axis direction. In other words, the tilt of optical axis LA1 can be adjusted by adjusting the position of first lens 120d along first step 511a. Laser light L1 is then coupled to optical fiber 550 with high efficiency.

Since generatrix 125d is tilted with respect to the active layer and the xy-plane, as illustrated in (a) and (b) in FIG. 39A, the distance between the center of beam spot LO1d and generatrix 125d in the z-axis direction changes when first lens 120d moves in the x-axis direction. Furthermore, when angle θ1 satisfies $0° < |θ1| < 45°$, the amount of change in the distance between the center of beam spot LO1d and generatrix 125d in the z-axis direction is less than the amount of movement of first lens 120d in the x-axis direction. When the position of first lens 120d in the x-axis direction is adjusted by using manufacturing equipment, the position in the x-axis direction is adjusted with precision equal to the precision of the manufacturing equipment. Since, as described above, the amount of change in the distance between the center of beam spot LO1d and generatrix 125d in the z-axis direction is less than the amount of movement of first lens 120d in the x-axis direction, the position of first lens 120d in the z-axis direction can be adjusted with higher precision than the precision of the manufacturing equipment.

For example, when angle $\theta 1$ is 6°, the amount of change in the distance between the center of beam spot LO1d and generatrix 125d in the z-axis direction is about 1/10 of the amount of movement of first lens 120d in the x-axis direction; thus, the position in the z-axis direction can be adjusted with precision that is 1/10 of the manufacturing equipment.

In such an optical unit 1d, the position of first lens 120d can easily be adjusted such that the coupling efficiency between laser light L1 emitted from semiconductor laser element 200 and optical fiber 550 is high. Note that the same is true for the other optical units 2d to 6d. In other words, light source module 10d having high coupling efficiency is realized.

Furthermore, (c) in FIG. 39A is a front view illustrating when first bonding material 161 is injected onto first lens 120d that has been moved. Thus, first lens 120d is bonded by providing first bonding material 161 at the end of the negative side of the x-axis and the end of the positive side of the x-axis of first lens 120d.

Furthermore, a method for manufacturing first lens 120d will be described below. FIG. 40 is a front view illustrating the method for manufacturing first lens 120d according to the present embodiment.

More specifically, (a) in FIG. 40 is a front view illustrating cylindrical lens 900 that has been prepared, (b) in FIG. 40 is a front view illustrating a plurality of fragmentary lenses 901 that have been cut, (c) in FIG. 40 is a front view illustrating polishing of the plurality of fragmentary lenses 901, and (d) in FIG. 40 is a front view illustrating a plurality of first lenses 120d that have been manufactured.

First, as illustrated in (a) in FIG. 40, cylindrical lens 900 having generatrix 915 is prepared. Further, the prepared cylindrical lens 900 is cut at a plurality of cutting lines 902, indicated by the dashed lines in (a) in FIG. 40. Here, the plurality of cutting lines 902 are parallel to each other, and cylindrical lens 900 is cut such that angle $\gamma$, which is the angle between each of the plurality of cutting lines 902 and generatrix 915, satisfies $0° < \gamma < 90°$.

The cutting of cylindrical lens 900 resulted in the plurality of fragmentary lenses 901 being obtained. As illustrated in (b) in FIG. 40, the plurality of fragmentary lenses 901 are fixed such that their cut surfaces are in contact with each other, by using, e.g., a jig and a temporary fixing resin, not illustrated.

Subsequently, the plurality of fragmentary lenses 901 fixed to the jig or the like are polished in a batch. Here, as illustrated in (c) in FIG. 40, the plurality of fragmentary lenses 901 are polished in a batch up to two polishing lines 903 that are parallel to each other, indicated by dash-dot lines. Then, as illustrated in (d) in FIG. 40, a plurality of first lenses 120d having end faces tilted with respect to generatrix 125 are obtained.

The jig and the temporary fixing resin are then removed to manufacture the plurality of first lenses 120d.

Next, the effects of optical unit 1d according to the present embodiment will be described with reference to FIG. 41A to FIG. 42.

First, the influence, on the optical properties of optical unit 1d, of the tilt of generatrix 125d with respect to the active layer and the xy-plane will be examined.

Aberrations occur due to the tilt of generatrix 125d. Thus, distortion is expected to occur in each of the optical intensity distribution of laser lights L1 to L6 at the incident face of condenser lens 800, and the optical intensity distribution of laser lights L1 to L6 at the incident face of optical fiber 550.

FIG. 41A is a diagram indicating the results of calculating, by simulation, the optical intensity distribution of laser lights L1 to L6 at the incident face of condenser lens 800 when, in addition to condition B6 of Embodiment 1, angle $\theta 1$ according to the present embodiment is -15°. In FIG. 41A, the beam spots of laser lights L1 to L6 are illustrated, with darker colored areas indicating higher optical intensity.

In FIG. 41A, the optical intensity distribution is calculated under the following conditions. Specifically, the peak wavelength and the light-emitting region width of semiconductor laser element 200 are 450 nm and 100 $\mu$m, respectively, F1, which is the effective focal length of FACL 110, is 0.38 mm, F2, which is the effective focal length of first lens 120d, is 38 mm, lens distance d is 6.3 mm, the effective focal length of SACL 170 is 13.5 mm, the effective focal length of condenser lens 800 is 7.3 mm, and the core diameter and numerical aperture NA of optical fiber 550 are 100 $\mu$m and 0.22, respectively.

Since angle $\theta 1$ is -15°, the beam spots of laser lights L1 to L6 have increasing values on the vertical axis as the values on the horizontal axis increase, as illustrated in FIG. 41A. In other words, in FIG. 42, the respective beam spots of laser lights L1 to L6 are on an upward curve.

Here, the results of the calculation, in the present embodiment, of the change in coupling efficiency of optical fiber 550, with respect to the x-axis direction of first lens 120d, in the optical system of light source module 10d will be described with reference to FIG. 41B. FIG. 41B is a diagram illustrating the results of calculating the coupling efficiency under the conditions of FIG. 41A. In other words, the data indicated by the black circles and solid lines in FIG. 41B are the calculation results when similarly to FIG. 41A, in addition to condition B6 of Embodiment 1, angle $\theta 1$ according to the present embodiment is -15°. At this time, FACL 110 is displaced by 2 $\mu$m (-2 $\mu$m) in the negative direction of the z-axis. In this case, the optical efficiency is 80% or less at the reference position. However, by moving first lens 120d in the positive direction of the x-axis, the coupling efficiency increases, and by moving and adjusting first lens 120d by approximately 0.8 mm, the coupling efficiency can be restored to almost 100%.

The influence when angle θ1 is changed is described with reference to FIG. 42.

FIG. 42 is a diagram illustrating the results of calculating, by simulation, the maximum value of the coupling efficiency when using first lens 120d in which angle θ1 according to the present embodiment has been changed.

In FIG. 42, the white squares and solid lines indicate the coupling efficiency calculated under the same conditions as in FIG. 41A, when θ1 is changed. Furthermore, the coupling efficiency when θ1 = 0 has been normalized as 1.

As illustrated in FIG. 42, even when the absolute value of angle θ1 increases from 0° to 15°, the coupling efficiency remains at almost 1. Furthermore, when the absolute value of angle θ1 exceeds 15°, the coupling efficiency begins to gradually decrease, and when angle θ1 exceeds 23°, the coupling efficiency drops below 0.95. Therefore, under these conditions, the absolute value of angle θ1 may be set to 23° or less.

Under the above-described conditions, for example, the change in coupling efficiency when first lens 120d is adjusted in the x-axis direction under condition B6 of FIG. 23A can be compared with the change in the coupling efficiency when first lens 120 is adjusted in the z-axis direction under condition B6 of FIG. 23A. The black circles and solid lines in FIG. 23A and FIG. 41A both show the change in coupling efficiency when FACL 110 is displaced by 2.0 μm in the negative direction of the z-axis. FIG. 23A is a case in which the generatrix of first lens 120 is not tilted, and FIG. 41A is a case in which θ1 is -15°. The range in which the coupling efficiency exceeds 95% is approximately 300 μm when generatrix 125d is not tilted, and approximately 650 μm when θ1 is -15°, meaning the adjustment range is more than twice as large.

Furthermore, FIG. 41B illustrates the changes in coupling efficiency when first lens 120d is moved in the x-axis direction, when angle θ1 of the generatrix of first lens 120d is changed -1°, 2.5°, and 5° under condition B10. At this time, FACL 110 was similarly assumed to have been displaced by 2.0 μm in the negative direction of the z-axis. At all angles θ1, the coupling efficiency can be improved by adjusting first lens 120d in the x-axis direction. In other words, the coupling efficiency can be improved under a condition of angle θ1 being 1° or greater and 5° or less. Furthermore, it can be seen that angle θ1 being smaller results in a broader adjustment range.

Furthermore, in FIG. 42, the maximum value of the coupling efficiency is calculated, in addition to condition B6, under condition B10 and condition B4 as well, when first lens 120d in which angle θ1 according to the present embodiment is changed is used. Under condition B10 and condition B4, the range of angle θ1 in which the maximum value of the coupling efficiency does not decrease is lower than in condition B6. Thus, angle θ1 can be appropriately selected in accordance with the optical unit.

As illustrated in FIG. 39A, FIG. 39B, and the like, by adopting 0° < θ1 < 45° as angle θ1, when FACL 110 has been displaced, the coupling efficiency can be improved by adjusting the position of first lens 120d in the x-axis direction.

[Advantageous Effects, etc.]

In Embodiment 2, in each of the plurality of optical units (optical unit 1d to 6d), the first fast axis adjustment lens (first lens 120d) is a cylindrical lens that has generatrix 125d. Each of the plurality of semiconductor laser elements 200 has an active layer. Each of the plurality of generatrices 125d is tilted with respect to the active layer.

In Embodiment 2, as illustrated in (a) and (b) in FIG. 39A, when first lens 120d moves in the x-axis direction, the distance between the center of beam spot LO1d and generatrix 125d in the z-axis direction changes. Furthermore, when angle θ1 satisfies 0° < θ1 < 45°, the amount of change in the distance between the center of beam spot LO1d and generatrix 125d in the z-axis direction is less than the amount of movement of first lens 120d in the x-axis direction. When the position of first lens 120d in the x-axis direction is adjusted by manufacturing equipment, the position in the x-axis direction is adjusted with precision equal to the precision of the manufacturing equipment, whereby the position in the z-axis direction can be adjusted with precision higher than the precision of the manufacturing equipment.

In such an optical unit 1d, the position of first lens 120d can easily be adjusted such that the coupling efficiency between laser light L1 emitted from semiconductor laser element 200 and optical fiber 550 is high. Note that the same is true for the other optical units 2d to 6d. In other words, light source module 10d having high coupling efficiency is realized.

In Embodiment 2, in each of optical units 1d to 6d, first lens 120d has bottom face 1211 tilted with respect to generatrix 125d, and bottom face 1211 is fixed directly or indirectly to platform 510.

This makes it possible to fix first lens 120d to platform 510.

In Embodiment 2, in each of optical units 1d to 6d, semiconductor laser element 200 has an active layer, platform 510 has an attachment face (first step 511a) that is parallel to the active layer and to which first lens 120d is attached, and bottom face 1211 is fixed to the attachment face (first step 511a).

Thus, generatrix 125d of first lens 120d tilts with respect to the active layer. Thus, as described above, when the position of first lens 120d in the x-axis direction is adjusted by the manufacturing equipment, the position in the x-axis direction is adjusted with precision equal to the precision of the manufacturing equipment, whereby the position in the z-axis direction can be adjusted with precision higher than the precision of the manufacturing equipment.

In Embodiment 2, in each of optical units 1d to 6d, first lens 120d is disposed above a flat placement face (first step 511a) of the stage. The first fast axis adjustment lens (first lens 120d) has bottom face 1211 that is parallel to the flat placement face, and each of the plurality of generatrices 125d is tilted with respect to bottom face 1211.

Thus, when first lens 120d has moved such that bottom face 1211 follows the flat placement face (first step 511a), as described above, the amount of change in the distance between the center of beam spot LO1d and generatrix 125d in the z-axis direction is less than the amount of movement of first lens 120d in the x-axis direction. Thus, in such an optical unit 1d, the position of first lens 120d can easily be adjusted such that the coupling efficiency between laser light L1 emitted from semiconductor laser element 200 and optical fiber 550 is high. Note that the same is true for the other optical units 2d to 6d. In other words, light source module 10d having high coupling efficiency is realized. Further, emitted laser light L100d having high luminance can exit from the end face of optical fiber 550 of light source module 10d.

[Embodiment 3]

Hereinafter, Embodiment 3 will be described. Below, description will center on the points of difference from Embodiment 2, and the description of common points will be omitted or simplified.

FIG. 43 is a perspective view illustrating a part of light source module 10f according to Embodiment 3.

Light source module 10f according to the present embodiment has the same configuration as light source module 10d according to Embodiment 2, except that instead of optical units 1d to 6d, light source module 10f according to the present embodiment includes optical unit 1f, and optical unit 2f and four optical units each having the same configuration as optical unit 1f. In other words, light source module 10f according to the present embodiment includes six optical units. Each of the six optical units has the same configuration, and here, mainly optical unit 1f will be described.

Optical unit 1f according to the present embodiment has the same configuration as optical unit 1d according to Embodiment 2, except that mainly, package 400 is included.

In other words, optical unit 1f according to the present embodiment includes package unit 600 (semiconductor laser element 200, FACL 110, first submount 230, joining material 280c, second submount 250c, and package 400), first lens 120d, and SACL 170.

Package unit 600 includes semiconductor laser element 200, FACL 110, first submount 230, joining material 280c, second submount 250c, and package 400.

Package 400 includes bottom plate 410, side plate 430 surrounding the periphery, and translucent window 420. Translucent window 420 is disposed to cover front opening 630 formed in a part of side plate 430. Furthermore, for illustrative purposes, top plate 440 of package 400 is not illustrated in FIG. 43. Moreover, bottom plate 410 and side plate 430 are package components integrally molded from a material with high heat dissipation properties, such as a ceramic, for example. Furthermore, first internal electrode 611, second internal electrode 612, first external electrode 621, and second external electrode 622 are formed on side plate 430. First external electrode 621 and first internal electrode 611 are electrically connected to each other, and constitute a terminal. Second external electrode 622 and second internal electrode 612 are electrically connected to each other, and constitute a terminal. First internal electrode 611 and second internal electrode 612 are connected to semiconductor laser element 200, and power is inputted to first external electrode 621 and second external electrode 622 to input predetermined power to semiconductor laser element 200.

Note that as in Variation 3 of Embodiment 1, light source module 10f according to the present embodiment includes platform 510c.

In the present embodiment, semiconductor laser element 200 and FACL 110 are hermetically sealed by package 400. At this time, FACL 110 is fixed to a predetermined position in package 400 by using joining material 280c.

This protects semiconductor laser element 200 from impurities such as organic matter from outside package 400. Therefore, it is possible to inhibit the deterioration of semiconductor laser element 200 that occurs due to impurities such as organic matter adhering to semiconductor laser element 200 during operation of semiconductor laser element 200.

Furthermore, generatrix 125d of first lens 120d is tilted with respect to the active layer and the xy-plane. Angle θ1 between generatrix 125d and the active layer satisfies $0° < |θ1| < 45°$. Thus, as in Embodiment 2, in optical unit 1f, the position of first lens 120d can easily be adjusted such that the coupling efficiency between laser light L1 emitted from semiconductor laser element 200 and optical fiber 550 is high. In other words, even if FACL 110 is fixed in a position displaced from the predetermined position when package unit 600 is fixed to optical unit 1f, the coupling efficiency can be improved by moving and adjusting the position of first lens 120d along the upper face of platform 510c, that is, the xy-plane. The same is true for optical unit 2f and the other four optical units. In other words, light source module 10f having high coupling efficiency is realized.

[Embodiment 4]

Hereinafter, Embodiment 4 will be described. Below, description will center on the points of difference from Embodiment 3, and the description of common points will be omitted or simplified.

[Configuration]

First, the configuration of light source module 10g according to Embodiment 4 will be described with reference to FIG. 44.

FIG. 44 is a perspective view illustrating a part of light source module 10g according to Embodiment 4.

Light source module 10g according to the present embodiment has the same configuration as light source module 10f according to Embodiment 3, except that instead of the six optical units according to Embodiment 3, light source module 10g according to the present embodiment includes optical unit 1g, and optical unit 2g and four optical units each having the same configuration as optical unit 1g. In other words, light source module 10g according to the present embodiment includes six optical units. Each of the six optical units has the same configuration, and here, mainly optical unit 1g will be described.

Optical unit 1g according to the present embodiment has the same configuration as optical unit 1f according to Embodiment 3, except that mainly, second fast axis adjustment lens 130 is included.

Second fast axis adjustment lens 130 (hereinafter, second lens 130) is a lens on which laser light L1 that exits from first lens 120d is incident, and that adjusts the optical axis of laser light L1 in the fast axis direction.

Second lens 130 is an optical component having power in the fast axis direction that is higher than the power in the slow axis direction. Second lens 130 according to the present embodiment is a cylindrical lens having a power axis and a non-power axis. Furthermore, the power axis and the non-power axis are disposed perpendicular to each other. Second lens 130 has a convex curved elliptical face, that is, a convex elliptical surface, along the power axis. Second lens 130 according to the present embodiment is a planoconvex lens in which the incident face on which laser light L1 is incident is planar and the exit face from which laser light L1 exits is a convex curved face.

The incident face of second lens 130 is parallel to the zx-plane. The curved face of the exit face of second lens 130 has a radius of curvature that is sufficiently large compared to FACL 110.

Second lens 130 is a member that includes an inorganic transparent material such as glass, and an antireflective coating film matched to the wavelength of laser light L1 is formed on the incident face on which laser light L1 is incident and the exit face from which laser light L1 exits.

Second lens 130 is fixed beforehand by seventh bonding material 330 before first lens 120d is adjusted and fixed.

Furthermore, second lens 130 has generatrix 135. Note that it can be stated that second lens 130 has the same configuration as first lens 120d, except that second lens 130 has generatrix 135 instead of generatrix 125d.

As in generatrix 125d of first lens 120d, generatrix 135 of second lens 130 is tilted with respect to the active layer of semiconductor laser element 200. This tilting of generatrices 125d and 135 will be described with reference to FIG. 45.

FIG. 45 is a front view for illustrating the tilting of generatrices 125d and 135 according to the present embodiment. Note that for simplicity, (a) in FIG. 45 illustrates mainly first lens 120d and (b) in FIG. 45 illustrates mainly second lens 130.

Generatrix 125d of first lens 120d is tilted with respect to the active layer and the xy-plane. As illustrated in (a) in FIG. 45, generatrix 125d is tilted in an analog clock counterclockwise direction with respect to the active layer and the xy-plane.

Generatrix 135 of second lens 130 is tilted with respect to the active layer and the xy-plane. As illustrated in (b) in FIG. 45, generatrix 135 is tilted in an analog clock clockwise direction with respect to the active layer and the xy-plane.

Here, angle θ2 is the angle between generatrix 135 and the active layer. Since generatrix 135 is tilted with respect to the active layer, $0° < |θ2|$ is satisfied. Note that the tilt is sufficient as long as it is $0° < |θ2| < 45°$, and the tilt may be $0.5° < |θ2| < 30°$, or may be $1° < |θ2| < 10°$.

Thus, optical unit 1g has first lens 120d and second lens 130. Generatrix 125d of first lens 120d and generatrix 135 of second lens 130 are tilted with respect to the active layer. Furthermore, the direction in which generatrix 125d is tilted with respect to the active layer is opposite to the direction in which generatrix 135 is tilted with respect to the active layer.

As illustrated in FIG. 41A, in light source module 10d to which second lens 130 is not provided, it was clear that the optical intensity distribution of laser lights L1 to L6 was distorted, that is, the beam spots of laser lights L1 to L6 were on an upward curve. This is due to the aberration caused by the tilt of generatrix 125d, as described above.

When these laser lights L1 to L6 are aligned in the z-axis direction by using reflecting mirrors 700, some of the laser lights having a large tilt, among the grouping of laser lights L1 to L6 at the position of condenser lens 800, may not enter optical fiber 550 because of, e.g., shading by other reflecting mirrors, resulting in reduced coupling efficiency.

However, in the present embodiment, second lens 130 is provided, whereby the direction in which generatrix 125d is tilted with respect to the active layer is opposite to the direction in which generatrix 135 is tilted with respect to the active layer. Thus, the distortion of the optical intensity distribution due to the aberration caused by first lens 120d is eliminated by second lens 130, which has generatrix 135 tilted in the opposite direction. In other words, the beam spots illustrated in FIG. 41A are on an upward curve in the front view, but the beam spots of laser lights L1 to L6 that pass through second lens 130 approach a shape parallel to the xy-plane. As a result, the coupling efficiency in light source module 10g is improved.

[Advantageous Effects, etc.]

In Embodiment 4, each of the plurality of optical units further has a second fast axis adjustment lens (second lens 130) on which the laser light that exits from the first fast axis adjustment lens (first lens 120d) is incident, and that adjusts the optical axis of the laser light in the fast axis direction. In each of the plurality of optical units, semiconductor laser element 200 has an active layer, and first lens 120d and second lens 130 are cylindrical lenses that have generatrices 125d and 135, respectively. In each of the plurality of optical units, generatrices 125d and 135 are tilted with respect to the active layer, and the direction in which generatrix 125d is tilted with respect to the active layer is opposite to the direction in which generatrix 135 is tilted with respect to the active layer.

Thus, the distortion of the optical intensity distribution due to the aberration caused by first lens 120d is eliminated by second lens 130, which has generatrix 135 tilted in the opposite direction. In other words, the beam spots illustrated in FIG. 41A are on an upward curve in the front view, but it is possible to cause all of the beam spots of laser lights L1 to L6 that pass through second lens 130 to approach a shape parallel to the xy-plane. As a result, these laser lights L1 to L6 are inhibited from being, e.g., obstructed by other reflecting mirrors 700, whereby the coupling efficiency in light source module 10g is improved.

[Embodiment 5]

Hereinafter, Embodiment 5 will be described. Below, description will center on the points of difference from Embodiment 1, and the description of common points will be omitted or simplified.

[Configuration]

First, the configuration of a light source module according to Embodiment 5 will be described with reference to FIG. 46.

FIG. 46 is a front view illustrating a part of the light source module according to Embodiment 5. More specifically, FIG. 46 is a front view of a part of optical unit 1h included in the light source module according to the present embodiment.

The light source module according to the present embodiment has the same configuration as light source module 10 according to Embodiment 1, except that instead of optical units 1 to 6, the light source module according to the present embodiment includes optical unit 1h and five optical units each having the same configuration as optical unit 1h. In other words, the light source module according to the present embodiment includes six optical units. Each of the six optical units has the same configuration, and here, mainly optical unit 1h will be described.

Optical unit 1h has the same configuration as optical unit 1, except that optical unit 1h has first lens 120h instead of first lens 120, and has support member 150h instead of support member 150.

First lens 120h has lens body 1201h and lens holder 1202h that is a flange. First lens 120h is constituted by lens body 1201h and lens holder 1202h being joined together by using bonding material 1203.

Lens body 1201h has the same configuration as first lens 120 according to Embodiment 1. Lens holder 1202h is a member that holds lens body 1201h. In the present embodiment, lens holder 1202h is disposed below lens body 1201h. Lens holder 1202h includes, for example, an inorganic material such as glass or silicon. Lens holder 1202h may include a metal such as Fe, an Fe alloy such as stainless steel, Cu, a Cu alloy, or the like, or may include a ceramic such as $Al_2O_3$, $ZrO_2$, or SiN. Bonding material 1203 includes a material having a high melting point, such as AuSn solder or an Ag sintered body.

Lens holder 1202h is a member that includes an upper face that is further on the positive side of the z-axis and parallel to the xy-plane, and lower face 121h that is further on the negative side of the z-axis and tilted with respect to the xy-plane. The upper face of lens holder 1202h is bonded to the lower face of lens body 1201h. Lower face 121h is bonded to support member 150h. Thus, first lens 120h has lower face 121h that is tilted with respect to generatrix 125.

Support member 150h is a member disposed between first lens 120h and first step 511a. Support member 150h includes, for example, an inorganic material such as glass or silicon. Support member 150h may include a metal such as Fe, an Fe alloy such as stainless steel, Cu, a Cu alloy, or the like, or may include a ceramic such as $Al_2O_3$, $ZrO_2$, or SiN.

Support member 150h is a member that includes upper face 153h that is further on the positive side of the z-axis and tilted with respect to the xy-plane, and lower face 154h that is further on the negative side of the z-axis and parallel to the xy-plane. Lower face 154h and first step 511a are bonded together by second bonding material 162. Second bonding material 162 may include, for example, a solder material, a metal sintered body, or the like. Thus, support member 150h fixed to platform 510 has upper face 153h that is tilted with respect to the surface of first step 511a.

Upper face 153h of support member 150h and lower face 121h of first lens 120h are joined by first bonding material 161, which is a joining material, after the position of first lens 120h is adjusted. Upper face 153h is the attachment face of first lens 120h. Lower face 121h and upper face 153h, which is a tilted face, are faces that are parallel to each other. Furthermore, in the present embodiment as well, the active layer of semiconductor laser element 200 is parallel to the xy-plane. Therefore, lower face 121h and upper face 153h are tilted with respect to the xy-plane, that is, tilted also with respect to the active layer.

Further, here, the extent of tilt of upper face 153h, which is a tilted face, will also be described. In FIG. 46, angle θ3 is illustrated. Angle θ3 is the angle between the xy-plane and upper face 153h, which is a tilted face. In other words, angle θ3 is the angle between first step 511a and upper face 153h. Furthermore, angle θ3 is the angle between the active layer parallel to the xy-plane and upper face 153h. In the present embodiment, angle θ3 satisfies $0° < |θ3| < 45°$. Furthermore, in first lens 120h, the angle between generatrix 125 and lower face 121h is angle θ3.

Further, an example of a method for manufacturing optical unit 1h will be described with reference to FIG. 47. Here, as an example, optical unit 1h will be used for description, but the other five optical units are manufactured by the same method.

FIG. 47 is a schematic diagram illustrating a step in a method for manufacturing optical unit 1h. More specifically, in FIG. 47, the step, after adjusting the position of first lens 120h, of joining first lens 120h to support member 150h is illustrated. Note that before this step, the three steps below are performed. The three steps are: a step in which semiconductor laser element 200, first submount 230, and FACL 110 are disposed on second step 511b; a step in which first lens 120h is prepared in advance by bonding lens body 1201h and lens holder 1202h; and a step in which support member 150h is bonded to and fixed at a predetermined position on first step 511a.

Then, as illustrated in FIG. 47, the step in which the position of first lens 120h is adjusted and first lens 120h is bonded to support member 150h is performed.

(a) in FIG. 47 is a diagram illustrating a step in which first lens 120h is disposed on upper face 153h of support member 150h and light is emitted from semiconductor laser element 200. First, collet 1100 suctions the upper face of lens holder 1202h of first lens 120h and moves first lens 120h onto upper face 153h. At this time, optical unit 1h is moved such that generatrix 125 is disposed on imaginary line IL of optical unit 1h. Subsequently, laser light L1 is emitted from semiconductor laser element 200.

At time this, in FIG. 47, it is assumed that in the step of fixing FACL 110 to semiconductor laser element 200, FACL 110 is displaced upward, that is, in the positive direction of the z-axis, with respect to imaginary line IL of optical unit 1h. In this case, laser light L1 travels while tilted diagonally upward with respect to imaginary line IL. At this time, beam spot LO1d of laser light L1 at first lens 120h is displaced in the positive direction of the z-axis relative to generatrix 125. Here, distance d12 denotes the amount of displacement in the z-axis direction. In other words, at reference line XLVII-XLVII, it is assumed that the center of beam spot LO1d is distance d12 away from generatrix 125.

(b) in FIG. 47 is a diagram illustrating a so-called alignment step, which is a step in which the position of first lens 120h is moved. At this time, first lens 120h moves along upper face 153h, which is tilted with respect to the x-axis direction. Here, first lens 120h illustrated in (b) in FIG. 47 has been moved, with respect to first lens 120h illustrated in (a) in FIG. 47, further on the negative side of the x-axis and further on the negative side of the z-axis as indicated by the outlined arrow.

At this time, generatrix 125 moves away from the position of beam spot LO1d, whereby the distance between the center of beam spot LO1d and generatrix 125 is distance d121, which is greater than distance d12.

In the alignment step, the position of first lens 120h is moved, that is, the position of first lens 120h is adjusted, such that the coupling efficiency between outputted laser light L1 and optical fiber 550 is high. As a result of this adjustment, at reference line XLVII-XLVII, the center of beam spot LO1d is distance d121 away from generatrix 125. As a result, laser light L1 that exits from FACL 110 and travels at a diagonally upward tilt with respect to imaginary line IL is refracted in a direction parallel to imaginary line IL when laser light L1 is transmitted through lens body 1201h of first lens 120h. As a result, the coupling efficiency between laser light L1 and optical fiber 550 increases.

(c) in FIG. 47 is a diagram illustrating a step in which first lens 120h is fixed to support member 150h. While positionally adjusted first lens 120h is held by collet 1100, first bonding material 161, which is, e.g., an ultraviolet curable adhesive, is applied by syringe 1200 to a part at which the side face of lens holder 1202h and upper face 153h of support member 150h connect. Subsequently, first bonding material 161 is cured by irradiation with ultraviolet light.

(d) in FIG. 47 is a diagram illustrating a step in which syringe 1200 and collet 1100 are removed. Since first lens 120h is fixed to support member 150h by first bonding material 161, first lens 120h is fixed at a predetermined position on platform 510. Optical unit 1h is manufactured by the manufacturing method illustrated in (a) to (d) in FIG. 47.

In the light source module according to Embodiment 5, when angle θ3 satisfies $0° < |θ3| < 45°$, the same effects as in light source module 10d of Embodiment 2 are obtained. Angle θ3 may satisfy $0.5° < |θ3| < 30°$, or may satisfy $1° < |θ3| < 10°$. When angle θ3 satisfies $0° < |θ3| < 45°$, the amount of change in the distance in the z-axis direction between the center of beam spot LO1d and generatrix 125 is less than the amount of movement of first lens 120h in the x-axis direction when first lens 120h moves along upper face 153h, which is a tilted face. Thus, as in Embodiment 2, in optical unit 1h, the position of first lens 120h can easily be adjusted such that the coupling efficiency between laser light L1 emitted from semiconductor laser element 200 and optical fiber 550 is high. The same is true for the other five optical units. In other words, a light source module having high coupling efficiency is realized.

[Advantageous Effects, etc.]

In Embodiment 5, each of the plurality of optical units further has support member 150h that supports first lens 120h. In each of the plurality of optical units, semiconductor laser element 200 has an active layer, and first lens 120h (more specifically, lens body 1201h) is a cylindrical lens having generatrix 125. In each of the plurality of optical units, generatrix 125 is parallel to the active layer. Support member 150h has a tilted face (upper face 153h) that is tilted with respect to the active layer. First lens 120h (more specifically, lens body 1201h) is disposed on the tilted face (upper face 153h).

As a result, when first lens 120h is moved in the x-axis direction along the tilted face (upper face 153h), the amount of change in the distance between the center of beam spot LO1d and generatrix 125 in the z-axis direction is less than the amount of movement of first lens 120h in the x-axis direction. Thus, as in Embodiment 2, in optical unit 1h, the position of first lens 120h can easily be adjusted such that the coupling efficiency between laser light L1 emitted from semiconductor laser element 200 and optical fiber 550 is high. The same is true for the other five optical units. In other words, a light source module having high coupling efficiency is realized.

In Embodiment 5, each of the plurality of optical units has support member 150h provided to platform 510. In each of the plurality of optical units, support member 150h has an attachment face (upper face 153h) to which first lens 120h is attached, and semiconductor laser element 200 has an active layer. The bottom face (lower face 121h) of first lens 120h is fixed to the attachment face (upper face 153h) that is included in support member 150h and is tilted with respect to the active layer.

Thus, the bottom face (lower face 121h) of first lens 120h is disposed on the attachment face (upper face 153h) that is tilted with respect to the active layer. Therefore, as described above, in optical unit 1h, the position of first lens 120h can easily be adjusted such that the coupling efficiency between laser light L1 emitted from semiconductor laser element 200 and optical fiber 550 is high.

Note that in the present embodiment, lens body 1201h and lens holder 1202h were separate members, but this is not intended to be limiting. Lens body 1201h and lens holder 1202h may be formed integrally using the same glass material. Furthermore, a case of using ultraviolet curable adhesive as first bonding material 161 was described, but this is not intended to be limiting. For example, lens holder 1202h may be fixed to support member 150h by heating and cooling using, as first bonding material 161, an inorganic bonding material that is an inorganic material such as a solder material. Furthermore, lens holder 1202h and support member 150h may include an Fe alloy, and in this case, the region near first bonding material 161 may be irradiated with laser light to form first bonding material 161 that is a laser-welded part, thereby fixing lens holder 1202h to support member 150h. By adopting an inorganic bonding material as first bonding material 161, during operation of the light source module, it is possible to inhibit the generation, from first bonding material 161, of foreign matter such as low molecular weight siloxane, which adheres to light emission point 201 of semiconductor laser element 200 and deteriorates the properties of semiconductor laser element 200.

[Embodiment 6]

FIG. 48 is a cross-sectional view illustrating a method for manufacturing optical unit 1j according to Embodiment 6. Note that the placement direction and the like are indicated by thick arrows in FIG. 48.

The light source module according to the present embodiment has the same configuration as the light source module according to Variation 3 of Embodiment 1, except that instead of optical unit 1c and the five optical units each having the same configuration as optical unit 1c, the light source module according to the present embodiment includes optical unit 1j and five optical units each having the same configuration as optical unit 1j. In other words, the light source module according to the present embodiment includes six optical units. Each of the six optical units has the same configuration, and here, optical unit 1j will be described.

Optical unit 1j according to the present embodiment has the same configuration as optical unit 1c according to Variation 3 of Embodiment 1, except that mainly, package 400j is included instead of package 400.

Optical unit 1j includes package 400j that houses and hermetically seals semiconductor laser element 200 and FACL 110. More specifically, package 400j further houses and hermetically seals first submount 230 and second submount 250c. FACL 110 is fixed to the upper face of second submount 250c via joining material 280c. Note that among the plurality of constituent elements included in optical unit 1j, semiconductor laser element 200, FACL 110, first submount 230, second submount 250c, joining material 280c, and package 400j may be collectively described as package unit 600j.

Package 400j is a component that has: housing 430j that encloses semiconductor laser element 200 and FACL 110 from below and on the sides; translucent window 420; and top plate 440. Note that housing 430j corresponds to a member obtained by combining bottom plate 410 and side plate 430 of package 400.

In the present embodiment, translucent window 420 is provided to front opening 420c of housing 430j. Front opening 420c is stepped, as illustrated in FIG. 48, and the flat face corresponding to one step is first attachment face 430a and the flat face corresponding to the other step is second attachment face 430b.

(a) in FIG. 48 is a cross-sectional view for illustrating the placement of translucent window 420 at front opening 420c. Translucent window 420 is attached to first attachment face 430a.

(b) in FIG. 48 is a cross-sectional view for illustrating the placement of package unit 600j on first stage 511c. Package unit 600j is bonded to first stage 511c by using sixth bonding material 320. When package unit 600j is bonded, FACL 110 may sometimes be fixed

displaced from the optimal position, that is, from a position on imaginary line IL, due to a change in thickness of joining material 280c. (b) in FIG. 48 illustrates a case in which FACL 110 is fixed above imaginary line IL, and in this case, optical axis LA1 of laser light L1 tilts upward with respect to imaginary line IL, whereby laser light L1 travels diagonally upward. In this case, laser light L1 is mostly uncoupled with optical fiber 550.

In the present embodiment, further, first lens 120 is attached to second attachment face 430b of front opening 420c. The position of first lens 120 in the z-axis direction is adjusted by moving the position of first lens 120 along second attachment face 430b.

(c) in FIG. 48 is a cross-sectional view illustrating a state after first lens 120 has been bonded. As described above, the position of first lens 120 in the z-axis direction is adjusted. Here, the position of first lens 120 in the z-axis direction is adjusted to a position in which optical axis LA1 of laser light L1 that exits from first lens 120 is parallel to imaginary line IL. When the position of first lens 120 in the z-axis direction has reached this position, first lens 120 is bonded by using first bonding material 161. First bonding material 161 may include a solder material, as an example. First bonding material 161 may include an inorganic joining material such as a metal sintered body, a joining material such as an ultraviolet curable adhesive containing an ultraviolet curable resin, or the like.

Optical unit 1j according to the present embodiment makes it possible to easily adjust the position of first lens 120 in the z-axis direction and perform bonding. Laser light L1 can then be coupled to optical fiber 550 with high efficiency. Furthermore, a component that supports first lens 120 need not be prepared separately.

The light source module according to Embodiment 6 includes attachment faces that are equal in number to the plurality of optical units. In each of the plurality of optical units, first lens 120 has an incident face that is a face on which the laser light that exits from FACL 110 is incident, and that has a flat portion. The flat portion is fixed to one of the plurality of attachment faces (second attachment face 430b).

This makes it possible to easily adjust the position of first lens 120 in the fast axis direction, that is, the z-axis direction, as well as to fix first lens 120 after adjusting the position.

In Embodiment 6, in each of the plurality of optical units, one attachment face (second attachment face 430b) is provided to package 400j.

This makes it possible to fix first lens 120 to package 400j, eliminating the need to separately prepare a component that supports first lens 120.

[Embodiment 7]

FIG. 49 is a perspective view illustrating the overall configuration of light source device 1900 that includes light source module 10k, condenser lens 554, and wavelength conversion member 555 according to Embodiment 7.

Light source module 10k according to the present embodiment has the same configuration as light source module 10 of Embodiment 1, except that light source module 10k does not include condenser lens 800, optical fiber 550, and boot 551, and that translucent window 553 is provided to side wall 503.

Light source module 10k according to the present embodiment includes case 501, platform 510, a plurality of optical units (here, optical units 1, 2, 3, 4, 5, and 6), and a plurality of reflecting mirrors 700. Furthermore, in the present embodiment, translucent window 553 is provided to side wall 503, and laser lights L1 to L6 that are reflected by the plurality of reflecting mirrors 700 are spatially combined before being incident on translucent window 553, and are transmitted through translucent window 553. Here, spatially combined laser lights L1 to L6 transmitted through translucent window 553 are described as laser light L10. In other words, laser light L10 is the light that is outputted from light source module 10k.

Laser lights L1 to L6 are collimated laser lights. Thus, laser light L10 is also a collimated laser light. Furthermore, laser lights L1 to L6 are spatially combined by first lens 120, as collimated laser lights that are precisely parallel to each other. Since laser light L10 is composed of a plurality of collimated laser lights that are spatially combined, laser light L10 is a collimated laser light having high optical output and high optical density.

Therefore, light source module 10k can emit collimated laser light L10 having high optical output and high optical density.

In FIG. 49, beam spot LO10 of laser light L10 transmitted through translucent window 553 is illustrated. Laser light L10 transmitted through translucent window 553 is incident on condenser lens 554.

Condenser lens 554 is a lens that condenses arriving laser light L10. Laser light L10 condensed by condenser lens 554 exits from condenser lens 554 and is incident on light-condensing region LO20 at a predetermined position of wavelength conversion member 555. In the present embodiment, target 550a is condenser lens 554. Since laser light L10 is collimated laser light, laser light L10 is efficiently coupled with condenser lens 554. Note that when light source module 10 includes condenser lens 554, target 550a is light-condensing region LO20.

Wavelength conversion member 555 is a member that converts the wavelength of laser light L10 that exits from condenser lens 554, and is a member that includes, for example, a phosphor. Wavelength conversion member 555 is, for example, a rotating member, and is a so-called phosphor wheel. Due to this wavelength conversion member 555, the wavelength of laser light L10 is converted, and the wavelength-converted light exits from wavelength conversion member 555. For example, when laser light L10 that exits from condenser lens 554 is blue light and wavelength conversion member 555 includes a yellow phosphor that receives blue light and outputs yellow light, the blue light of laser light L10 and the yellow light outputted by the yellow phosphor are combined to output white light from wavelength conversion member 555.

At this time, laser light L10 incident on condenser lens 554 is a collimated laser light with high optical output and high optical density. Therefore, laser light L10 is condensed, at a high optical density, by condenser lens 554 onto light-condensing region LO20 at a predetermined position of wavelength conversion member 555. Therefore, wavelength-converted light with high luminance is outputted from wavelength conversion member 555. In other words, light source device 1900 can emit wavelength-converted light having high luminance.

Note that in the present embodiment, a case in which a phosphor wheel was used as wavelength conversion member 555 was described, but this is not intended to be limiting. A laser crystal may be used as wavelength conversion member 555. Furthermore, a resonator optical system in which the above-described laser crystal is disposed inside a resonator may be included. This makes it possible to realize a solid-state laser with high light emission efficiency.

[Embodiment 8]

FIG. 50 is a top view illustrating the overall configuration of light emission device 2000 according to Embodiment 8.

Light emission device 2000 according to the present embodiment has: a plurality of (three) light source modules 10m, 10n and 10p; reflecting mirror 1000; first dichroic mirror 1001; and second dichroic mirror 1002. Light source modules 10m, 10n, and 10p have the same configuration as light source module 10k according to Embodiment 7, except for the wavelength of the laser light that is emitted.

Light source modules 10m, 10n, and 10p each emit laser light having a different wavelength.

Light source module 10m has the same configuration as light source module 10k according to Embodiment 7, except that the wavelength of laser light L10m, which is the light emitted from light source module 10m, is 430 nm or greater and 480 nm or less.

Light source module 10n has the same configuration as light source module 10k according to Embodiment 7, except that the wavelength of laser light L10n, which is the light emitted from light source module 10n, is 480 nm or greater and 570 nm or less.

Light source module 10p has the same configuration as light source module 10k according to Embodiment 7, except that the wavelength of laser light L10p, which is the light emitted from light source module 10p, is 570 nm or greater and 700 nm or less.

Reflecting mirror 1000 reflects laser light L10p emitted from light source module 10p. First dichroic mirror 1001 transmits light having a wavelength in the red region (light having a wavelength of 570 nm or greater and 700 nm or less) and reflects light having a wavelength in the green region (light with a wavelength of 480 nm or greater and 570 nm or less). Laser light L10p reflected by reflecting mirror 1000 and laser light L10n emitted from light source module 10n are incident on first dichroic mirror 1001. First dichroic mirror 1001 transmits laser light L10p and reflects laser light L10n.

Second dichroic mirror 1002 transmits light having wavelengths in the green region and the red region and reflects light having a wavelength in the blue region (light having a wavelength of 430 nm or greater and 480 nm or less). Laser light L10p transmitted through first dichroic mirror 1001, laser light L10n reflected by first dichroic mirror 1001, and laser light L10m emitted from light source module 10m are incident on second dichroic mirror 1002. Second dichroic mirror 1002 transmits laser light L10p and laser light L10n, and reflects laser light L10m.

Consequently, it is possible to realize light emission device 2000 in which laser lights (that is, laser lights L10m to L10p) having wavelengths in the high-luminance red region, green region, and blue region are combined along the same optical axis. Such a light emission device 2000 can be used in a display.

Note that the wavelengths of laser lights L10m to L10p are not limited to those described above; the wavelength of laser light L10m may be 360 nm or greater and 390 nm or less, the wavelength of laser light L10n may be 390 nm or greater and 410 nm or less, and the wavelength of laser light L10p may be 410 nm or greater and 440 nm or less. In such a light emission device 2000, the reflection and transmission properties of first dichroic mirror 1001 and second dichroic mirror 1002 may be matched to the above-described wavelengths. Such a light emission device 2000 can be used in, for example, an exposure device usage, as a light emitting device for the replacement of mercury lamps (i-line: 365 nm, h-line: 405 nm, g-line: 436 nm).

[Other Embodiments]

The light source module according to the present disclosure has been described above based on the embodiments and variations, but the present disclosure is not intended to be limited to these embodiments and variations. Forms obtained by various modifications to the respective embodiments that can be conceived by a person skilled in the art as well as other forms realized by combining some constituent elements in the respective embodiments and variations are included in the scope of the present disclosure as long as they do not depart from the essence of the present disclosure.

For example, in the above embodiments and variations, convex cylindrical lenses were used as the fast axis cylindrical lens, the first fast axis adjustment lens, the second fast axis adjustment lens, and the slow axis collimator lens, but this is not intended to be limiting. Instead of the convex cylindrical lenses, concave cylindrical mirrors may be used as the fast axis cylindrical lens, the first fast axis adjustment lens, the second fast axis adjustment lens, and the slow axis collimator lens.

Furthermore, in FIG. 4A, an example in which fourth side face 124 of first lens 120 was bonded to first supporting side face 151 of support member 150 by using first bonding material 161 was illustrated, but this is not intended to be limiting. FIG. 51 is a perspective view illustrating another example of bonding first lens 120 and support member 150 together. For example, first lens 120 may be bonded to each of two support members 150 by using first bonding material 161. In FIG. 51, at least part of light incident face 120q of first lens 120 is a flat face, and light incident face 120q is bonded to flat faces on the negative side of the y-axis, these flat faces being attachment faces of each of the two support members 150. Such a first lens 120 and two support members 150 may be provided between FACL 110 and the reflecting mirror. This configuration makes it possible to move and fix first lens 120 and its generatrix 125 in the fast axis direction, that is, the z-axis direction, for positional adjustment. Furthermore, as yet another example, at least a portion of the light exit face of first lens 120 may be flat, and this light exit face may be bonded to a flat face on the positive side of the y-axis, this flat face being the attachment face of support member 150.

Moreover, various modifications, replacements, additions, omissions, and the like can be carried out for the aforementioned embodiments within the scope of the claims or equivalents thereof.

[Industrial Applicability]

The present disclosure makes it possible to provide a light source module that has high coupling efficiency.

[Reference Signs List]

1, 1a, 1b, 1c, 1d, 1f, 1g, 1h, 1j, 1x, 1xx, 2, 2d, 2f, 2g, 2x, 2xx, 3, 4, 5, 6 optical unit
d lens distance
d11, d12, d111, d121 distance
10, 10a, 10d, 10f, 10g, 10k, 10m, 10n, 10p, 10x, 10xx light source module
LA1 optical Axis
D1, D2, D3, D4, D5 width
IL imaginary line
L1, L2, L3, L4, L5, L6, L10, L10m, L10n, L10p, L11, L21 laser light
L100, L100d emitted laser light
P0, P1, P2 principal point
W1, W1a, W2, W3, W4, W5, W6, Wt1, Wt2 width
110 fast axis cylindrical lens (FACL)
120, 120a, 120d, 120h, 120xx first lens
120q light incident face
121 first side face
121h lower face
1211 bottom face
122 second side face
123 third side face
124 fourth side face
125, 125a, 125d, 135, 915, 1251, 1251a generatrix
130 second lens
150, 150h support member
151 first supporting side face

152 second supporting side face
153 upper face
153h upper face
154 lower face
154h lower face
161 first bonding material
162 second bonding material
170 SACL
200 semiconductor laser element
201 light emission point
230 first submount
231 first upper face
240 third bonding material
250, 250c second submount
251 second upper face
280, 280c joining material
290 fourth bonding material
320 sixth bonding material
330 seventh bonding material
400, 400j package
410 bottom plate
420 translucent window
420c, 630 front opening
430 side plate
430j housing
430a first attachment face
430a second attachment face
440 top plate
501 case
502 base
503 side wall
510, 510c platform
511, 511c first stage
511a first step
511b second step
512 second stage
513 third stage
514 fourth stage
515 fifth stage
516 sixth stage
550 optical fiber
550a target
551 boot
552 terminal
553 translucent window
554 condenser lens
555 wavelength conversion member
600, 600j package unit
700, 701, 702, 703, 1000 reflecting mirror
701a upper face
702a upper face
800 condenser lens
900 cylindrical lens
1001 first dichroic mirror
1002 second dichroic mirror
1100 collet
1101 fast axis collimator lens
1200 syringe

1201, 1201hlens body
1202, 1202hlens holder
1203 bonding material
1900 light source device
2000 light emission device
LO1, LO2, LO3, LO4, LO5, LO6, LO10, LO1d, LO2d beam spot
LO20 light-condensing region
ML1 distance
ML2 distance
MU1 distance
MU2 distance

**Claims**

1. A light source module comprising:

   a platform including a plurality of stages in a shape of a staircase; and
   a plurality of optical units each disposed on a different one of the plurality of stages, wherein
   each of the plurality of optical units includes:

   a semiconductor laser element that emits laser light;
   a fast axis cylindrical lens that is a lens on which the laser light emitted from the semiconductor laser element is incident, and that focuses the laser light in a fast axis direction of the laser light;
   a first fast axis adjustment lens that is a lens on which the laser light that exits from the fast axis cylindrical lens is incident, and that adjusts an optical axis of the laser light in the fast axis direction; and
   a slow axis collimator lens that is a lens on which the laser light that exits from the first fast axis adjustment lens is incident, and that collimates the laser light in a slow axis direction of the laser light, and

   $\alpha$ satisfies Formula 1:

   $$\alpha = F2/F1 \qquad (Formula\ 1),$$

   $\beta$ satisfies Formula 2:

   $$\beta = d/F2 \qquad (Formula\ 2),$$

   when F2 > 0, $\alpha$ and $\beta$ satisfy Formula 3, Formula 4, Formula 5, and Formula 6:

   $$\alpha > 1 \qquad (Formula\ 3)$$

   $$\alpha\beta > 1 \qquad (Formula\ 4)$$

   $$\beta < (1/\alpha) + (1/3) \qquad (Formula\ 5)$$

   $$\beta < 1 \qquad (Formula\ 6),$$

   and
   when F2 < 0, $\alpha$ and $\beta$ satisfy Formula 7, Formula 8, Formula 9, and Formula 10:

   $$\alpha < -1 \qquad (Formula\ 7)$$

   $$\alpha\beta < 1 \qquad (Formula\ 8)$$

$$\beta > (1/\alpha) - (1/3) \qquad \text{(Formula 9)}$$

$$\beta > -1 \qquad \text{(Formula 10)},$$

where

> F1 denotes an effective focal length of the fast axis cylindrical lens,
> F2 denotes an effective focal length of the first fast axis adjustment lens, and
> d denotes a distance between a principal point of the fast axis cylindrical lens and a principal point of the first fast axis adjustment lens.

2. The light source module according to claim 1, wherein

when F2 > 0, $\alpha$ satisfies Formula 11:

$$9.3 \leq \alpha \qquad \text{(Formula 11)},$$

and
when F2 < 0, $\alpha$ satisfies Formula 12:

$$-9.3 \geq \alpha \qquad \text{(Formula 12)}.$$

3. The light source module according to claim 1, wherein

when F2 > 0, $\alpha$ satisfies Formula 13:

$$\alpha \leq 633 \qquad \text{(Formula 13)},$$

and
when F2 < 0, $\alpha$ satisfies Formula 14:

$$\alpha \geq -633 \qquad \text{(Formula 14)}.$$

4. The light source module according to claim 1, wherein

the fast axis cylindrical lens includes an incident face on which the laser light is incident and an exit face from which the laser light exits, and
the incident face is disposed to face a light emission point of the semiconductor laser element.

5. The light source module according to any one of claims 1 to 4, wherein
the first fast axis adjustment lens is a cylindrical lens, and is a convex lens.

6. The light source module according to claim 5, wherein
$\beta$ satisfies Formula 15:

$$0 < \beta \leq 0.33 \qquad \text{(Formula 15)}.$$

7. The light source module according to any one of claims 1 to 4, wherein
each first fast axis adjustment lens is a cylindrical lens, and is a concave lens.

8. The light source module according to claim 7, wherein
$\beta$ satisfies Formula 16:

$$-0.33 \leq \beta < 0 \qquad \text{(Formula 16)}.$$

9. The light source module according to any one of claims 1 to 8, wherein
F1 is 0.15 mm or greater and 0.65 mm or less.

10. The light source module according to claim 1, wherein
in each of the plurality of optical units, the first fast axis adjustment lens includes a generatrix.

11. The light source module according to claim 10, wherein

each of the plurality of optical units includes a support member that is provided to the platform, and
in each of the plurality of optical units,

the support member includes an attachment face to which the first fast axis adjustment lens is attached,
the first fast axis adjustment lens includes a side face that is orthogonal to the generatrix,
the semiconductor laser element includes an active layer, and
the side face is fixed to the attachment face that is orthogonal to the active layer.

12. The light source module according to claim 10, wherein
in each of the plurality of optical units,

the first fast axis adjustment lens includes a bottom face that is tilted with respect to the generatrix, and
the bottom face is fixed directly or indirectly to the platform.

13. The light source module according to claim 12, wherein
in each of the plurality of optical units,

the semiconductor laser element includes an active layer,
the platform includes an attachment face that is parallel to the active layer and to which the first fast axis
adjustment lens is attached, and
the bottom face is fixed to the attachment face.

14. The light source module according to claim 12, wherein

each of the plurality of optical units includes a support member that is provided to the platform, and
in each of the plurality of optical units,

the support member includes an attachment face to which the first fast axis adjustment lens is attached,
the semiconductor laser element includes an active layer, and
the bottom face is included in the support member and fixed to attachment face that is tilted with respect to the
active layer.

15. The light source module according to any one of claims 1 to 9, wherein
each of the plurality of optical units includes a joining material that fixes the fast axis cylindrical lens.

16. The light source module according to claim 15, wherein
the joining material is an inorganic joining material.

17. The light source module according to claim 15, wherein
each of the plurality of optical units includes:

a first submount on which the semiconductor laser element is disposed; and
a second submount that is joined to the first submount and the fast axis cylindrical lens.

18. The light source module according to claim 17, wherein
the joining material is disposed between a lower face of the fast axis cylindrical lens and an upper face of the second
submount.

**19.** The light source module according to claim 18, wherein
each of the plurality of optical units includes a package that houses and hermetically seals the semiconductor laser element and the fast axis cylindrical lens.

**20.** The light source module according to claim 19, comprising:

a plurality of attachment faces equal in number to the plurality of optical units, wherein
in each of the plurality of optical units,

the first fast axis adjustment lens includes an incident face on which the laser light that exits from the fast axis cylindrical lens is incident, the incident face including a flat portion, and
the flat portion is fixed to one attachment face of the plurality of attachment faces.

**21.** The light source module according to claim 20, wherein
in each of the plurality of optical units, the one attachment face is provided to the package.

**22.** The light source module according to any one of claims 1 to 9, wherein
in each of the plurality of optical units,

the first fast axis adjustment lens is a cylindrical lens that includes a generatrix,
the semiconductor laser element includes an active layer, and
the generatrix is tilted with respect to the active layer.

**23.** The light source module according to claim 22, wherein
in each of the plurality of optical units,

the first fast axis adjustment lens is disposed above a flat placement face of the stage,
the first fast axis adjustment lens includes a bottom face that is parallel to the flat placement face, and
the generatrix is tilted with respect to the bottom face.

**24.** The light source module according to any one of claims 1 to 9, wherein

each of the plurality of optical units further includes a support member that supports the first fast axis adjustment lens, and
in each of the plurality of optical units,

the semiconductor laser element includes an active layer,
the first fast axis adjustment lens is a cylindrical lens that includes a generatrix,
the generatrix is parallel to the active layer,
the support member includes a tilted face that is tilted with respect to the active layer, and
the first fast axis adjustment lens is disposed on the tilted face.

**25.** The light source module according to any one of claims 1 to 9, wherein

each of the plurality of optical units further includes a second fast axis adjustment lens that is a lens on which the laser light that exits from the first fast axis adjustment lens is incident, and that adjusts an optical axis of the laser light in the fast axis direction, and
in each of the plurality of optical units,

the semiconductor laser element includes an active layer,
each of the first fast axis adjustment lens and the second fast axis adjustment lens is a cylindrical lens that includes a generatrix,
the generatrix of the first fast axis adjustment lens and the generatrix of the second fast axis adjustment lens are tilted with respect to the active layer, and
a direction in which the generatrix of the first fast axis adjustment lens is tilted with respect to the active layer is opposite to a direction in which the generatrix of the second fast axis adjustment lens is tilted with respect to the active layer.

FIG. 1

FIG. 2

# FIG. 3

EP 4 672 517 A1

FIG. 4A

FIG. 4B

FIG. 5

1

230

200

201

110

P1

P0

δ

F

L1

d

LA1

120

P2

W1

x y z

FIG. 6A

EP 4 672 517 A1

FIG. 6B

57

FIG. 7

FIG. 8

# FIG. 9

EP 4 672 517 A1

FIG. 10

EP 4 672 517 A1

# FIG. 11

FIG. 12

# FIG. 13

| Condition | Semiconductor laser element 200 | | Fast axis collimator lens 1101 | Slow axis collimator lens 170 | Condenser lens 800 | Optical fiber 550 | |
|---|---|---|---|---|---|---|---|
| | Wavelength | Light-emitting region width | Effective focal length F1x | Effective focal length | Effective focal length | Core diameter | Numerical aperture NA |
| A1 | 450 nm | 50 μm | 0.15 mm | 6.4 mm | 4.5 mm | 50 μm | 0.22 |
| A2 | 450 nm | 50 μm | 0.15 mm | 6.4 mm | 4.5 mm | 70 μm | 0.22 |
| A3 | 450 nm | 100 μm | 0.15mm | 6.4 mm | 4.5 mm | 100 μm | 0.22 |
| A4 | 450 nm | 50 μm | 0.38 mm | 13.5 mm | 7.3 mm | 50 μm | 0.22 |
| A5 | 450 nm | 50 μm | 0.38 mm | 13.5 mm | 7.3 mm | 70 μm | 0.22 |
| A6 | 450 nm | 100 μm | 0.38 mm | 13.5 mm | 7.3 mm | 100 μm | 0.22 |
| A7 | 450 nm | 50 μm | 0.65 mm | 15.3 mm | 11.3 mm | 50 μm | 0.22 |
| A8 | 450 nm | 50 μm | 0.65 mm | 15.3 mm | 11.3 mm | 70 μm | 0.22 |
| A9 | 450 nm | 100 μm | 0.65 mm | 15.3 mm | 11.3 mm | 100 μm | 0.22 |

EP 4 672 517 A1

FIG. 14

FIG. 15

# FIG. 16

## FIG. 17

| Condition | Semiconductor laser element 200 | | FACL 110 | First lens 120 | Lens distance | SACL 170 | Condenser lens 800 | Optical fiber 550 | |
|---|---|---|---|---|---|---|---|---|---|
| | Wavelength | Light-emitting region width | Effective focal length F1 | Effective focal length F2 | d | Effective focal length | Effective focal length | Core diameter | Numerical aperture NA |
| B1 | 450 nm | 50 μm | 0.15 mm | 38 mm | 4.6 mm | 6.4 mm | 4.5 mm | 50 μm | 0.22 |
| B2 | 450 nm | 50 μm | 0.15 mm | 38 mm | 4.6 mm | 6.4 mm | 4.5 mm | 70 μm | 0.22 |
| B3 | 450 nm | 100 μm | 0.15 mm | 38 mm | 4.6 mm | 6.4 mm | 4.5 mm | 100 μm | 0.22 |
| B4 | 450 nm | 50 μm | 0.38 mm | 38 mm | 6.3 mm | 13.5 mm | 7.3 mm | 50 μm | 0.22 |
| B5 | 450 nm | 50 μm | 0.38 mm | 38 mm | 6.3 mm | 13.5 mm | 7.3 mm | 70 μm | 0.22 |
| B6 | 450 nm | 100 μm | 0.38 mm | 38 mm | 6.3 mm | 13.5 mm | 7.3 mm | 100 μm | 0.22 |
| B7 | 450 nm | 50 μm | 0.65 mm | 38 mm | 4.7 mm | 15.3 mm | 11.6 mm | 50 μm | 0.22 |
| B8 | 450 nm | 50 μm | 0.65 mm | 38 mm | 4.7 mm | 15.3 mm | 11.6 mm | 70 μm | 0.22 |
| B9 | 450 nm | 100 μm | 0.65 mm | 38 mm | 4.7 mm | 15.3 mm | 11.6 mm | 100 μm | 0.22 |
| B10 | 450 nm | 50 μm | 0.65 mm | 6.5 mm | 2.0 mm | 15.3 mm | 11.6 mm | 50 μm | 0.22 |
| B11 | 450 nm | 50 μm | 0.15 mm | 38 mm | 11.5 mm | 9.7 mm | 4.5 mm | 50 μm | 0.22 |
| B12 | 450 nm | 50 μm | 0.38 mm | 95 mm | 1.5 mm | 13.5 mm | 7.3 mm | 50 μm | 0.22 |
| B13 | 450 nm | 50 μm | 0.38 mm | 95 mm | 31 mm | 13.5 mm | 7.3 mm | 50 μm | 0.22 |
| B14 | 450 nm | 50 μm | 0.15 mm | 95 mm | 2.0 mm | 6.4 mm | 4.5 mm | 50 μm | 0.22 |
| B15 | 450 nm | 50 μm | 0.15 mm | 95 mm | 31 mm | 6.4 mm | 4.5 mm | 50 μm | 0.22 |

EP 4 672 517 A1

# FIG. 18

| Type | $\alpha$ | $\beta$ | F／F1 |
|---|---|---|---|
| B1 ～ B3 | 254 | 0.12 | 1.13 |
| B4 ～ B6 | 100 | 0.16 | 1.18 |
| B7 ～ B9 | 59 | 0.12 | 1.11 |
| B10 | 9.3 | 0.30 | 1.24 |
| B11 | 100 | 0.04 | 1.03 |
| B12 | 250 | 0.02 | 1.01 |
| B13 | 250 | 0.33 | 1.48 |
| B14 | 633 | 0.02 | 1.02 |
| B15 | 633 | 0.33 | 1.48 |

# FIG. 19

FIG. 20

FIG. 21

EP 4 672 517 A1

# FIG. 22

FIG. 23A

EP 4 672 517 A1

EP 4 672 517 A1

EP 4 672 517 A1

# FIG. 23E

EP 4 672 517 A1

EP 4 672 517 A1

FIG. 23G

FIG. 24

10a

1a

201

P0

110

F

δ

P1

d

P2

120a

L1

LA1

125a

W1a

y

z

x

# FIG. 25

(a)

700  170  L1  LA1  120a  110  200

z
x  y

IL  125a  201

(b)

700  170  L1  LA1  125a  120a  110  200

z
x  y

IL  1251a  201

EP 4 672 517 A1

# FIG. 26

EP 4 672 517 A1

# FIG. 27

FIG. 28

## FIG. 29

| Condition | Semiconductor laser element 200 | | FACL 110 | First lens 120 | Lens distance | SACL 170 | Condenser lens 800 | Optical fiber 550 | |
|---|---|---|---|---|---|---|---|---|---|
| | Wavelength | Light-emitting region width | Effective focal length F1 | Effective focal length F2 | d | Effective focal length | Effective focal length | Core diameter | Numerical aperture NA |
| C1 | 450 nm | 50 μm | 0.38 mm | -3 mm | 5.0 mm | 13.5 mm | 7.3 mm | 50 μm | 0.22 |

# FIG. 30

| Condition | α | β | F／F1 |
|:---:|:---:|:---:|:---:|
| C1 | -100 | -0.13 | 0.88 |

FIG. 31

FIG. 32

EP 4 672 517 A1

# FIG. 33

EP 4 672 517 A1

# FIG. 34

FIG. 35

EP 4 672 517 A1

## FIG. 36

# FIG. 37

EP 4 672 517 A1

# FIG. 38

# FIG. 39A

(a)

1100
120d
LO1d
125d
511a
510
d11
1211
Z
y⊗→x
XXXIX

(b)

1100
120d
LO1d
125d
511a
510
d111
1211
Z
y⊗→x
XXXIX

(c)

1100
120d
LO1d
125d
1200
1200
1211
161
510
Z
y⊗→x

EP 4 672 517 A1

FIG. 39B

(a)

(b)

(c)

FIG. 40

EP 4 672 517 A1

# FIG. 41A

Z coordinate value

Y coordinate value

# FIG. 42

FIG. 43

FIG. 44

EP 4 672 517 A1

# FIG. 45

EP 4 672 517 A1

# FIG. 46

FIG. 47

EP 4 672 517 A1

# FIG. 48

# FIG. 49

EP 4 672 517 A1

FIG. 50

EP 4 672 517 A1

FIG. 51

## INTERNATIONAL SEARCH REPORT

International application No.

**PCT/JP2024/005963**

| A. | CLASSIFICATION OF SUBJECT MATTER |
|---|---|

*H01S 5/02253*(2021.01)i; *H01S 5/40*(2006.01)i
FI:   H01S5/02253; H01S5/40

According to International Patent Classification (IPC) or to both national classification and IPC

| B. | FIELDS SEARCHED |
|---|---|

Minimum documentation searched (classification system followed by classification symbols)

H01S5/00-5/50

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2019-216204 A (FUJIKURA LTD.) 19 December 2019 (2019-12-19)<br>in particular, fig. 6 | 1-25 |
| A | JP 2017-208483 A (FUJIKURA LTD.) 24 November 2017 (2017-11-24)<br>in particular, fig. 1 | 1-25 |
| A | US 2019/0293800 A1 (ROSEMOUNT AEROSPACE INC.) 26 September 2019 (2019-09-26)<br>in particular, fig. 2 | 1-25 |

☐ Further documents are listed in the continuation of Box C.   ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **12 March 2024** | **26 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/005963**

| Patent document cited in search report | | | Publication date (day/month/year) | Patent family member(s) | | | Publication date (day/month/year) |
|---|---|---|---|---|---|---|---|
| JP | 2019-216204 | A | 19 December 2019 | US | 2021/0257805 | A1 | |
| | | | | in particular, fig. 6 | | | |
| | | | | EP | 3809542 | A1 | |
| | | | | CN | 112020802 | A | |
| JP | 2017-208483 | A | 24 November 2017 | (Family: none) | | | |
| US | 2019/0293800 | A1 | 26 September 2019 | EP | 3726245 | A1 | |
| | | | | CA | 3062696 | A | |

Form PCT/ISA/210 (patent family annex) (July 2022)

**REFERENCES CITED IN THE DESCRIPTION**

**Patent documents cited in the description**

- JP 2014170888 A